# EUROPEAN PATENT APPLICATION

(11) **EP 4 838 303 A1**
(43) Date of publication of application: **11.11.2026**
(21) Application number: 25749229.8
(22) Date of filing: 31.01.2025
(51) Int. Cl.: G03F 7/039, G03F 7/022, G03F 7/004, G03F 7/20, G03F 7/26, H10K 59/80, H10K 59/122

(54) **POSITIVE PHOTOSENSITIVE RESIN COMPOSITION, ELECTRONIC COMPONENT, AND DISPLAY DEVICE**

(30) Priority: 31.01.2024 KR 20240014893; 24.01.2025 KR 20250011278
(71) Applicant: Dongjin Semichem Co., Ltd., Incheon 22824 (KR)
(72) Inventor: LEE, Sun Hee, Hwaseong-si Gyeonggi-do 18635 (KR); YOUN, Hyoc Min, Hwaseong-si Gyeonggi-do 18635 (KR); YEO, Tai Hoon, Hwaseong-si Gyeonggi-do 18635 (KR); KIM, Dong Myung, Hwaseong-si Gyeonggi-do 18635 (KR); LEE, Seok Hyeon, Hwaseong-si Gyeonggi-do 18635 (KR); LEE, Tae Won, Hwaseong-si Gyeonggi-do 18635 (KR); LEE, Sang Yoon, Hwaseong-si Gyeonggi-do 18635 (KR); LEE, Seung Yeon, Hwaseong-si Gyeonggi-do 18635 (KR); WI, Na Ra, Hwaseong-si Gyeonggi-do 18635 (KR); HUH, Chul, Hwaseong-si Gyeonggi-do 18635 (KR); CHO, Ji Eun, Hwaseong-si Gyeonggi-do 18635 (KR); MIN, Kyung Ah, Hwaseong-si Gyeonggi-do 18635 (KR); PARK, Ji Eun, Hwaseong-si Gyeonggi-do 18635 (KR)
(74) Representative: Grünecker Patent- und Rechtsanwälte PartG mbB
(86) International application number: PCT/KR2025/099151
(87) International publication number: WO 2025/165190

(57) **Abstract**

The present invention relates to: a positive photosensitive resin composition having excellent sensitivity, residual film rate, adhesive strength, chemical resistance, hygroscopicity, and heat resistance; a method for manufacturing an insulating film by using same; an electronic component; and a display device for an organic electroluminescent device.

## Description

### Technical Field

The present disclosure relates to a positive photosensitive resin composition, an electronic component, and a display device.

### Background Art

Recently, among display devices, organic lightemitting diodes (OLEDs), especially active-matrix OLEDs (AMOLEDs), have gained attention in the market for various reasons.

OLED devices typically include an organic insulating film, and a polyimide photosensitive resin composition is generally used to form the organic insulating film. Techniques of substituting polyamic esters among polyimide precursors, which are used in conventional polyimide photosensitive resin compositions, with alkyls, have been applied, but polyamic esters substituted with alkyls are difficult to control in terms of solubility and have low sensitivity. Therefore, there is an urgent need for a solution to this problem.

### DISCLOSURE

### Technical Problem

The present disclosure is intended to provide a positive photosensitive resin composition having excellent sensitivity, film retention rate, adhesion, chemical resistance, hygroscopicity, and heat resistance, and an electronic component and display device including a cured product thereof.

However, the problems to be solved by the present disclosure are not limited to the above-mentioned problems, and other problems not mentioned will be clearly understood by those skilled in the art from the following description.

### Technical Solution

One embodiment of the present disclosure provides a positive photosensitive resin composition comprising: an alkali-soluble polymer resin; an esterified quinone diazide compound; and a crosslinking agent containing a phenol group, wherein the alkali-soluble polymer resin comprises a reaction product of a mixture comprising an amine-based compound, an acid anhydride compound, and a capping compound, and satisfies Equation 1 below:

[Equation 1] $\left(A+B\right) / 2 < 6.0 eV$

In Equation 1 above, A is the CTC value (eV) of the amine-based compound, and B is the sum of the CTC value (eV) of the acid anhydride compound and the CTC value (eV) of the capping compound in a mixture of the acid anhydride compound and the capping compound, wherein the CTC value represents the quantum calculation simulation value for the energy level difference between an electron donor and an electron acceptor in the compound, assuming that the compound forms a charge transfer complex.

According to one embodiment of the present disclosure, the positive photosensitive composition may have a fluorine content of 10,000 ppm or less.

According to one embodiment of the present disclosure, the alkali-soluble polymer resin may comprise a repeating unit represented by Formula A below and a repeating unit represented by Formula B below, wherein the repeating unit represented by Formula A and the repeating unit represented by Formula B may comprise a structure derived from an amine-based compound containing R_{b} and a structure derived from an acid anhydride compound containing Rₐ:

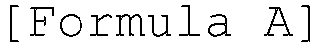

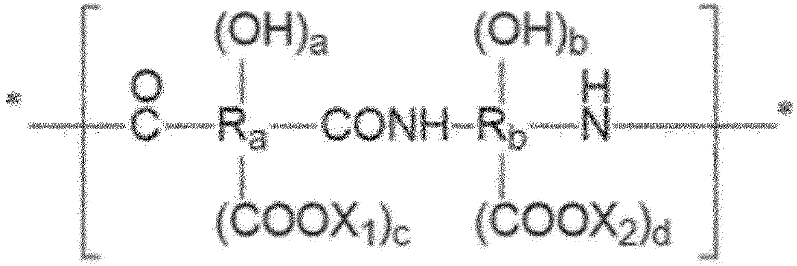

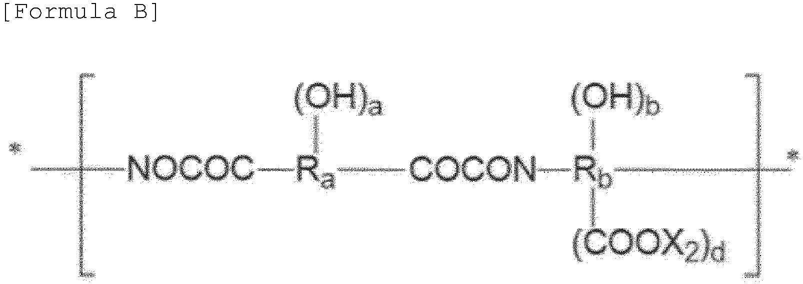

In Formulas A and B above, Rₐ and R_{b} are each independently an organic group having 5 to 60 carbon atoms, X₁ and X₂ are each independently hydrogen or an alkyl group having 1 to 10 carbon atoms, a and b are each independently an integer ranging from 0 to 4, c and d are each independently an integer ranging from 0 to 2, and a+b is 1 or more.

According to one embodiment of the present disclosure, the alkali-soluble polymer resin may comprise, based on a total of 100 mol% of the repeating unit represented by Formula A and the repeating unit represented by Formula B, at least 51 mol% of the repeating unit represented by Formula B.

According to one embodiment of the present disclosure, the amine-based compound may comprise at least one of compounds represented by Formulas 1-1 to 1-19 below. 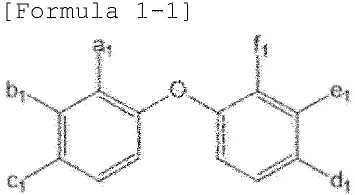 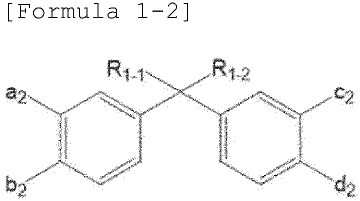 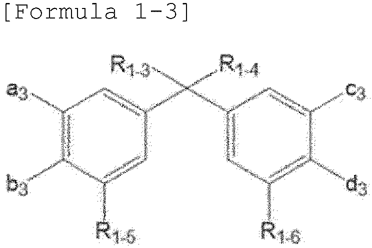 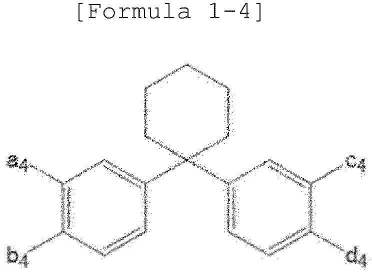 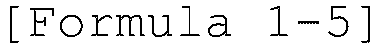 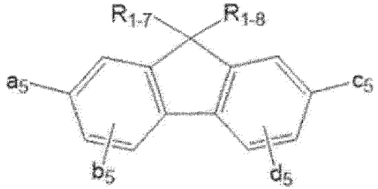 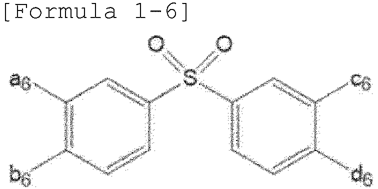 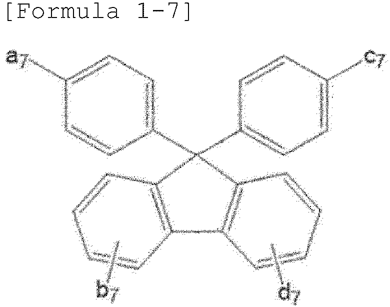 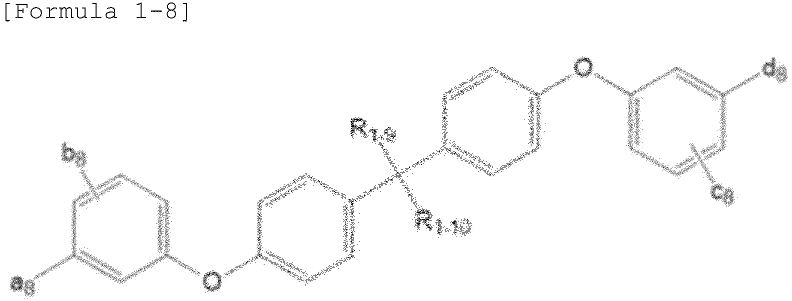 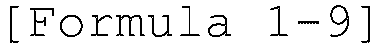 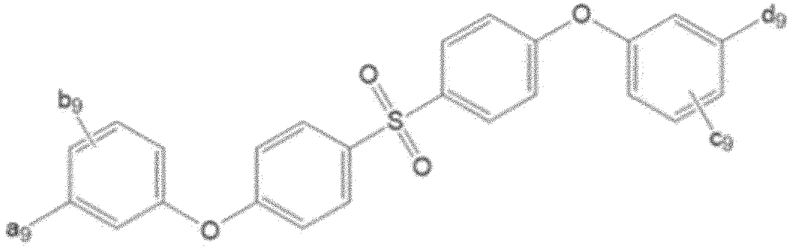 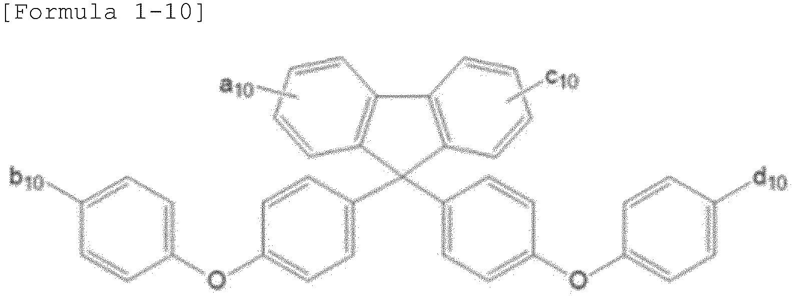 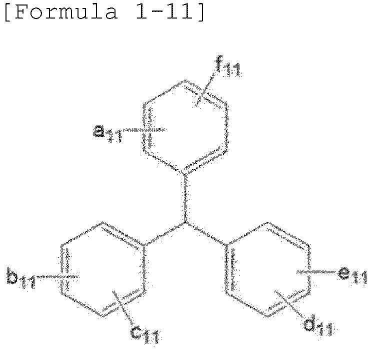 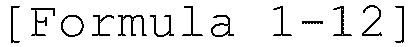 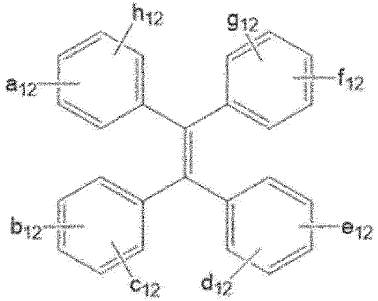 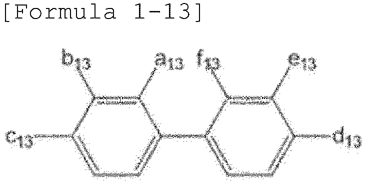 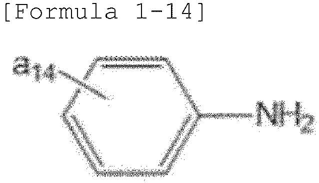 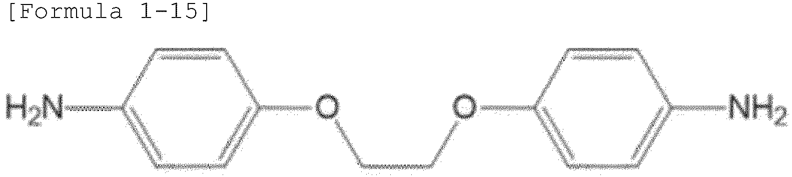 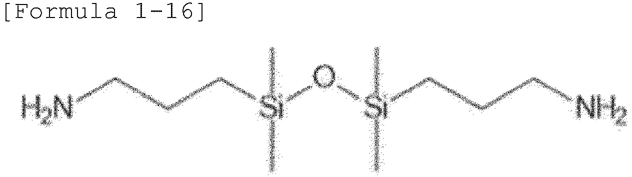 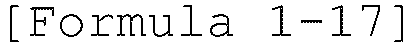 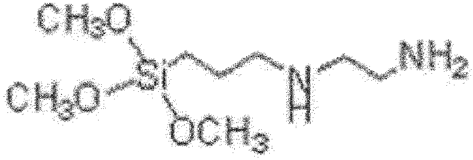 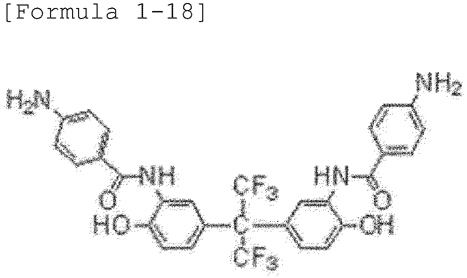 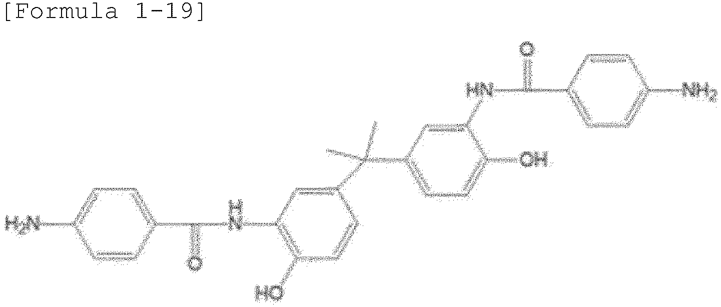 wherein at least two of a₁, b₁, c₁, d₁, e₁ and f₁ are amine groups, and the remainder are hydrogen, hydroxyl groups, halogen-substituted alkyl groups having 1 to 3 carbon atoms, or -COOX₂; at least two of a₂, b₂, c₂ and d₂ are amine groups, and the remainder are hydrogen, hydroxyl groups, or -COOX₂; R₁₋₁ and R₁₋₂ are each independently hydrogen, an alkyl group having 1 to 10 carbon atoms, a halogen-substituted alkyl group having 1 to 3 carbon atoms, or a cycloalkyl group having 5 to 10 carbon atoms; at least two of a₃, b₃, c₃ and d₃ are amine groups, and the remainder are hydrogen, hydroxyl groups, or -COOX₂; R₁₋₃ and R₁₋₄ are each independently an alkyl group having 1 to 10 carbon atoms or a cycloalkyl group having 5 to 10 carbon atoms; R₁₋₅ and R₁₋₆ are each independently hydrogen or an alkyl group having 1 to 10 carbon atoms; at least two of a₄, b₄, c₄ and d₄ are amine groups, and the remainder are hydrogen, hydroxyl groups, or -COOX₂; at least two of a₅, b₅, c₅ and d₅ are amine groups, and the remainder are hydrogen, hydroxyl groups, or -COOX₂; R₁₋₇ and R₁₋₈ are each independently an alkyl group having 1 to 10 carbon atoms or a cycloalkyl group having 5 to 10 carbon atoms; at least two of a₆, b₆, c₆ and d₆ are amine groups, and the remainder are hydrogen, hydroxyl groups, or -COOX₂; at least two of a₇, b₇, c₇ and d₇ are amine groups, and the remainder are hydrogen, hydroxyl groups, or -COOX₂; at least two of a₈, b₈, c₈ and d₈ are amine groups, and the remainder are hydrogen, hydroxyl groups, or -COOX₂; R₁₋₉ and R₁₋₁₀ are each independently an alkyl group having 1 to 10 carbon atoms or a cycloalkyl group having 5 to 10 carbon atoms; at least two of a₉, b₉, c₉ and d₉ are amine groups, and the remainder are hydrogen, hydroxyl groups, or -COOX₂; at least two of a₁₀, b₁₀, c₁₀ and d₁₀ are amine groups, and the remainder are hydrogen, hydroxyl groups, or -COOX₂; at least two of a₁₁, b₁₁, c₁₁, d₁₁, e₁₁ and f₁₁ are amine groups, and the remainder are hydrogen, hydroxyl groups, or -COOX₂; at least two of a₁₂, b₁₂, c₁₂, d₁₂, e₁₂, f₁₂ and g₁₂ are amine groups, and the remainder are hydrogen, hydroxyl groups, or -COOX₂; at least two of a₁₃, b₁₃, c₁₃, d₁₃, e₁₃ and f₁₃ are amine groups, and the remainder are hydrogen, hydroxyl groups, unsubstituted or halogen-substituted alkyl groups having 1 to 3 carbon atoms, or -COOX₂; a₁₄ is a thiol group, an amine group, or a hydroxyl group; and X₂ is hydrogen or an alkyl group having 1 to 10 carbon atoms.

According to one embodiment of the present disclosure, the acid anhydride compound may comprise at least one of compounds represented by Formulas 2-1 to 2-16 below:

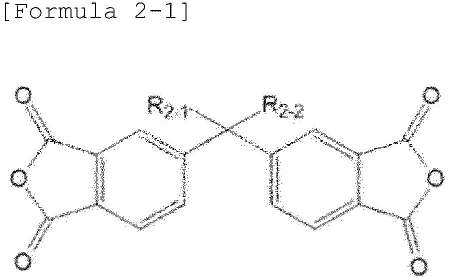

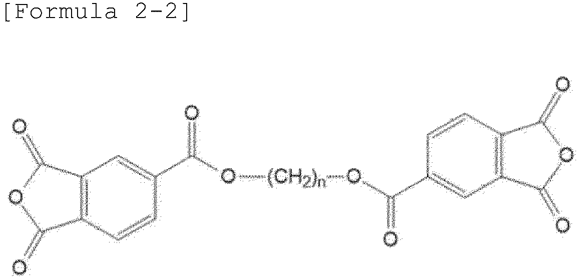

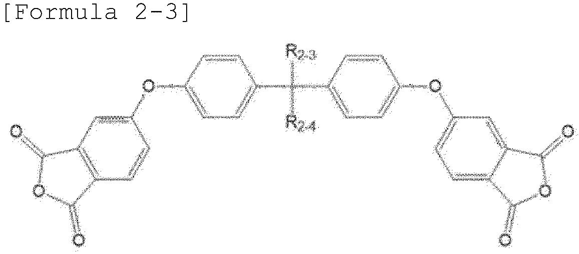

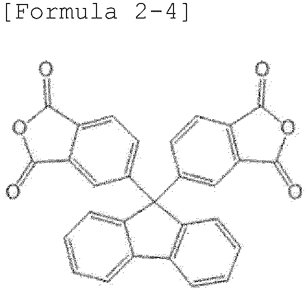

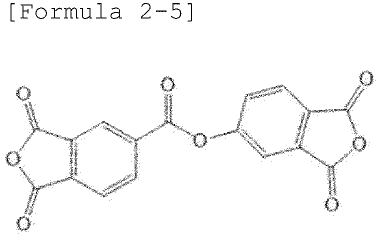

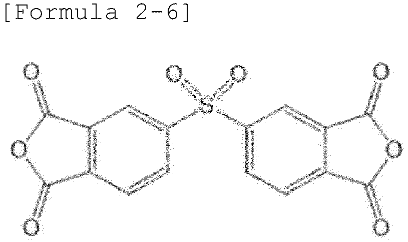

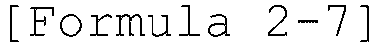

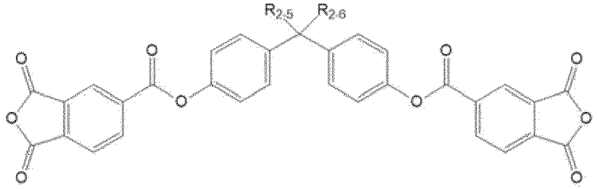

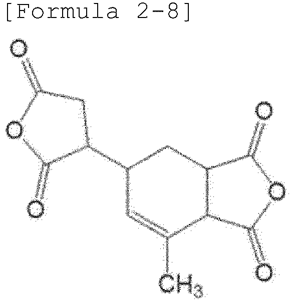

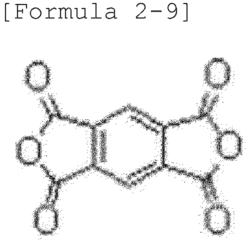

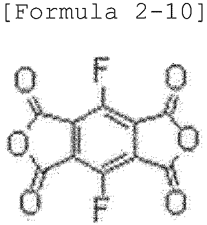

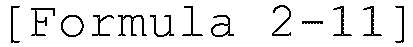

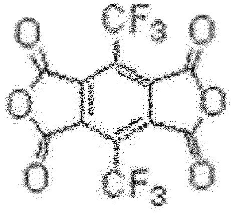

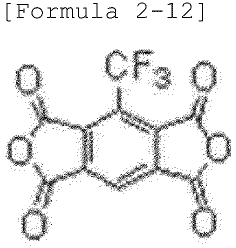

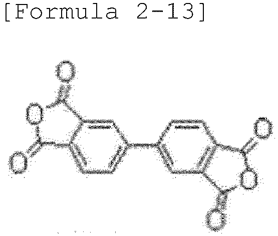

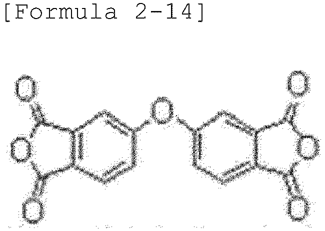

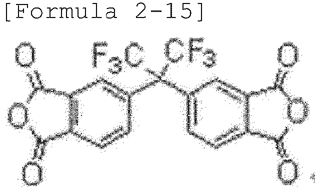

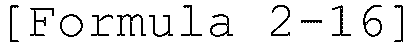

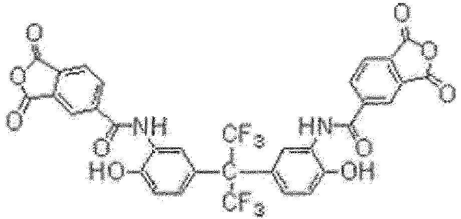

In the above formulas, R₂₋₁ to R₂₋₆ are each independently an alkyl group having 1 to 10 carbon atoms or a cycloalkyl group having 5 to 10 carbon atoms, and n is an integer ranging from 2 to 20.

In the above formulas, R₂₋₁ to R₂₋₆ are each independently an alkyl group having 1 to 10 carbon atoms or a cycloalkyl group having 5 to 10 carbon atoms, and n is an integer ranging from 2 to 20.

According to one embodiment of the present disclosure, the capping compound may comprise at least one of compounds C-1 to C-5 below:

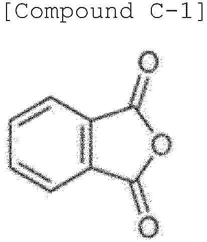

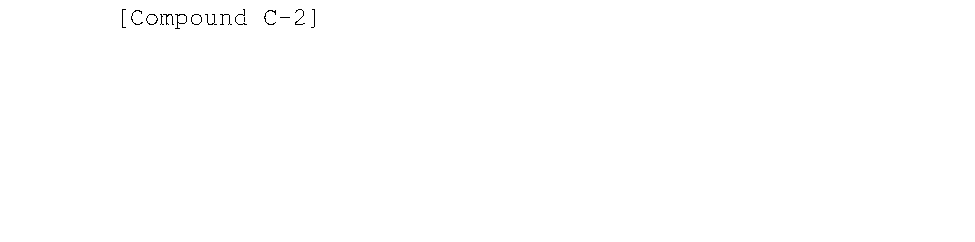

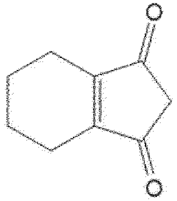

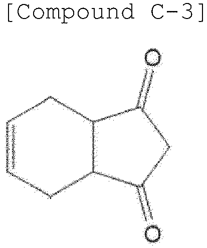

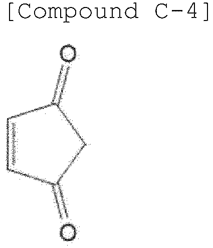

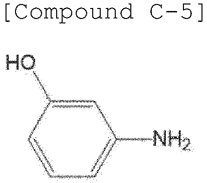

According to one embodiment of the present disclosure, the esterified quinone diazide compound may comprise a reaction product of a quinone diazide compound and at least one of phenol compounds represented by Formulas 3-1 to 3-13 below:

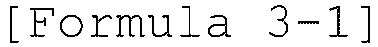

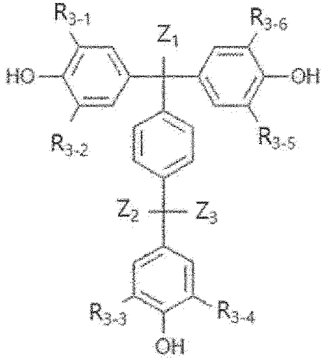

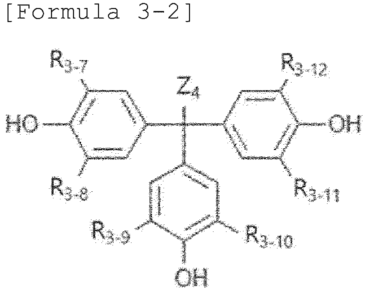

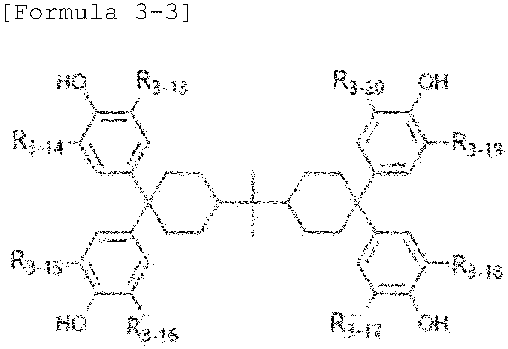

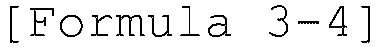

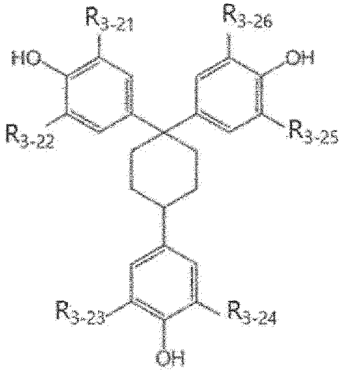

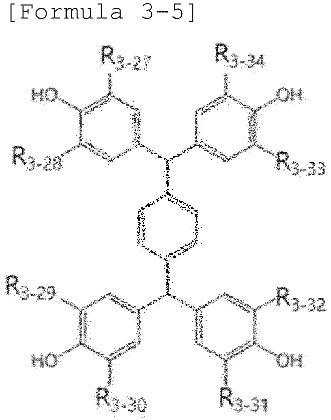

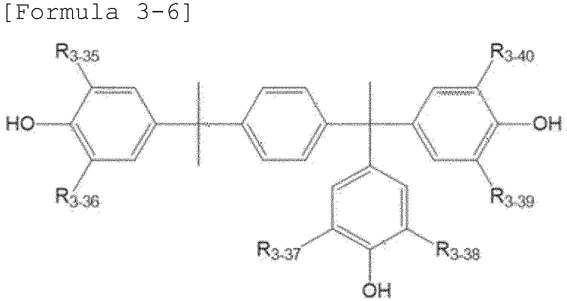

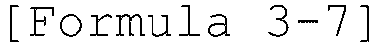

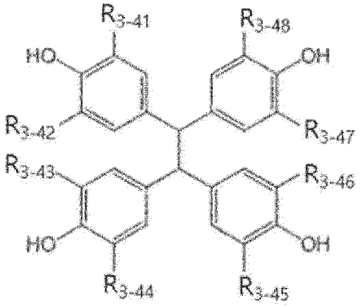

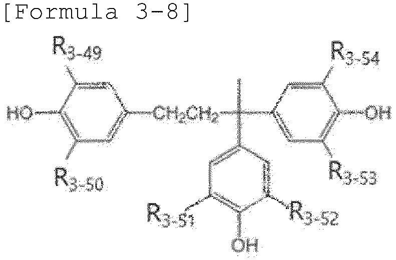

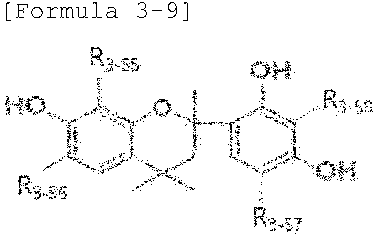

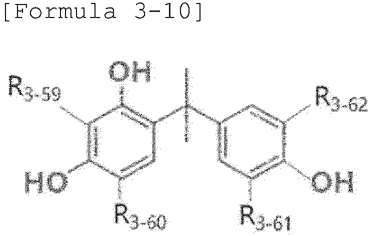

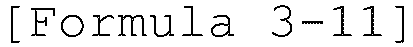

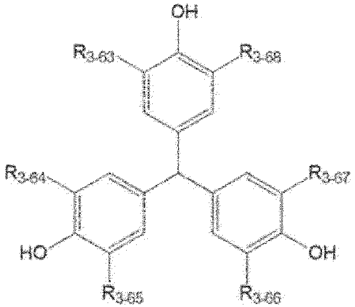

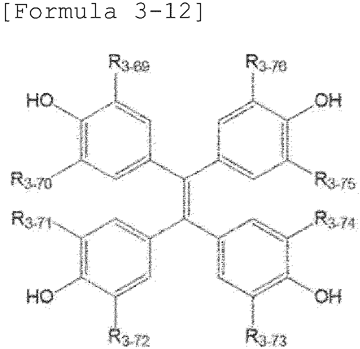

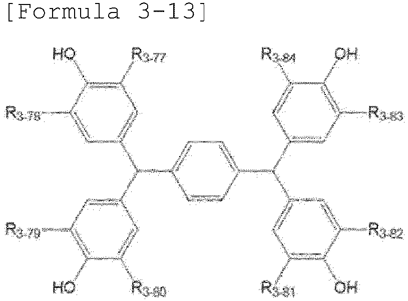

In the above formulas, R₃₋₁ to R₃₋₈₄ are each independently hydrogen, an alkyl group having 1 to 4 carbon atoms, or an alkenyl group having 2 to 4 carbon atoms, and Z₁ to Z₄ are each independently hydrogen or an alkyl group having 1 to 4 carbon atoms.

According to one embodiment of the present disclosure, the content of the esterified quinone diazide compound may be 10 parts by weight or more and 40 parts by weight or less based on 100 parts by weight of the alkali-soluble polymer resin.

According to one embodiment of the present disclosure, the crosslinking agent may comprise at least one of compounds represented by Formulas 4-1 to 4-21 below:

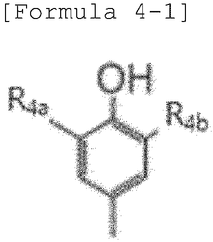

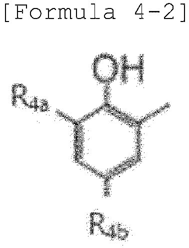

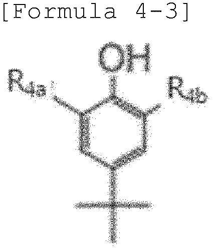

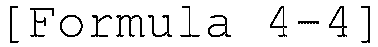

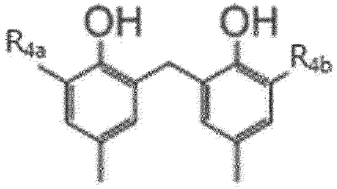

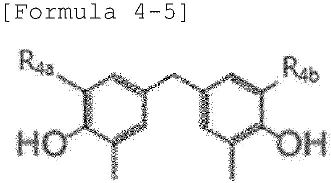

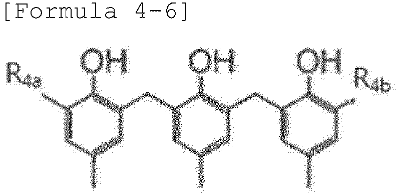

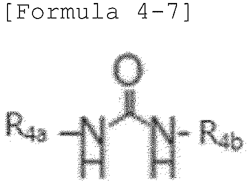

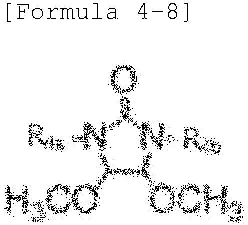

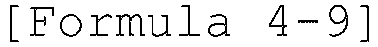

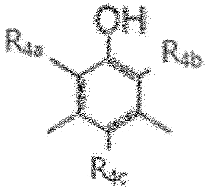

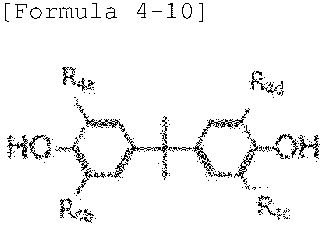

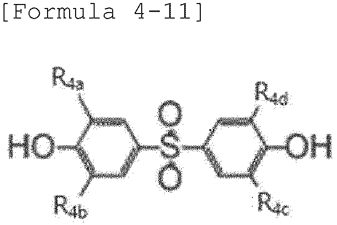

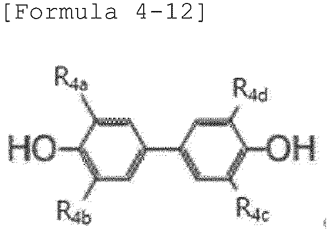

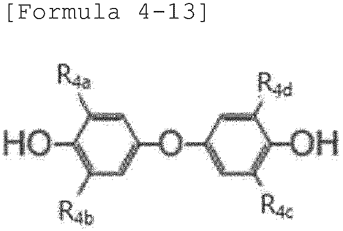

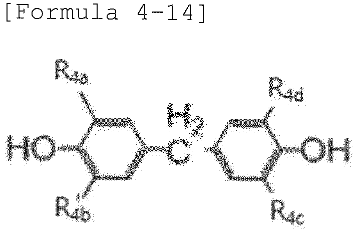

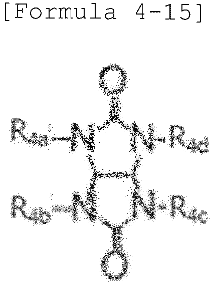

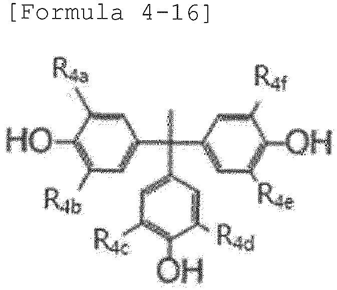

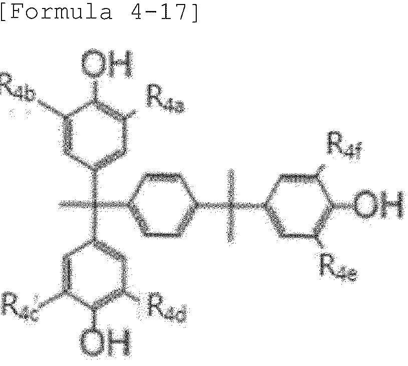

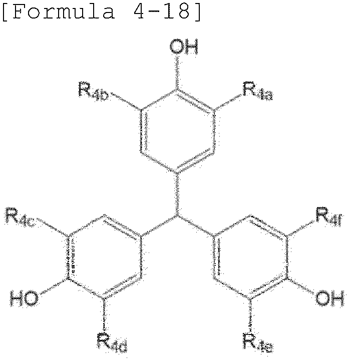

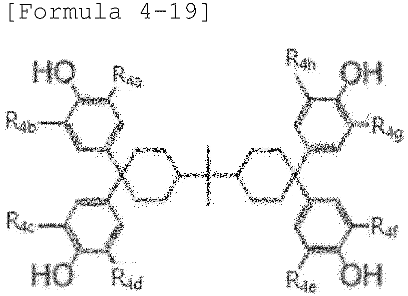

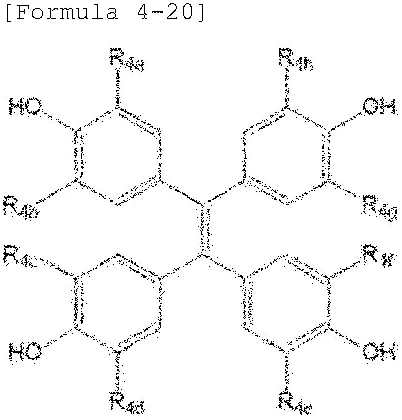

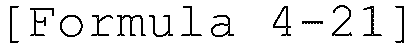

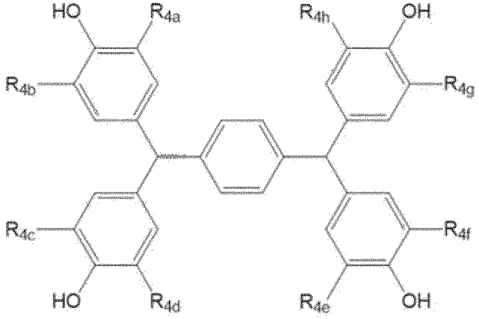

In the above formulas, R₄ₐ to R₄ₕ are each independently hydrogen, an alkyl group having 1 to 3 carbon atoms, or *-(CH₂)ₘ-O-R₄₋₁, at least one of R₄ₐ and R_{4b} in Formulas 4-1 to 4-8 above is *-(CH₂)ₘ-O-R_{4**-**1}, at least one of R₄ₐ to R_{4c} in Formula 4-9 above is -(CH₂)ₘ-O-R_{4**-1**}, at least one of R₄ₐ to R_{4d} in Formulas 4-10 to 4-15 above is *-(CH₂)(-O-R₄₋₁, at least one of R₄ₐ to R_{4f} in Formulas 4-16 to 4-18 above is *-(CH₂)ₘ-O-R₄₋₁, at least one of R₄ₐ to R₄ₕ in Formulas 4-19 to 4-21 above is *-(CH₂)ₘ-O-R₄₋₁, m is an integer ranging from 1 to 6, and R₄₋₁ is an alkyl group having 1 to 3 carbon atoms.

According to one embodiment of the present disclosure, the content of the crosslinking agent may be 5 parts by weight or more and 30 parts by weight or less based on 100 parts by weight of the alkali-soluble polymer resin.

According to one embodiment of the present disclosure, the positive photosensitive resin composition may further comprise at least one of an organic solvent, a surfactant, and an additive.

**One** embodiment of the present disclosure provides an electronic component comprising an insulating film comprising a cured product of the positive photosensitive resin composition.

One embodiment of the present disclosure provides a display device comprising an insulating film comprising a cured product of the positive photosensitive resin composition.

### Advantageous Effects

The positive photosensitive resin composition according to one embodiment of the present disclosure may have excellent sensitivity, film retention rate, adhesion, chemical resistance, heat resistance, solar resistance, hygroscopicity, operation reliability, and bending characteristics.

In addition, the electronic component according to one embodiment of the present disclosure may have excellent sensitivity, film retention rate, adhesion, chemical resistance, heat resistance, solar resistance, hygroscopicity, operation reliability, and bending characteristics.

In addition, the display device according to one embodiment of the present disclosure may have excellent sensitivity, film retention rate, adhesion, chemical resistance, heat resistance, solar resistance, hygroscopicity, operation reliability, and bending characteristics.

The effects of the present disclosure are not limited to the above-described effects, and effects not mentioned will be clearly understood by those skilled in the art from the present specification and the accompanying drawings.

### Brief Description of Drawings

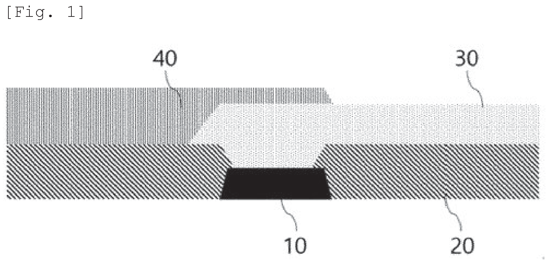

Fig. 1 is a diagram showing forming a patterned film on a patterned ITO substrate and depositing EL thereon.

### Best Mode for Invention

Throughout the present specification, when any part is referred to as "including" any component, this means that the part does not exclude other component(s), but may further include other component(s), unless specifically stated otherwise.

Throughout the present specification, when any member is referred to as being placed "on" another member, this includes not only a case where any member is in contact with another member, but also a case where a third member exists between the two members.

Throughout the present specification, the unit "parts by weight" may mean the weight ratio between components.

Throughout the present specification, terms including ordinal numbers, such as "first" and "second," are used for the purpose of distinguishing one component from another component and are not limited by the ordinal numbers. For example, a first component may be referred to as a second component, and similarly, a second component may be referred to as a first component, without departing from the scope of the present disclosure.

Throughout the present specification, the "weight-average molecular weight" of any compound may be calculated using the molecular weight and molecular weight distribution of the compound. Specifically, the molecular weight and molecular weight distribution of the compound may be obtained by: placing tetrahydrofuran (THF) and the compound in a 1-ml glass vial to prepare a test sample in which the concentration of the compound is 1 wt%; filtering a standard sample (polystyrene) and the test sample through a filter (pore size: 0.45 µm); injecting each of the sample filtrates into a GPC injector; and comparing the elution time of the test sample with a calibration curve of the standard sample. At this time, Infinity II 1260 (Agilent Technologies, Inc.) may be used as a measurement instrument, and the flow rate and the column temperature may be set at 1.00 mL/min and 40.0°C, respectively.

Throughout the present specification, "*" represents a linking moiety.

Hereinafter, the present specification will be described in more detail.

One embodiment of the present disclosure provides a positive photosensitive resin composition containing: an alkali-soluble polymer resin; an esterified quinone diazide compound; and a crosslinking agent containing a phenol group, wherein the alkali-soluble polymer resin includes a reaction product of a mixture including an amine-based compound, an acid anhydride compound, and a capping compound, and satisfies Equation 1 below:

[Equation 1] $\left(A+B\right) / 2 < 6.0 eV$

In Equation 1 above, A is the CTC value (eV) of the amine-based compound, and B is the sum of the CTC value (eV) of the acid anhydride compound and the CTC value (eV) of the capping compound in a mixture of the acid anhydride compound and the capping compound, wherein the CTC value represents the quantum calculation simulation value for the energy level difference between an electron donor and an electron acceptor in the compound, assuming that the compound forms a charge transfer complex.

The positive photosensitive resin composition according to one embodiment of the present disclosure may have excellent sensitivity, film retention rate, adhesion, chemical resistance, heat resistance, solar resistance, hygroscopicity, operation reliability, and bending characteristics.

According to one embodiment of the present disclosure, the alkali-soluble polymer resin satisfies Equation 1 above. Specifically, the CTC value of the alkali-soluble polymer resin may be 3.5 eV or more and less than 6.0 eV as calculated by Equation 1-1 below. [Equation 1-1] $CTC \left(eV\right) of alkali - soluble polymer resin = \left(A+B\right) / 2$

In Equation 1-1 above, A and B are the same as those defined in Equation 1 above. Here, the CTC value represents the quantum calculation simulation value for the energy level difference between an electron donor (HOMO) and an electron acceptor (LUMO) in each of the amine-based compound, the acid anhydride compound and the capping compound, assuming that each of the amine-based compound, the acid anhydride compound and the capping compound forms a charge transfer complex. In this case, the quantum calculation simulation value may be calculated using M06-2X/6-311G by applying Gaussian 16, density functional theory.

According to one embodiment of the present disclosure, the CTC value of the amine-based compound may be the CTC value based on 100 parts by weight of the amine-based compound. For example, based on 100 parts by weight of the amine-based compound represented by Compound 1-2 described below, the CTC value of Compound 1-2 may be 4.56 eV. In addition, based on 100 parts by weight of the amine-based compound represented by Compound 1-15 described below, the CTC value of Compound 1-15 may be 5.49 eV. Meanwhile, the amine-based compound may include one or more amine compounds. In this case, the CTC value of the amine-based compound may be calculated through the CTC value of each amine compound included in the amine-based compound and the weight ratio (mixing ratio) between the amine compounds. For example, based on 100 parts by weight of the amine-based compound, the content of Compound 1-2 may be 30 parts by weight, and the content of Compound 1-15 may be 70 parts by weight. In this case, the CTC value (A) of the amine-based compound in Equation 1 and Equation 1-1 may be the sum of the CTC value of Compound 1-2 (4.56 eV X (30/100)) and the CTC value of Compound 1-15 (5.49 eV X (70/100)) in the amine-based compound.

According to one embodiment of the present disclosure, the CTC value of the acid anhydride compound may be the CTC value based on 100 parts by weight of the acid anhydride compound. In this case, 100 parts by weight of the acid anhydride compound may be the content based on 100 parts by weight of the amine-based compound. For example, based on 100 parts by weight of the acid anhydride compound represented by Compound 2-4 described below, the CTC value of Compound 2-4 may be 5.92 eV. In addition, the CTC value of the capping compound may be the CTC value based on 100 parts by weight of the capping compound. In this case, 100 parts by weight of the capping compound may be the content based on 100 parts by weight of the amine-based compound. For example, based on 100 parts by weight of the capping compound represented by Compound C-4 described below, the CTC value of Compound C-4 may be 4.60 eV.

In Equations 1 and 1-1 above, the sum (B) of the CTC value (eV) of the acid anhydride compound and the CTC value (eV) of the capping compounds may be calculated as follows. For example, based on 100 parts by weight of the amine-based compound, the content of Compound 2-4 may be 80 parts by weight, and the content of Compound C-4 may be 40 parts by weight. B in Equations 1 and 1-1 above may be the sum of the CTC value of Compound 2-4 (5.92 eV X (80/120)) and the CTC value of Compound C-4 (4.60 eV X (40/120)) in a mixture of the acid anhydride compound and the capping compound.

According to one embodiment of the present disclosure, the CTC value of the alkali-soluble polymer resin as calculated by Equation 1-1 may be 3.5 eV or more and less than 6.0 eV, 3.7 eV or more and 5.99 eV or less, 3.9 eV or more and 5.95 eV or less, 4.0 eV or more and 5.9 eV or less, 4.2 eV or more and 5.8 eV or less, 4.4 eV or more and 5.7 eV or less, 4.6 eV or more and 5.6 eV or less, 4.8 eV or more and 5.5 eV or less, 5.0 eV or more and 5.4 eV or less, 4.0 eV or more and 5.5 eV or less, 4.3 eV or more and 5.2 eV or less, 4.6 eV or more and 5.1 eV or less, 4.7 eV or more and 5.0 eV or less, and 5.0 eV or more and 5.99 eV or less, 5.2 eV or more and 5.95 eV or less, 5.4 eV or more and 5.9 eV or less, or 5.6 eV or more and 5.8 eV or less. It is possible to effectively provide a cured product having excellent sensitivity, film retention rate, adhesion, chemical resistance, heat resistance, solar resistance, hygroscopicity, operation reliability, and bending characteristics, which contains the alkali-soluble polymer resin satisfying the above-described CTC value range.

According to one embodiment of the present disclosure, the fluorine content of the positive photosensitive composition may be 10,000 ppm or less. Specifically, the positive photosensitive composition has a fluorine content of 0 ppm or more and 10,000 ppm or less, 500 ppm or more and 9,500 ppm or less, 1,000 ppm or more and 9,000 ppm or less, 2,000 ppm or more and 8,000 ppm or less, 3,000 ppm or more and 7,000 ppm or less, 4,000 ppm or more and 6,000 ppm or less, 0 ppm or more and 6,000 ppm or less, 100 ppm or more and 5,500 ppm or less, 300 ppm or more and 5,000 ppm or less, 700 ppm or more and 4,500 ppm or less, 900 ppm or more and 4,000 ppm or less, 1,100 ppm or more and 3,500 ppm or less, 1,500 ppm or more and 3,300 ppm or less, 1,700 ppm or more and 2,900 ppm or less, 5,000 ppm or more and 10,000 ppm or less, 5,500 ppm or more and 9,000 ppm or less, 6,000 ppm or more and 8,500 ppm or less, or 6,500 ppm or more and 8,000 ppm or less. The positive photosensitive resin composition having a fluorine content satisfying the above-described range may have excellent physical properties such as heat resistance, solar resistance, hygroscopicity, and operation reliability.

According to one embodiment of the present disclosure, the alkali-soluble polymer resin may include a repeating unit represented by Formula A below and a repeating unit represented by Formula B below:

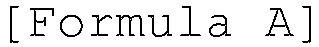

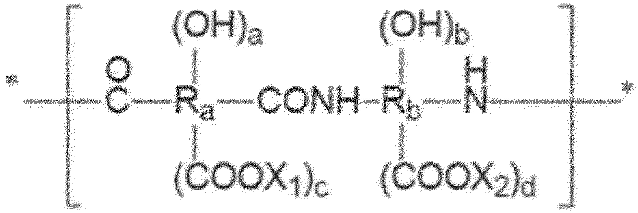

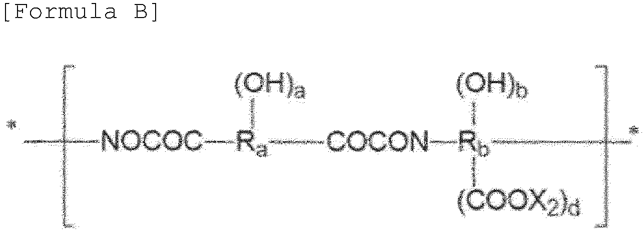

In Formulas A and B above, Rₐ and R_{b} are each independently an organic group having 5 to 60 carbon atoms, X₁ and X₂ are each independently hydrogen or an alkyl group having 1 to 10 carbon atoms, a and b are each independently an integer ranging from 0 to 4, c and d are each independently an integer ranging from 0 to 2, and a+b is 1 or more.

Specifically, Rₐ may include at least one of an aromatic group having 6 to 30 carbon atoms, a cycloalkyl group having 5 to 10 carbon atoms, and a cycloalkene group having 5 to 10 carbon atoms. In addition, R_{b} may include at least one aromatic group having 6 to 30 carbon atoms. X₁ and X₂ may be hydrogen. a may be 0 to 3, 0 to 2, 0 to 1, or 0. b may be 1 to 3, 2 to 3, or 2. c may be 1 to 2, or 2. d may be 0 to 1, or 0.

By using the alkali-soluble polymer resin including the repeating unit represented by Formula A and the repeating unit represented by Formula B, it is possible to provide a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the repeating unit represented by Formula A may be a repeating unit represented by Formula A-1 below, and the repeating unit represented by Formula B may be a repeating unit represented by Formula B-1 below.

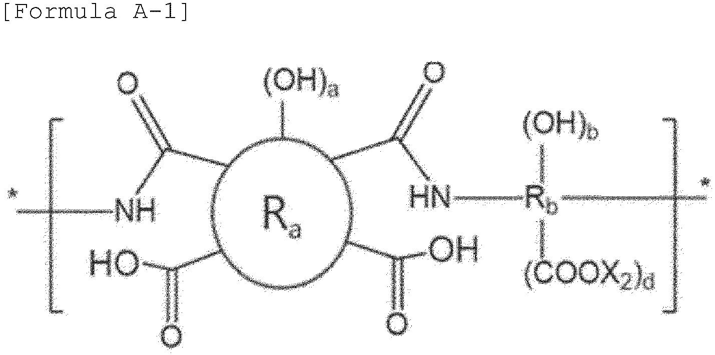

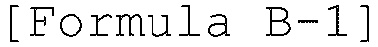

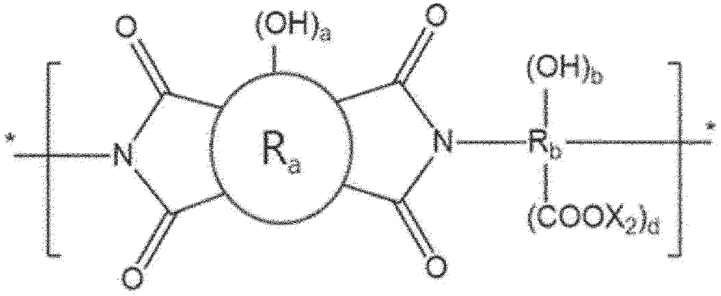

Rₐ, R_{b}, X₁, X₂, and a to d in Formulas A-1 and B-1 above are the same as those defined in Formulas A and B above. That is, the repeating unit represented by Formula A-1 may contain an amic acid bond, and the repeating unit represented by Formula B-1 may contain an imide bond.

According to one embodiment of the present disclosure, the alkali-soluble polymer resin may have, based on a total of 100 mol% of the repeating unit represented by Formula A and the repeating unit represented by Formula B, 51 mol% or more of the repeating unit represented by Formula B. That is, based on a total of 100 mol% of the repeating unit containing an amic acid bond and the repeating unit containing an imide bond, the content of the repeating unit containing an imide bond may be 51 mol% or more.

Specifically, based on a total of 100 mol% of the repeating unit represented by Formula A and the repeating unit represented by Formula B, the content of the repeating unit represented by Formula B may be 51 mol% or more and 97 mol% or less, 55 mol% or more and 97 mol% or less, 60 mol% or more and 97 mol% or less, 65 mol% or more and 97 mol% or less, 70 mol% or more and 97 mol% or less, 75 mol% or more and 97 mol% or less, 80 mol% or more and 97 mol% or less, 85 mol% or more and 95 mol% or less, 88 mol% or more and 95 mol% or less, 89 mol% or more and 95 mol% or less, 90 mol% or more and 95 mol% or less, 91 mol% or more and 95 mol% or less, or 93 mol% or more and 95 mol% or less. By using the alkali-soluble polymer resin in which the content of the repeating unit represented by Formula B satisfies the above-described range, it is possible to provide a positive photosensitive resin composition having improved chemical resistance and heat resistance.

According to one embodiment of the present disclosure, the repeating unit represented by Formula A and the repeating unit represented by Formula B may include a structure derived from an amine-based compound containing R_{b}. Specifically, the amine-based compound may contain one or more amine groups in its structure. The amine-based compound may include a diamine-based compound. More specifically, the amine-based compound may contain at least a first aromatic group having 6 to 30 carbon atoms to which one or more amine groups are attached, and a second aromatic group having 6 to 30 carbon atoms to which one or more amine groups are attached. By using the alkali-soluble polymer resin having a structure derived from the amine-based compound containing R_{b}, it is possible to provide a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the amine-based compound may include at least one of compounds represented by Formulas 1-1 to 1-19 below.

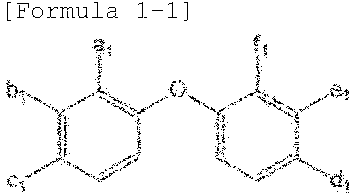

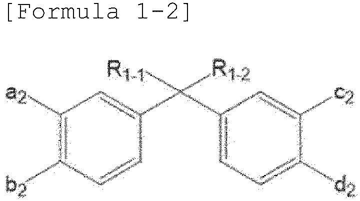

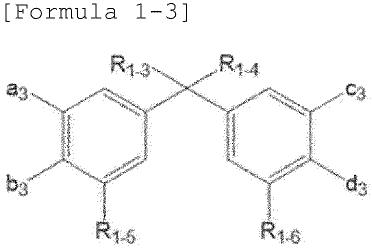

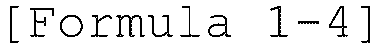

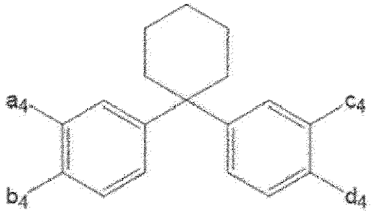

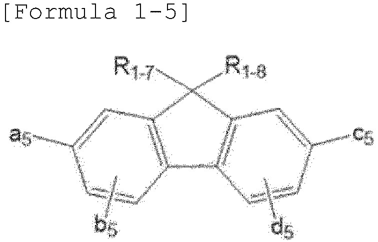

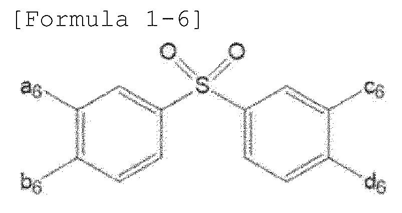

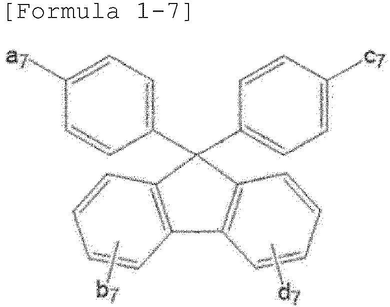

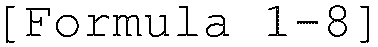

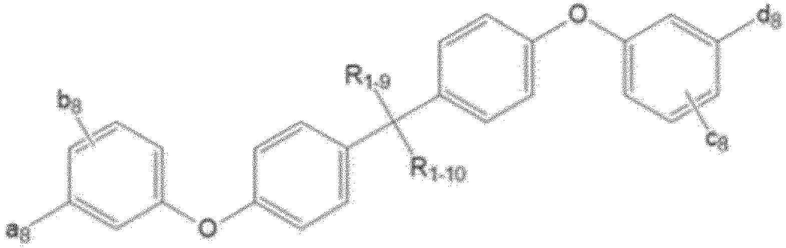

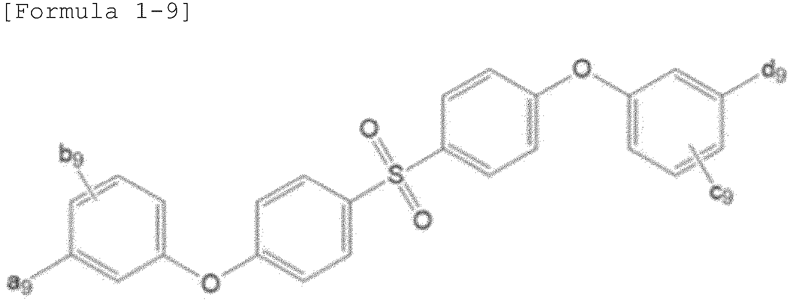

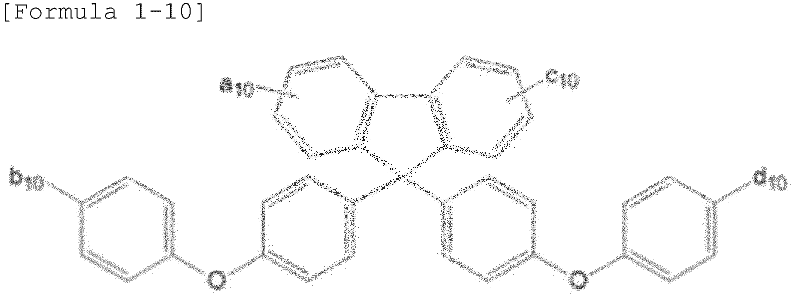

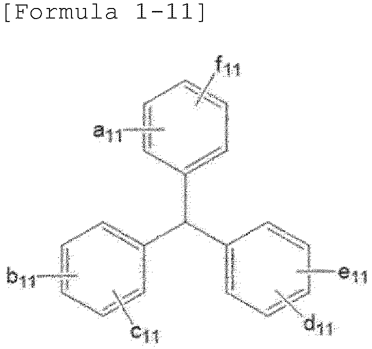

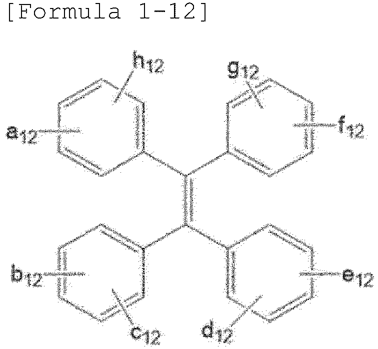

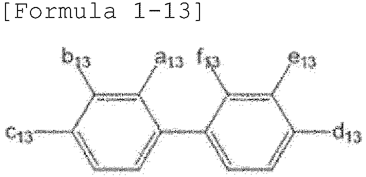

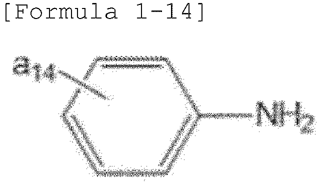

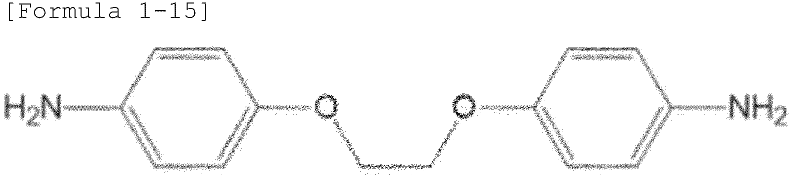

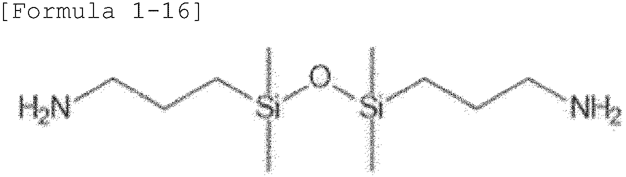

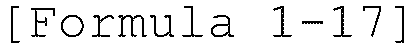

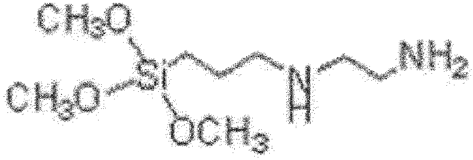

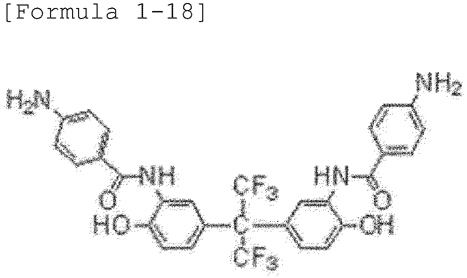

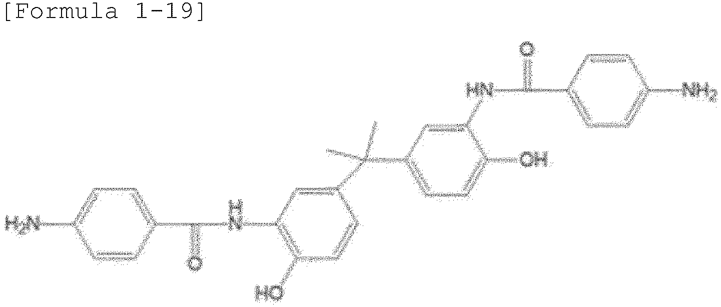

wherein at least two of a₁, b₁, c₁, d₁, e₁ and f₁ are amine groups, and the remainder are hydrogen, hydroxyl groups, halogen-substituted alkyl groups having 1 to 3 carbon atoms, or -COOX₂; at least two of a₂, b₂, c₂ and d₂ are amine groups, and the remainder are hydrogen, hydroxyl groups, or -COOX₂; R₁₋₁ and R₁₋₂ are each independently hydrogen, an alkyl group having 1 to 10 carbon atoms, a halogen-substituted alkyl group having 1 to 3 carbon atoms, or a cycloalkyl group having 5 to 10 carbon atoms; at least two of a₃, b₃, c₃ and d₃ are amine groups, and the remainder are hydrogen, hydroxyl groups, or -COOX₂; R₁₋₃ and R₁₋₄ are each independently an alkyl group having 1 to 10 carbon atoms or a cycloalkyl group having 5 to 10 carbon atoms; R₁₋₅ and R₁₋₆ are each independently hydrogen or an alkyl group having 1 to 10 carbon atoms; at least two of a₄, b₄, c₄ and d₄ are amine groups, and the remainder are hydrogen, hydroxyl groups, or -COOX₂; at least two of a₅, b₅, c₅ and d₅ are amine groups, and the remainder are hydrogen, hydroxyl groups, or -COOX₂; R₁₋₇ and R₁₋₈ are each independently an alkyl group having 1 to 10 carbon atoms or a cycloalkyl group having 5 to 10 carbon atoms; at least two of a₆, b₆, c₆ and d₆ are amine groups, and the remainder are hydrogen, hydroxyl groups, or -COOX₂; at least two of a₇, b₇, c₇ and d₇ are amine groups, and the remainder are hydrogen, hydroxyl groups, or -COOX₂; at least two of a₈, b₈, c₈ and d₈ are amine groups, and the remainder are hydrogen, hydroxyl groups, or -COOX₂; R₁₋₉ and R₁₋₁₀ are each independently an alkyl group having 1 to 10 carbon atoms or a cycloalkyl group having 5 to 10 carbon atoms; at least two of a₉, b₉, c₉ and d₉ are amine groups, and the remainder are hydrogen, hydroxyl groups, or -COOX₂; at least two of a₁₀, b₁₀, c₁₀ and d₁₀ are amine groups, and the remainder are hydrogen, hydroxyl groups, or -COOX₂; at least two of a₁₁, b₁₁, c₁₁, d₁₁, e₁₁ and f₁₁ are amine groups, and the remainder are hydrogen, hydroxyl groups, or -COOX₂; at least two of a₁₂, b₁₂, c₁₂, d₁₂, e₁₂, f₁₂ and g₁₂ are amine groups, and the remainder are hydrogen, hydroxyl groups, or -COOX₂; at least two of a₁₃, b₁₃, c₁₃, d₁₃, e₁₃ and f₁₃ are amine groups, and the remainder are hydrogen, hydroxyl groups, unsubstituted or halogen-substituted alkyl groups having 1 to 3 carbon atoms, or -COOX₂; a₁₄ is a thiol group, an amine group, or a hydroxyl group; and X₂ is hydrogen or an alkyl group having 1 to 10 carbon atoms. Here, the halogen may be fluorine (F).

Specifically, in Formula 1-1 above, b₁ and e₁ may be amine groups. Also, in Formula 1-1 above, c₁ and d₁ may be amine groups. In Formula 1-2 above, a₂ and c₂ may be amine groups. Also, in Formula 1-2 above, b₂ and d₂ may be amine groups. In Formula 1-3 above, a₃ and c₃ may be amine groups. In Formula 1-4 above, a₄ and c₄ may be amine groups. In Formula 1-5 above, b₅ and d₅ may be amine groups. In Formula 1-6 above, a₆ and c6 may be amine groups. Also, in Formula 1-6 above, b₆ and d₆ may be amine groups. In Formula 1-7 above, b₇ and d₇ may be amine groups. In Formula 1-8 above, a₈ and d₈ may be amine groups. In Formula 1-9, a₉ and d₉ may be amine groups. In Formula 1-10 above, a₁₀ and c₁₀ may be amine groups. In Formula 1-11 above, b₁₁ and e₁₁ may be amine groups. In Formula 1-12 above, b₁₂ and e₁₂ may be amine groups. In Formula 1-13 above, c₁₃ and d₁₃ may be amine groups.

By using the alkali-soluble polymer resin having a structure derived from an amine-based compound including at least one of the compounds represented by Formulas 1-1 to 1-19, it is possible to effectively realize a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the CTC value of the amine-based compound may be 4.0 eV or more and 8.0 eV or less. That is, the CTC value of each of the compounds represented by Formulas 1-1 to Formula 1-19 may be 4.0 eV or more and 8.0 eV or less. In this case, the CTC value of the amine-based compound may be based on 100 parts by weight of the amine-based compound. Specifically, the CTC value of the amine-based compound may be 4.2 eV or more and 7.5 eV or less, 4.4 eV or more and 7.0 eV or less, 4.6 eV or more and 7.0 eV or less, 4.8 eV or more and 7.0 eV or less, 5.0 eV or more and 7.0 eV or less, 5.2 eV or more and 7.0 eV or less, 5.4 eV or more and 7.0 eV or less, 5.6 eV or more and 7.0 eV or less, 5.8 eV or more and 7.0 eV or less, 6.0 eV or more and 7.0 eV or less, 6.2 eV or more and 7.0 eV or less, or 6.5 eV or more and 7.0 eV or less. When the CTC value of the amine-based compound is within the above-described range, it is possible to effectively realize a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the amine-based compound may include at least one of Compounds 1-1 to 1-32 below.

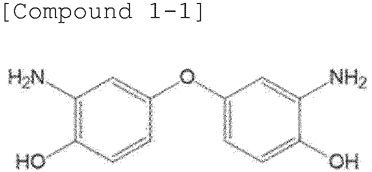

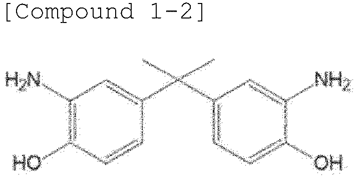

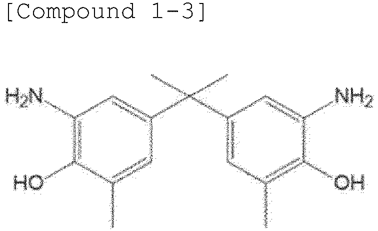

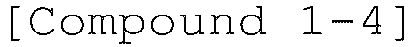

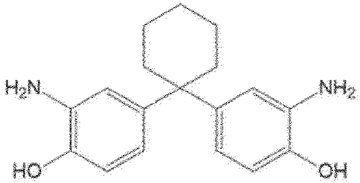

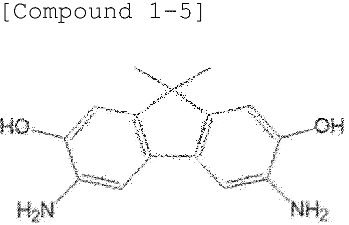

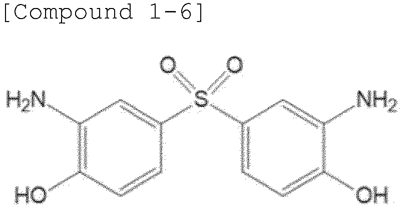

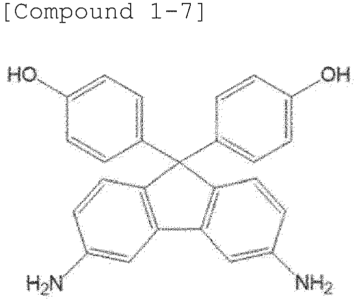

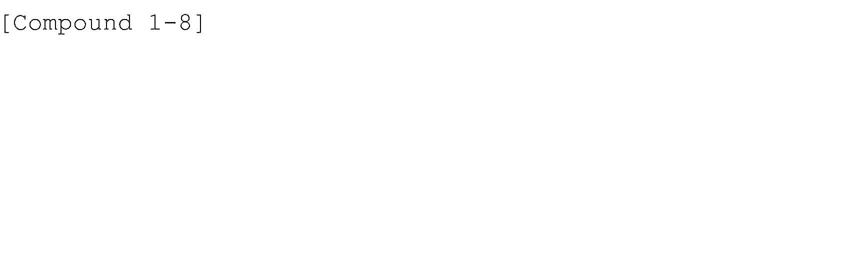

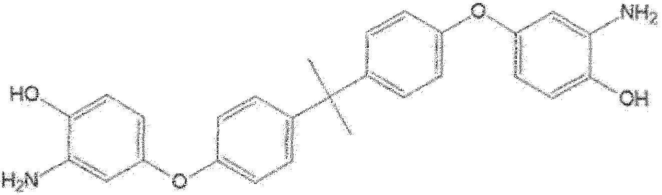

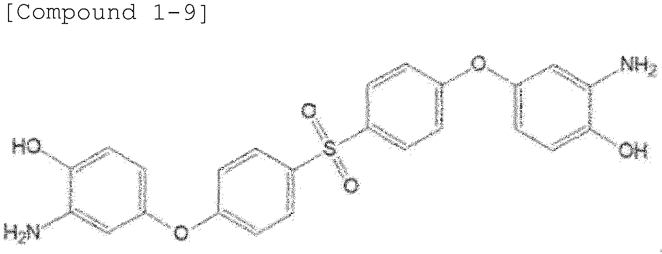

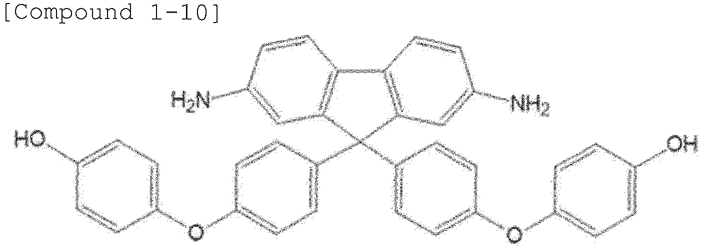

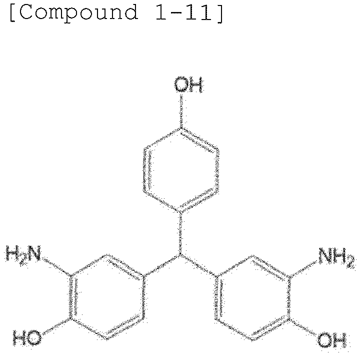

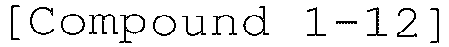

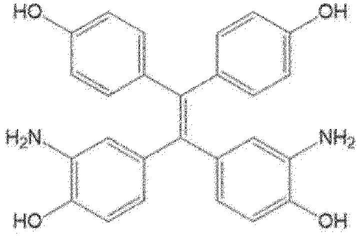

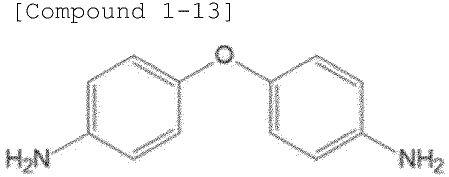

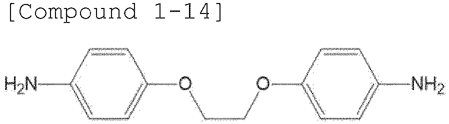

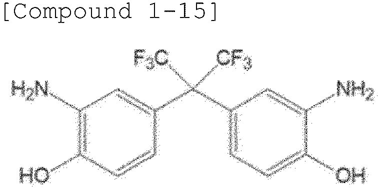

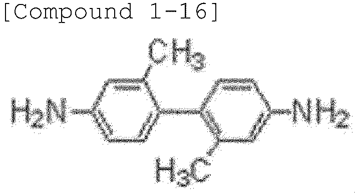

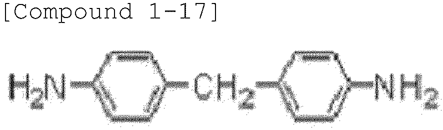

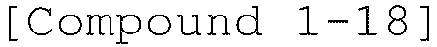

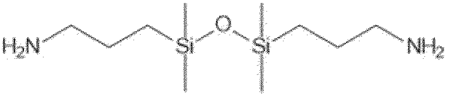

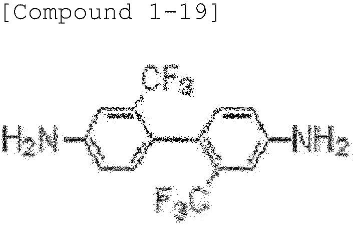

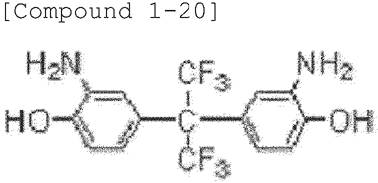

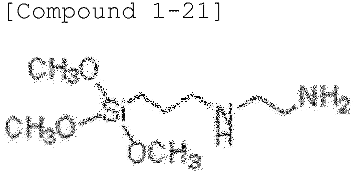

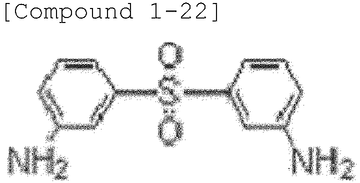

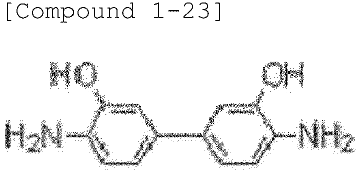

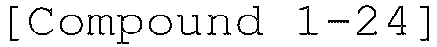

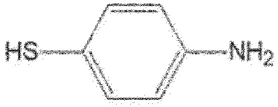

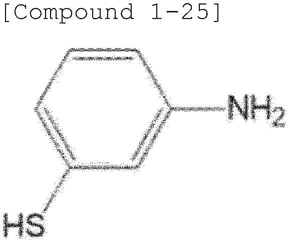

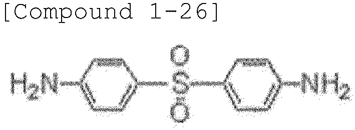

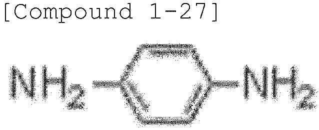

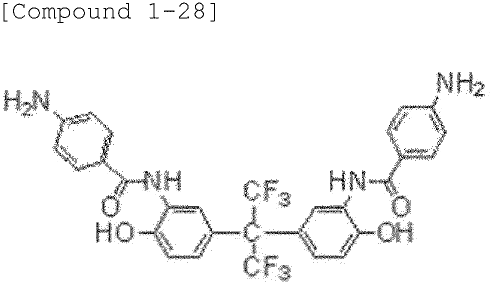

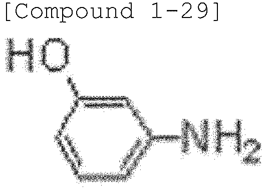

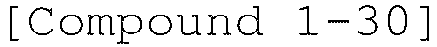

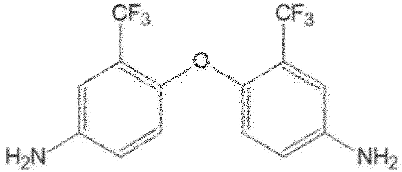

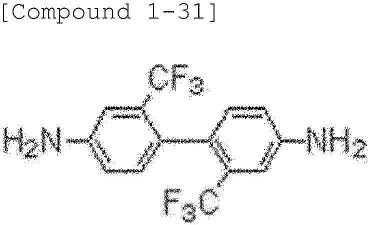

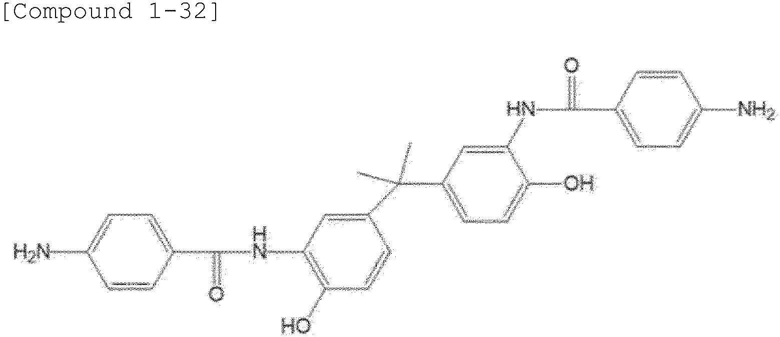

When an amine-based compound including at least one of Compounds 1-1 to 1-32 above is used, the positive photosensitive resin composition may have excellent sensitivity, film retention rate, adhesion, chemical resistance, heat resistance, solar resistance, hygroscopicity, operation reliability, and bending characteristics.

According to one embodiment of the present disclosure, the repeating unit represented by Formula A and the repeating unit represented by Formula B may include a structure derived from an acid anhydride compound containing Rₐ. Specifically, the acid anhydride compound may include an acid dianhydride compound. More specifically, the acid anhydride compound may include a cyclic acid dianhydride compound. More specifically, the acid anhydride compound may include at least a third aromatic group having 6 to 30 carbon atoms to which an acid anhydride group is attached, and a fourth aromatic group having 6 to 30 carbon atoms to which an acid anhydride group is attached. By using the alkali-soluble polymer resin having a structure derived from the acid anhydride compound containing Rₐ, it is possible to provide a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the acid anhydride compound may include at least one of compounds represented by Formulas 2-1 to 2-16 below:

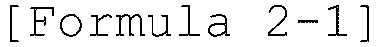

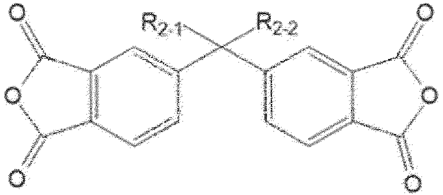

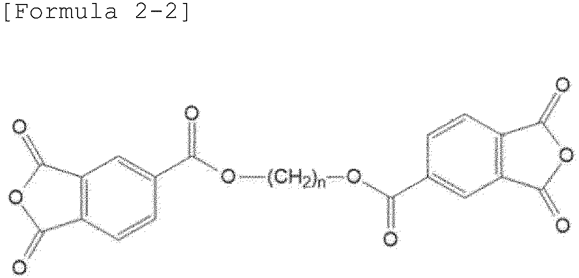

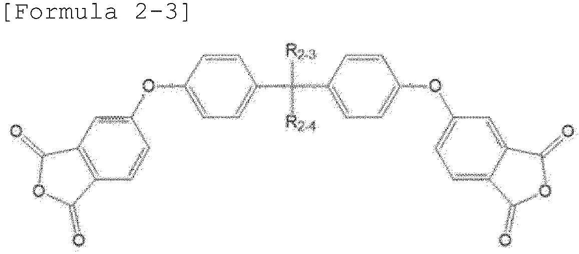

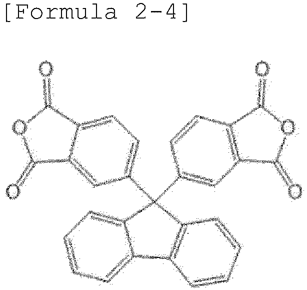

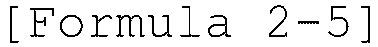

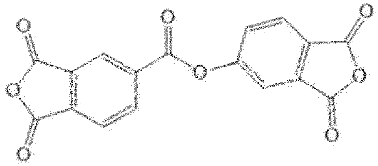

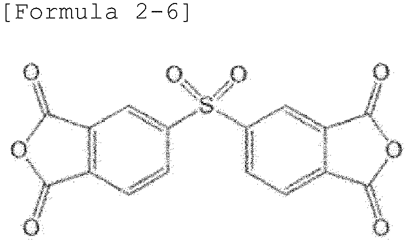

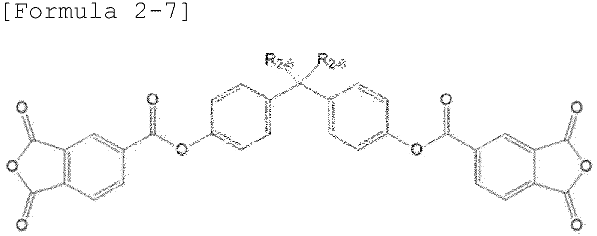

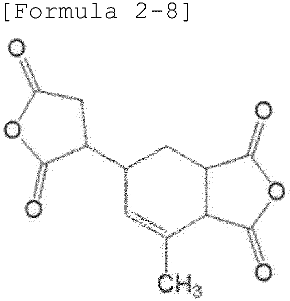

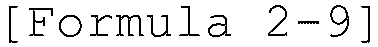

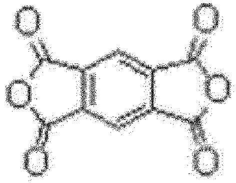

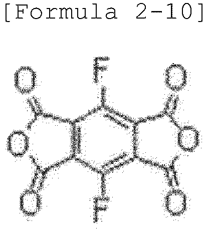

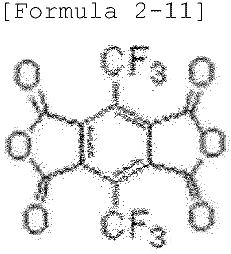

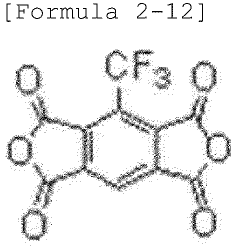

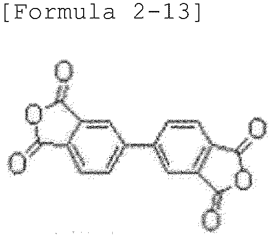

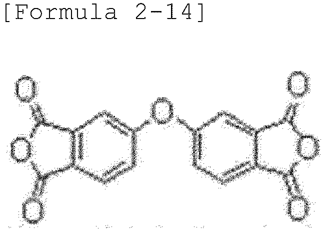

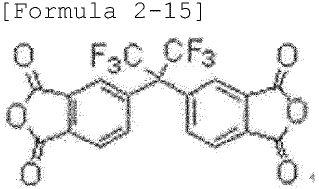

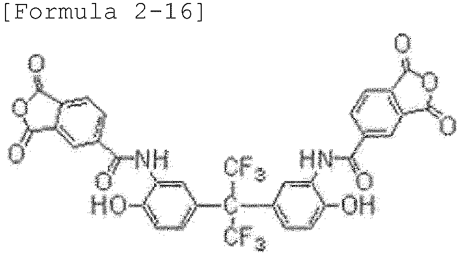

In the above Formulas, R₂₋₁ to R₂₋₆ are each independently an alkyl group having 1 to 10 carbon atoms or a cycloalkyl group having 5 to 10 carbon atoms, and n is an integer ranging from 2 to 20. Specifically, R₂₋₁ to R₂₋₆ may each independently be an alkyl group, wherein the number of carbon atoms in the alkyl group may be 1 to 8, 1 to 5, 1 to 3, or 1. n may be an integer ranging from 2 to 18, 2 to 16, 2 to 14, 2 to 12, 2 to 10, 2 to 8, 2 to 6, or 2 to 4.

By using the alkali-soluble polymer resin having a structure derived from an acid anhydride compound including at least one of the compounds represented by Formulas 2-1 to 2-16, it is possible to effectively realize a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the CTC value of the acid anhydride compound may be 4.0 eV or more and 7.0 eV or less. That is, the CTC value of each of the compounds represented by Formulas 2-1 to 2-16 may be 4.0 eV or more and 7.0 eV or less. In this case, the CTC value of the acid anhydride compound may be based on 100 parts by weight of the acid anhydride compound for 100 parts by weight of the amine-based compound. Specifically, the CTC value of the acid anhydride compound may be 4.2 eV or more and 6.5 eV or less, 4.4 eV or more and 6.0 eV or less, 4.6 eV or more and 6.0 eV or less, 4.8 eV or more and 6.0 eV or less, 5.0 eV or more and 6.0 eV or less, 5.2 eV or more and 6.0 eV or less, 5.4 eV or more and 6.0 eV or less, 5.6 eV or more and 6.0 eV or less, or 5.8 eV or more and 6.0 eV or less. When the CTC value of the acid anhydride compound is within the above-described range, it is possible to effectively realize a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the acid anhydride compound may include at least one of Compounds 2-1 to 2-17 below. 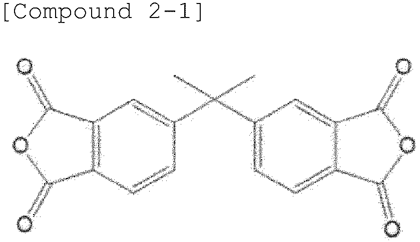 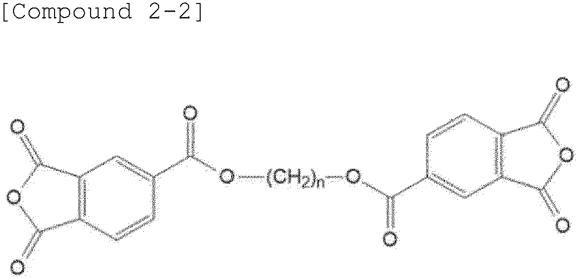 (n is an integer of 2) 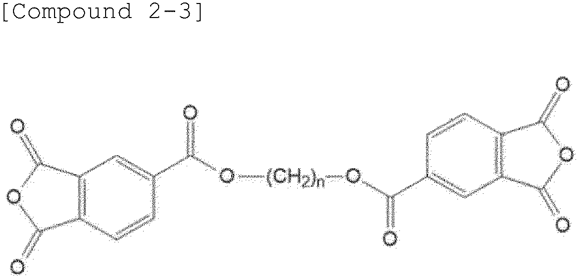 (n is an integer of 4)

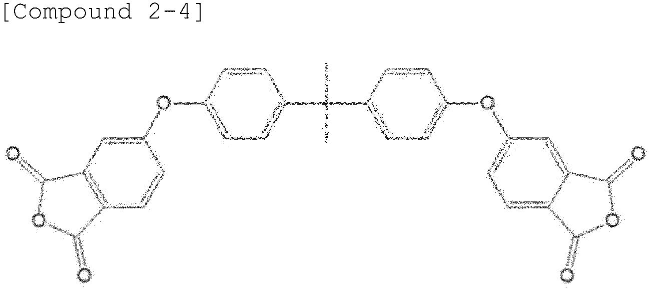

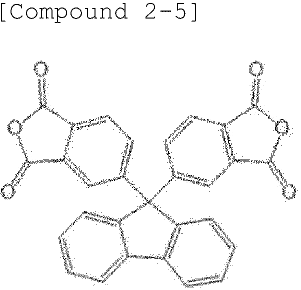

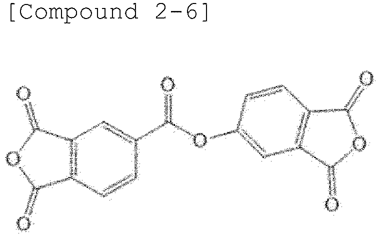

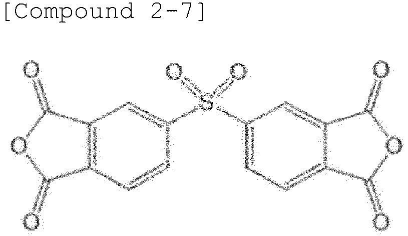

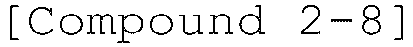

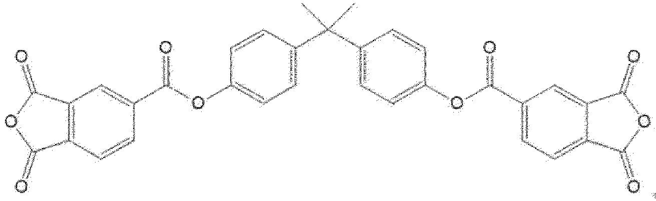

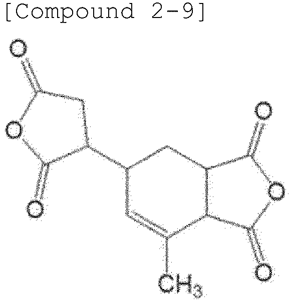

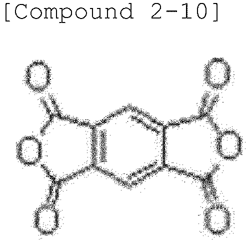

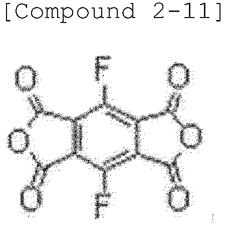

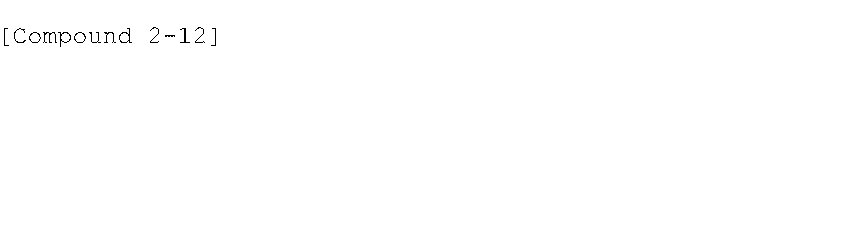

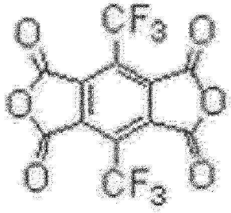

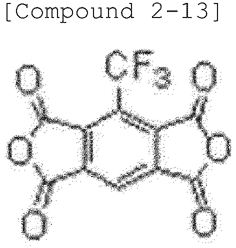

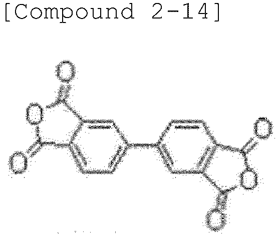

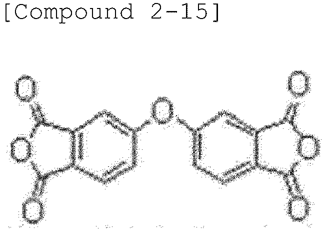

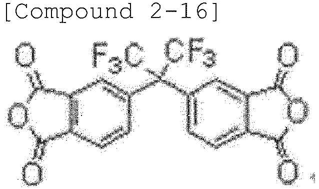

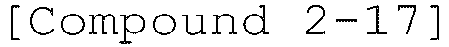

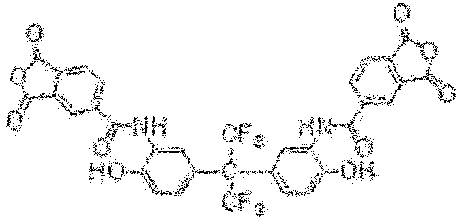

When an acid anhydride compound including at least one of Compounds 2-1 to 2-17 above is used, the positive photosensitive resin composition may have excellent sensitivity, film retention rate, adhesion, chemical resistance, heat resistance, solar resistance, hygroscopicity, operation reliability, and bending characteristics.

According to one embodiment of the present disclosure, the alkali-soluble polymer resin may be one in which the ends of the main chain are capped with a capping compound including an acid anhydride compound. The capping compound may include a cyclic acid anhydride compound. The cyclic acid anhydride compound may include a benzene ring or a cyclohexene ring.

According to one embodiment of the present disclosure, the capping compound may include at least one of Compounds C-1 to C-5 below:

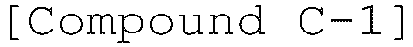

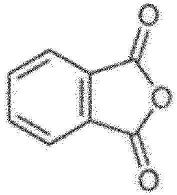

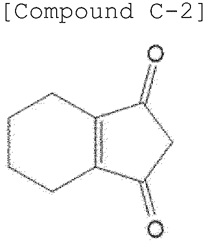

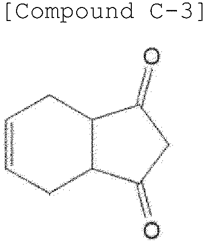

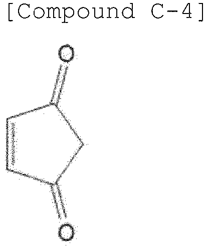

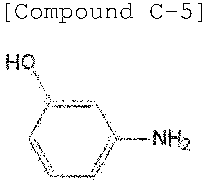

When the alkali-soluble polymer resin contains end groups derived from the capping compound, the positive photosensitive resin composition may have excellent sensitivity, film retention rate, adhesion, chemical resistance, heat resistance, solar resistance, hygroscopicity, operation reliability, and bending characteristics.

According to one embodiment of the present disclosure, the CTC value of the capping compound may be 4.0 eV or more and 6.0 eV or less. That is, the CTC value of each of the compounds represented by Compounds C-1 to C-5 may be 4.0 eV or more and 6.0 eV or less. In this case, the CTC value of the capping compound may be based on 100 parts by weight of the capping compound for 100 parts by weight of the amine-based compound. Specifically, the CTC value of the capping compound may be 4.2 eV or more and 5.5 eV or less, 4.4 eV or more and 5.0 eV or less, 4.6 eV or more and 5.0 eV or less, or 4.8 eV or more and 5.0 eV or less. When the CTC value of the capping compound is within the above-described range, it is possible to effectively realize a positive photosensitive resin composition having improved sensitivity, film retention rate, adhesion, chemical resistance, heat resistance, solar resistance, hygroscopicity, operation reliability, and bending characteristics.

According to one embodiment of the present disclosure, the esterified quinone diazide compound may include a reaction product of a quinone diazide compound and at least one of phenol compounds represented by Formulas 3-1 to 3-13 below:

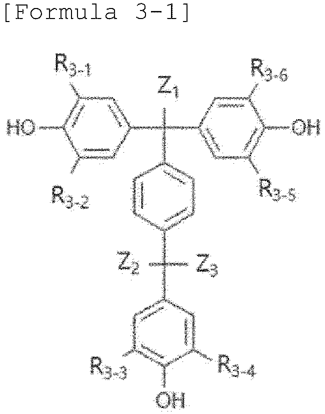

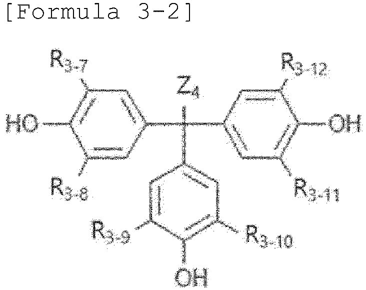

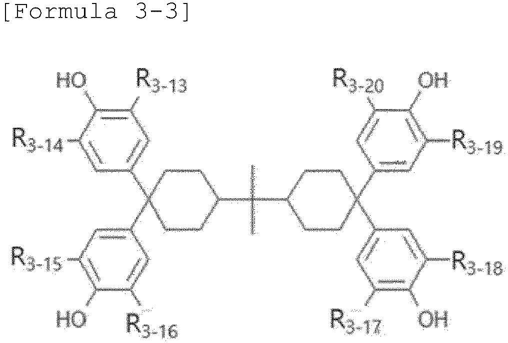

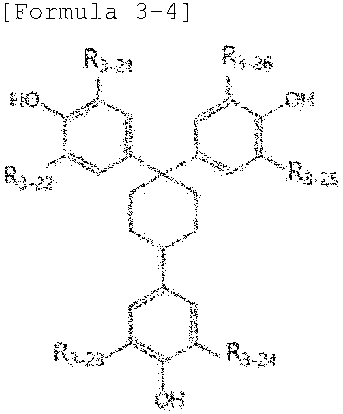

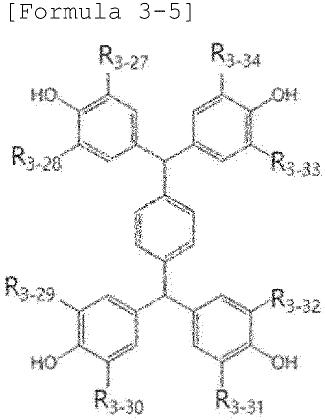

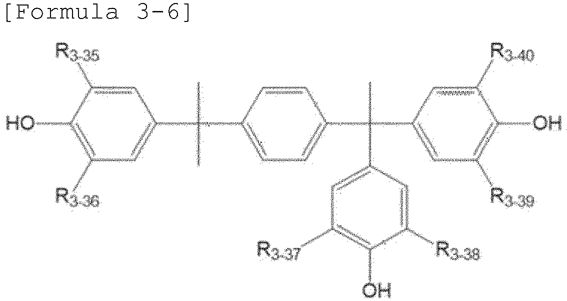

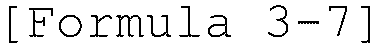

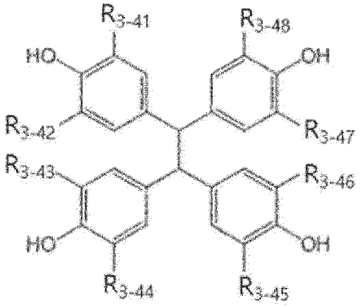

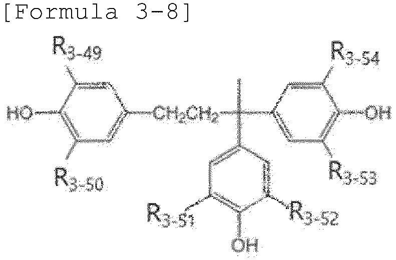

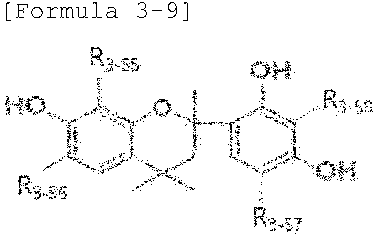

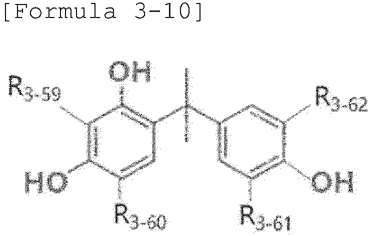

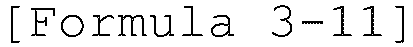

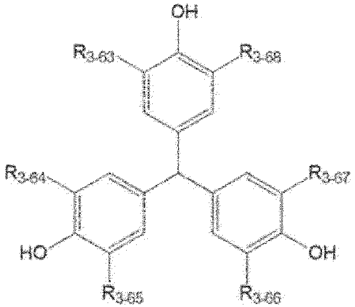

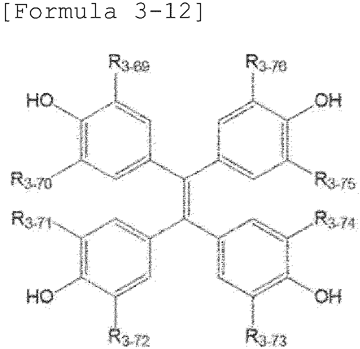

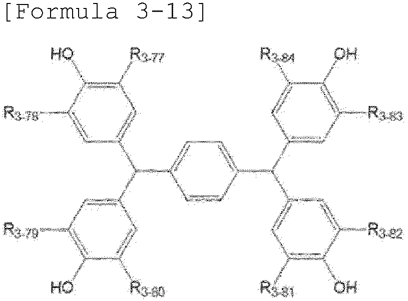

In the above Formulas, R₃₋₁ to R₃₋₈₄ are each independently hydrogen, an alkyl group having 1 to 4 carbon atoms, or an alkenyl group having 2 to 4 carbon atoms, and Z₁ to Z₄ are each independently hydrogen or an alkyl group having 1 to 4 carbon atoms.

Specifically, the quinone diazide compound may include a naphthoquinone diazide compound. That is, the esterified quinone diazide compound may include a reaction product of a naphthoquinone diazide compound and one of the phenol compounds represented by Formulas 3-1 to 3-13.

According to one embodiment of the present disclosure, the esterified quinone diazide compound may include a compound represented by Formula 3-A below.

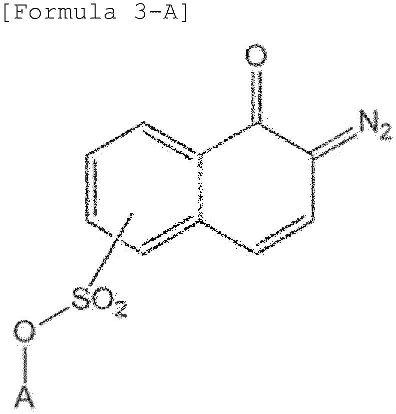

In Formula 3-A above, "A" corresponds to the structure (moiety) of the phenol compound, and the oxygen of the "A-O" bond corresponds to the oxygen of the phenolic hydroxyl group of the phenol compound. The positive photosensitive resin composition containing the esterified quinone diazide compound may easily realize an organic film having excellent sensitivity, film retention rate, adhesion, chemical resistance, heat resistance, solar resistance, hygroscopicity, operation reliability, and bending characteristics.

According to one embodiment of the present disclosure, the phenol compound may include at least one of Compounds 3-1 to 3-13 below.

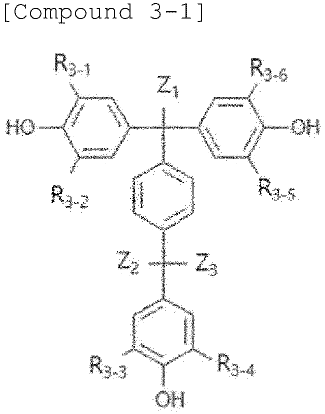

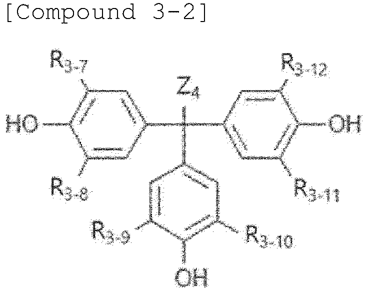

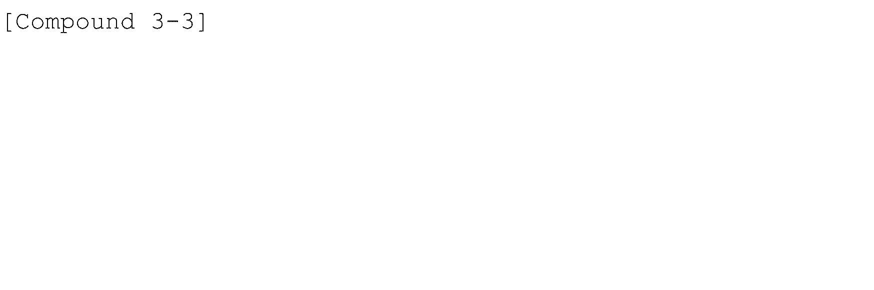

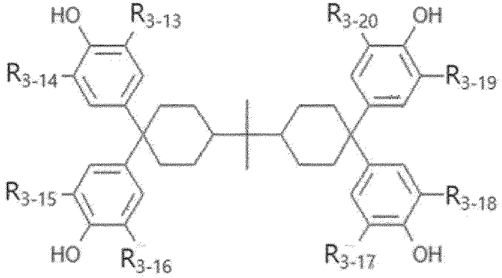

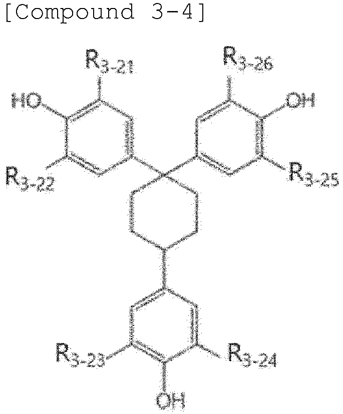

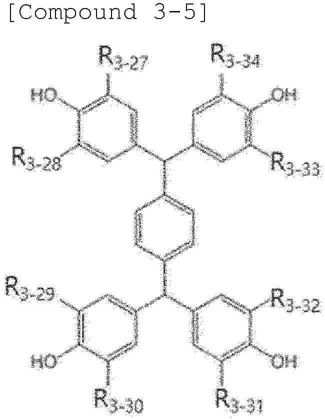

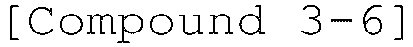

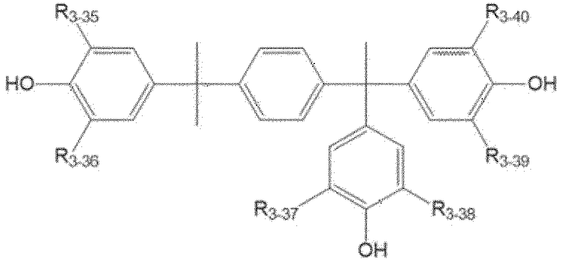

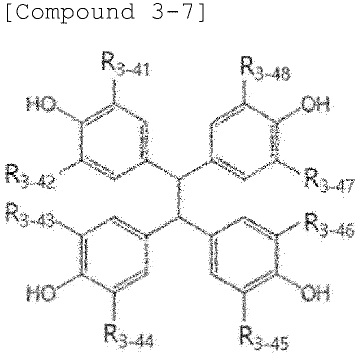

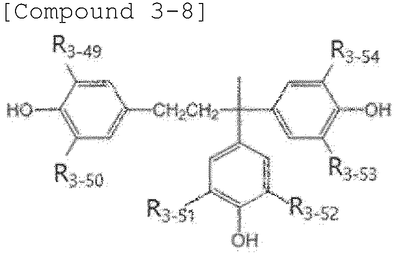

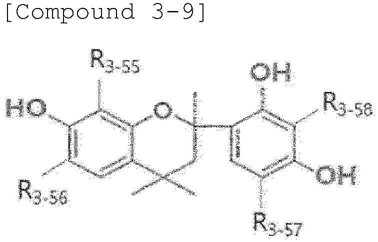

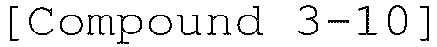

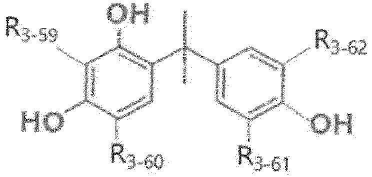

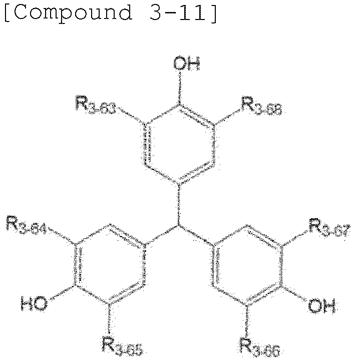

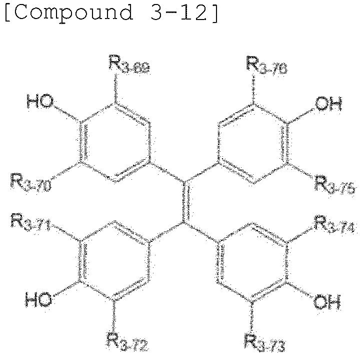

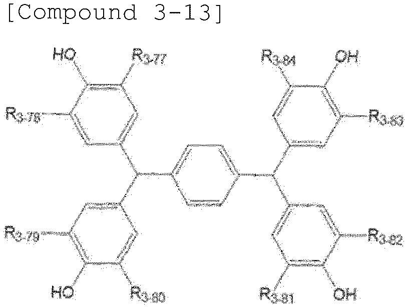

According to one embodiment of the present disclosure, the esterified quinone diazide compound may contain 2 or more moles of the quinone diazide compound based on 1 mole of the phenol compound. Specifically, based on 1 mole of the phenol compound, the content of the quinone diazide compound attached to the phenolic hydroxyl group of the phenol compound may be 2.0 mol or more and 3.5 mol or less, 2.5 mol or more and 3.5 mol or less, 3.2 mol or more and 3.5 mol or less, 2.0 mol or more and 3.0 mol or less, 2.2 mol or more and 2.8 mol or less, 2.4 mol or more and 2.6 mol or less, 2.5 mol or more and 3.5 mol or less, 2.8 mol or more and 3.3 mol or less, or 3.0 mol or more and 3.2 mol or less. By using the esterified quinone diazide compound having the above-described content of the quinone diazide compound, an organic film having excellent chemical resistance and heat resistance may be effectively formed from the positive photosensitive resin composition.

The quinone diazide compound may react with the phenolic hydroxyl group of the phenol compound. For example, the phenol compound represented by Formula 3-7 contains 4 phenolic hydroxyl groups, and thus 1 mol of the phenol compound contains 4 mol of reaction sites. When the quinone diazide compound is reacted with the phenol compound represented by Formula 3-7, the esterified quinone diazide compound may include an unreacted phenol compound containing four phenolic hydroxyl groups, a reaction product containing three phenolic hydroxyl groups and one attached quinone diazide compound, a reaction product containing two phenolic hydroxyl groups and two attached quinone diazide compounds, a reaction product containing one phenolic hydroxyl group and three attached quinone diazide compounds, and a reaction product containing four attached quinone diazide compounds. The content of the quinone diazide compound attached to the above-described esterified quinone diazide compound may be based on 1 mol of the phenol compound for the entire reaction product. That is, the content of the quinone diazide compound attached to the esterified quinone diazide compound may correspond to the content of the quinone diazide compound added to carry out the reaction for 1 mol of the phenol compound.

According to one embodiment of the present disclosure, the content of the esterified quinone diazide compound may be 10 parts by weight or more and 40 parts by weight or less based on 100 parts by weight of the alkali-soluble polymer resin. Specifically, the content of the esterified quinone diazide compound may be, based on 100 parts by weight of the alkali-soluble polymer resin, 15 parts by weight or more and 35 parts by weight or less, 20 parts by weight or more and 30 parts by weight or less, 10 parts by weight or more and 30 parts by weight or less, 12.5 parts by weight or more and 27.5 parts by weight or less, 17.5 parts by weight or more and 27.5 parts by weight or less, 22.5 parts by weight or more and 25 parts by weight or less, 20 parts by weight or more and 40 parts by weight or less, 20 parts by weight or more and 37.5 parts by weight or less, 20 parts by weight or more and 32.5 parts by weight or less, 20 parts by weight or more and 27.5 parts by weight or less, or 20 parts by weight or more and 25 parts by weight or less. When the content of the esterified quinone diazide compound is within the above-described range, the positive photosensitive resin composition may effectively provide an organic film having improved chemical resistance and heat resistance.

According to one embodiment of the present disclosure, the crosslinking agent may include at least one of compounds represented by Formulas 4-1 to 4-21 below:

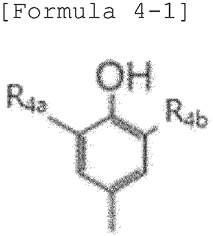

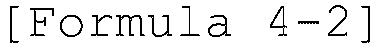

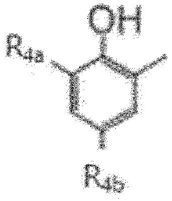

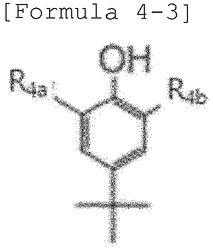

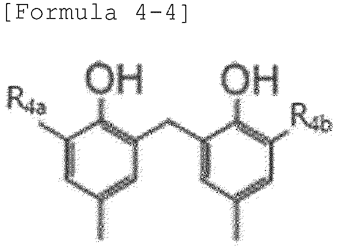

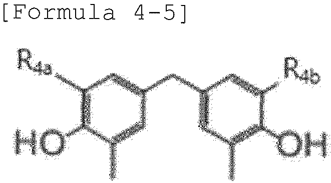

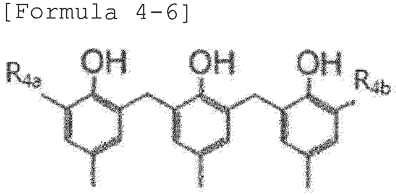

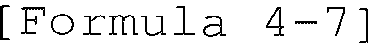

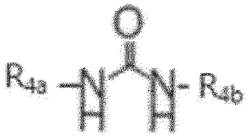

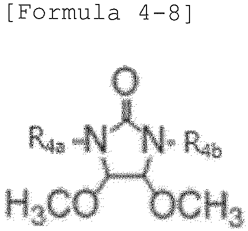

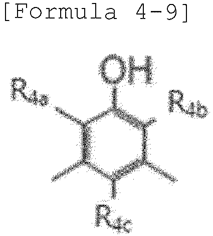

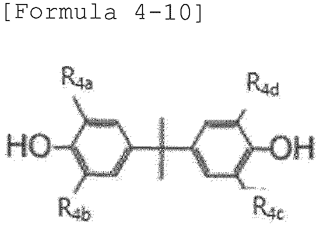

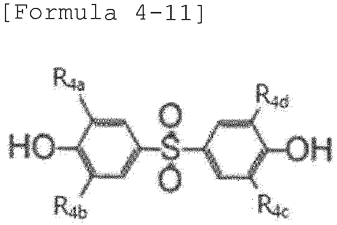

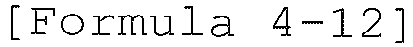

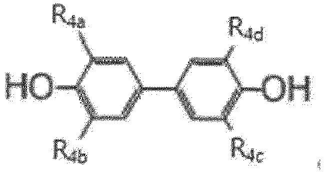

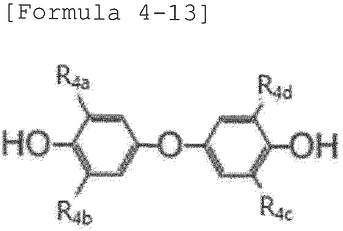

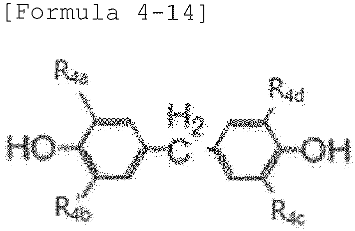

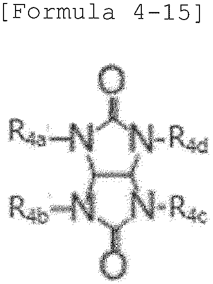

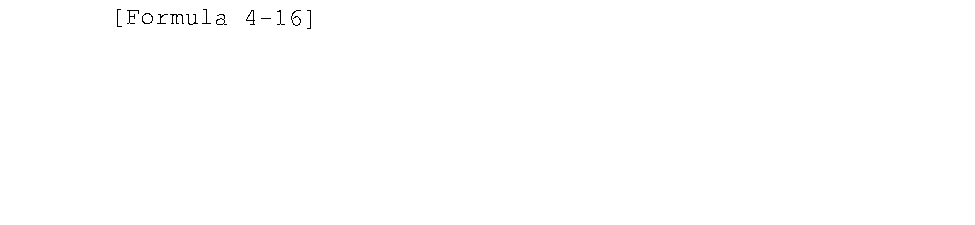

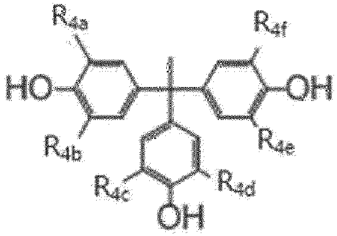

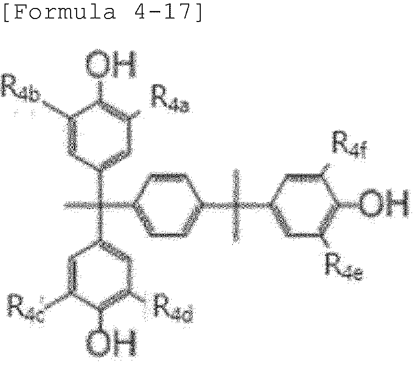

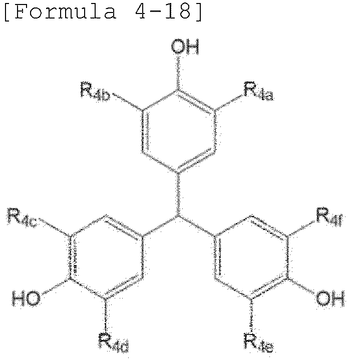

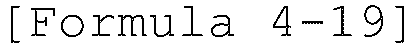

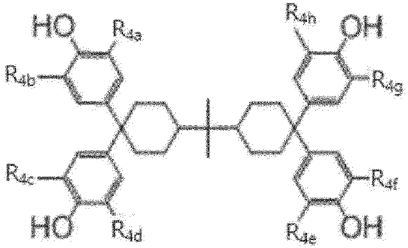

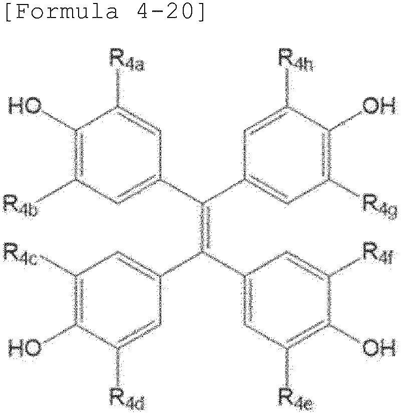

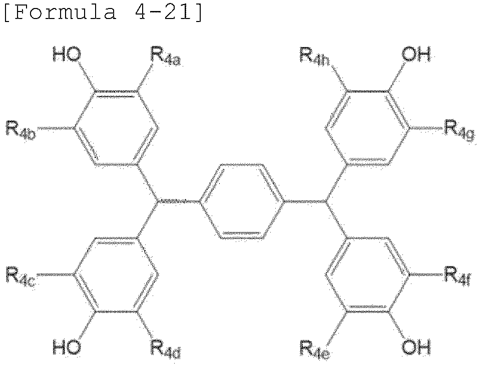

In the above Formulas, R₄ₐ to R₄ₕ are each independently hydrogen, an alkyl group having 1 to 3 carbon atoms, or *-(CH₂)ₘ-O-R₄₋₁, at least one of R₄ₐ and R_{4b} in Formulas 4-1 to 4-8 above is *-(CH₂)ₘ-O-R₄₋₁, at least one of R₄ₐ to R_{4c} in Formula 4-9 above is *-(CH₂)ₘ-O-R₄₋₁, at least one of R₄ₐ to R_{4d} in Formulas 4-10 to 4-15 above is *-(CH₂)ₘ-O-R₄₋₁, at least one of R₄ₐ to R_{4f} in Formulas 4-16 to 4-18 above is *-(CH₂)ₘ-O-R₄₋₁, at least one of R₄ₐ to R₄ₕ in Formulas 4-19 to 4-21 above is *-(CH₂)ₘ-O-R₄₋₁, m is an integer ranging from 1 to 6, and R₄₋₁ is an alkyl group having 1 to 3 carbon atoms.

Specifically, in the above Formulas, R₄ₐ to R₄ₕ may be *-(CH₂)ₘ-O-R₄₋₁. m may be 1 to 4, 1 to 2, or 1. R₄₋₁ may be a methyl group. More specifically, R₄ₐ to R₄ₕ may be - CH₂-O-CH₃. By using the above-described type of crosslinking agent, the positive photosensitive resin composition may stably form an organic film.

According to one embodiment of the present disclosure, the content of the crosslinking agent may be, based on 100 parts by weight of the alkali-soluble polymer resin, 5 parts by weight or more and 30 parts by weight or less, 8 parts by weight or more and 28 parts by weight or less, 8 parts by weight or more and 25 parts by weight or less, 8 parts by weight or more and 20 parts by weight or less, 10 parts by weight or more and 25 parts by weight or less, 15 parts by weight or more and 20 parts by weight or less, 5 parts by weight or more and 20 parts by weight or less, 8 parts by weight or more and 17 parts by weight or less, 12 parts by weight or more and 14 parts by weight or less, 10 parts by weight or more and 30 parts by weight or less, 12 parts by weight or more and 25 parts by weight or less, 14 parts by weight or more and 23 parts by weight or less, or 15 parts by weight or more and 20 parts by weight or less. When the content of the crosslinking agent is within the above-described range, the positive photosensitive resin composition may effectively form an organic film having excellent chemical resistance, heat resistance, solar resistance, hygroscopicity, operation reliability, and bending characteristics.

According to one embodiment of the present disclosure, the positive photosensitive resin composition may further contain at least one of an organic solvent, a surfactant, and an additive. The organic solvent may include at least one of gamma-butyrolactone (GBL), N-methylpyrrolidone (NMP), propylene glycol methyl ether acetate (PGMEA), ethyl lactate (EL), methyl-3-methoxypropionate (MMP), propylene glycol monomethyl ether (PGME), diethyl glycol ethyl methyl ether (MEDG), diethyl glycol butyl methyl ether (MBDG), diethylene glycol dimethyl ester (DMDG), and diethylene glycol diethyl ester (DEDG). As the surfactant and additive, those used in the art may be used without limitation. For example, the additive may include a thermal acid generator, a UV absorber, etc.

One embodiment of the present disclosure provides a method for manufacturing an insulating film, including: a step of applying a positive photosensitive resin precursor composition onto a substrate, followed by drying; an exposure step; a step of developing using an alkaline developer; and a heating step.

According to the manufacturing method according to one embodiment of the present disclosure, an insulating film having excellent sensitivity, film retention rate, adhesion, chemical resistance, heat resistance, solar resistance, hygroscopicity, operation reliability and bending characteristics may be easily manufactured using the positive photosensitive resin composition.

One embodiment of the present disclosure provides an electronic component including an insulating film including a cured product of the positive photosensitive resin composition.

The electronic component according to one embodiment of the present disclosure may have excellent sensitivity, film retention rate, adhesion, chemical resistance, heat resistance, solar resistance, hygroscopicity, operation reliability, and bending characteristics.

According to one embodiment of the present disclosure, the insulating film may be used for insulating films such as interlayer insulating films, protective insulating films, and gate insulating films, as well as for planarization films. In addition, an electronic component including the insulating film may be an electronic component for OLEDs, an electronic component for semiconductors, an electronic component for displays, or the like.

One embodiment of the present disclosure provides a display device including an insulating film including a cured product of the positive photosensitive resin composition.

The display device for an organic electroluminescent device according to one embodiment of the present disclosure may have excellent sensitivity, film retention rate, adhesion, chemical resistance, heat resistance, solar resistance, hygroscopicity, operation reliability, and bending characteristics.

According to one embodiment of the present disclosure, the display device may include: a first electrode provided on a substrate; an insulating film provided on the first electrode so as to partially expose the first electrode; and a second electrode provided opposite to the first electrode. In this case, the insulating film may be provided to cover an edge portion of the first electrode.

According to one embodiment of the present disclosure, the cross-section of the insulating film at the boundary portion where the insulating film exposes the first electrode may have a forward tapered shape.

According to one embodiment of the present disclosure, the display device may include a display device for an organic electroluminescent device including: a first electrode formed on a substrate; a thin film layer including a light-emitting layer formed on the first electrode and comprising at least an organic compound; and a second electrode formed on the thin film layer.

According to one embodiment of the present disclosure, the display device may include, without limitation, any components used for display devices in the art, except that it includes the organic film. The display device may be a liquid crystal display (LCD), an organic light-emitting display (OLED), a plasma display panel (PDP), or an electrophoretic display.

### Mode for Invention

Hereinafter, the present disclosure will be described in detail through examples. However, the examples according to the present disclosure may be modified in various different forms, and the scope of the present disclosure is not to be construed as being limited to the examples described below. The examples of the present specification are provided to more completely explain the present disclosure to those skilled in the art.

### Materials

### Amine-Based Compounds for Producing Alkali-Soluble Polymer Resins

Table 1 below shows amine-based compounds (diamine compounds) for producing alkali-soluble polymer resins and the charge transfer complex (CTC) values thereof.

The CTC values of the amine-based compounds may be calculated through quantum chemical calculation (Gaussian 16, Density Functional Theory_M06-2X/6-311G) simulation.

**[Table 1]**

| Code | Structure | CTC | |
|---|---|---|---|
| | | Based on (parts by weight) | CTC value (eV) |
| A-1 (Compound 1-2) | 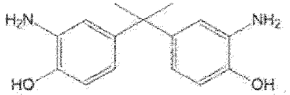 | 100 | 4.56 |
| A-2 (Compound 1-3) | 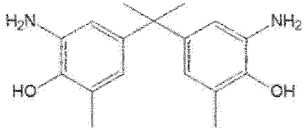 | 100 | 5.50 |
| A-3 (Compound 1-4) | 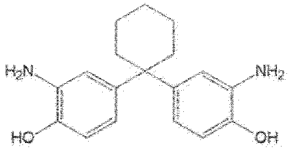 | 100 | 6.50 |
| A-4 (Compound 1-5) | 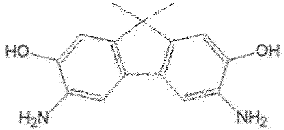 | 100 | 6.00 |
| A-5 (Compound 1-6) | 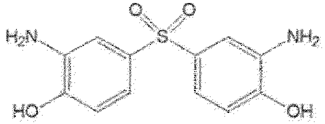 | 100 | 4.80 |
| A-6 (Compound 1-7) | 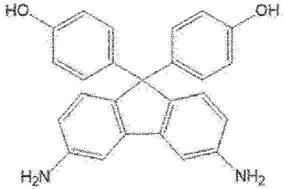 | 100 | 6.70 |
| A-7 (Compound 1-8) | 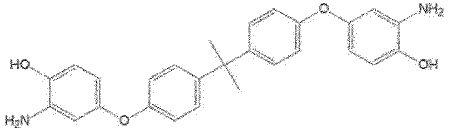 | 100 | 4.93 |
| A-8 (Compound 1-32) | 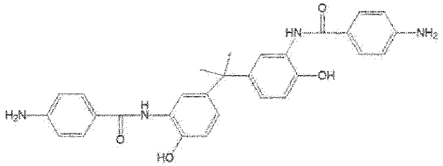 | 100 | 5.29 |
| A-9 (Compound 1-13) | 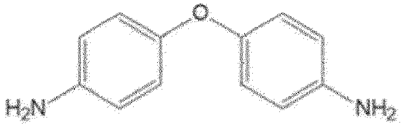 | 100 | 4.55 |
| A-10 (Compound 1-14) | 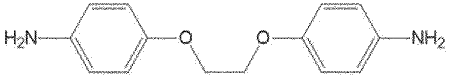 | 100 | 4.60 |
| A-11 (Compound 1-15) | 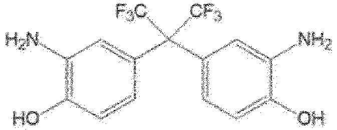 | 100 | 5.49 |
| A-12 (Compound 1-28) | 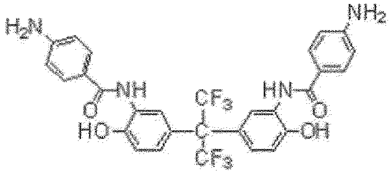 | 100 | 6.85 |
| A-13 (Compound 1-30) | 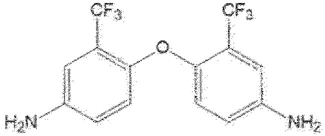 | 100 | 7.00 |
| A-14 (Compound 1-31) | 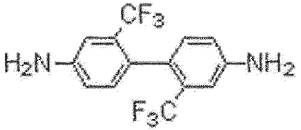 | 100 | 6.80 |

### Acid Anhydride Compounds for Producing Alkali-Soluble Polymer Resins

Table 2 below shows acid anhydride compounds for producing alkali-soluble polymer resins and the charge transfer complex (CTC) values thereof.

The CTC values of the acid anhydride compounds may be calculated through quantum calculation (Gaussian 16, Density Functional Theory_M06-2X/6-311G) simulation. Here, the CTC values of the acid anhydride compounds in Table 2 below are those calculated based on 100 parts by weight of each acid anhydride compound for 100 parts by weight of the amine-based compound.

**[Table 2]**

| Code | Structure | CTC | |
|---|---|---|---|
| | | Based on (parts by weight) | CTC value (eV) |
| B-1 (Compound 2-1) | 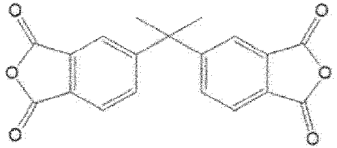 | 100 | 4.57 |
| B-2 (Compound 2-2) | 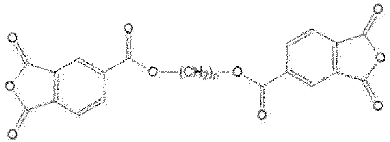 (n is an integer of 2) | 100 | 5.95 |
| B-3 (Compound 2-3) | 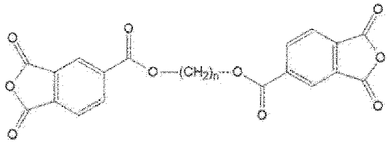 (n is an integer of 4) | 100 | 6.00 |
| B-4 (Compound 2-4) | 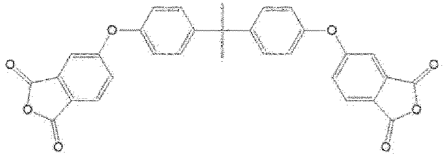 | 100 | 5.92 |
| B-5 (Compound 2-5) | 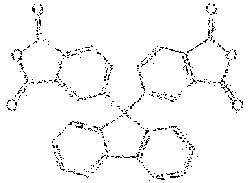 | 100 | 6.71 |
| B-6 (Compound 2-6) | 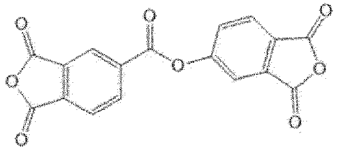 | 100 | 4.57 |
| B-7 (Compound 2-7) | 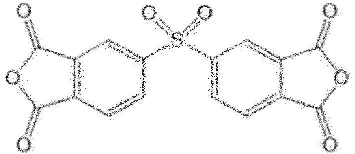 | 100 | 4.80 |
| B-8 (Compound 2-8) | 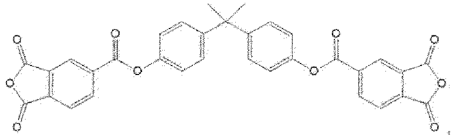 | 100 | 5.93 |
| B-9 (Compound 2-15) | 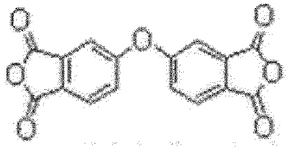 | 100 | 4.56 |
| B-10 (Compound 2-16) | 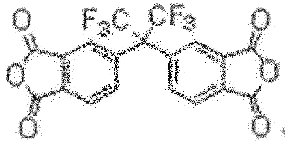 | 100 | 5.50 |

### Capping Compounds for Producing Alkali-Soluble Polymer Resins

Table 3 below shows capping compounds for producing alkali-soluble polymer resins and the charge transfer complex (CTC) values thereof.

The CTC values of the capping compounds may be calculated through quantum calculation (Gaussian 16, Density Functional Theory_M06-2X/6-311G) simulation. Here, the CTC values of the capping compounds in Table 3 below are those calculated based on 100 parts by weight of each capping compound for 100 parts by weight of the amine-based compound.

**[Table 3]**

| Code | Structure | CTC | |
|---|---|---|---|
| | | Based on (parts by weight) | CTC value (eV) |
| C-1 (Compound C-1) | 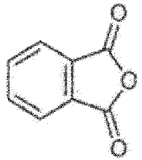 | 100 | 4.56 |
| C-2 (Compound C-2) | 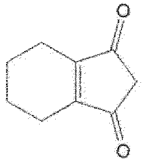 | 100 | 4.65 |
| C-3 (Compound C-3) | 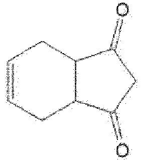 | 100 | 4.60 |
| C-4 (Compound C-4) | 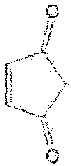 | 100 | 4.60 |
| C-5 (Compound C-5) | 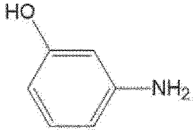 | 100 | 4.56 |

### Production of Alkali-Soluble Polymer Resins

### Combinations of Amine-Based Compounds (Diamine Compounds)

Combinations of diamine compounds were prepared as follows.

**[Table 4]**

| | First diamine | | | Second diamine | | | Total values for diamines | |
|---|---|---|---|---|---|---|---|---|
| Synthesis Example | Code | Content (parts by weight)/ CTC (eV) | | Code | Content (parts by weight)/ CTC (eV) | | Content (parts by weight)/ CTC (eV) | |
| 1 | A-1 | Content | 30 | A-11 | Content | 70 | Content | 100.00 |
| | | CTC | 1.368 | | CTC | 3.84 | CTC | 5.21 |
| 2 | A-2 | Content | 30 | A-12 | Content | 70 | Content | 100.00 |
| | | CTC | 1.65 | | CTC | 4.80 | CTC | 6.45 |
| 3 | A-4 | Content | 30 | A-12 | Content | 70 | Content | 100.00 |
| | | CTC | 1.8 | | CTC | 4.80 | CTC | 6.60 |
| 4 | A-5 | Content | 30 | A-11 | Content | 70 | Content | 100.00 |
| | | CTC | 1.44 | | CTC | 3.84 | CTC | 5.28 |
| 5 | A-6 | Content | 30 | A-12 | Content | 70 | Content | 100.00 |
| | | CTC | 2.01 | | CTC | 4.80 | CTC | 6.81 |
| 6 | A-7 | Content | 30 | A-11 | Content | 70.00 | Content | 100.00 |
| | | CTC | 1.479 | | CTC | 3.84 | CTC | 5.32 |
| 7 | A-9 | Content | 30.00 | A-11 | Content | 70.00 | Content | 100.00 |
| | | CTC | 1.37 | | CTC | 3.84 | CTC | 5.21 |
| 8 | A-1 | Content | 40 | A-11 | Content | 60.00 | Content | 100.00 |
| | | CTC | 1.824 | | CTC | 3.29 | CTC | 5.12 |
| 9 | A-3 | Content | 40 | A-11 | Content | 60.00 | Content | 100.00 |
| | | CTC | 2.6 | | CTC | 3.29 | CTC | 5.89 |
| 10 | A-4 | Content | 40 | A-12 | Content | 60.00 | Content | 100.00 |
| | | CTC | 2.4 | | CTC | 4.11 | CTC | 6.51 |
| 11 | A-5 | Content | 40 | A-11 | Content | 60.00 | Content | 100.00 |
| | | CTC | 1.92 | | CTC | 3.29 | CTC | 5.21 |
| 12 | A-6 | Content | 40 | A-12 | Content | 60.00 | Content | 100.00 |
| | | CTC | 2.68 | | CTC | 4.11 | CTC | 6.79 |
| 13 | A-7 | Content | 40 | A-11 | Content | 60.00 | Content | 100.00 |
| | | CTC | 1.972 | | CTC | 3.29 | CTC | 5.27 |
| 14 | A-9 | Content | 40.00 | A-11 | Content | 60.00 | Content | 100.00 |
| | | CTC | 1.82 | | CTC | 3.29 | CTC | 5.11 |
| 15 | A-1 | Content | 50 | A-11 | Content | 50.00 | Content | 100.00 |
| | | CTC | 2.28 | | CTC | 2.75 | CTC | 5.03 |
| 16 | A-3 | Content | 50 | A-11 | Content | 50.00 | Content | 100.00 |
| | | CTC | 3.25 | | CTC | 2.75 | CTC | 6.00 |
| 17 | A-4 | Content | 50 | A-12 | Content | 50.00 | Content | 100.00 |
| | | CTC | 3 | | CTC | 3.43 | CTC | 6.43 |
| 18 | A-5 | Content | 50 | A-11 | Content | 50.00 | Content | 100.00 |
| | | CTC | 2.4 | | CTC | 2.75 | CTC | 5.15 |
| 19 | A-6 | Content | 50 | A-12 | Content | 50.00 | Content | 100.00 |
| | | CTC | 3.35 | | CTC | 3.43 | CTC | 6.78 |
| 20 | A-7 | Content | 50 | A-11 | Content | 50.00 | Content | 100.00 |
| | | CTC | 2.465 | | CTC | 2.75 | CTC | 5.21 |
| 21 | A-8 | Content | 50 | A-12 | Content | 50.00 | Content | 100.00 |
| | | CTC | 2.645 | | CTC | 3.43 | CTC | 6.07 |
| 22 | A-9 | Content | 50.00 | A-11 | Content | 50.00 | Content | 100.00 |
| | | CTC | 2.28 | | CTC | 2.75 | CTC | 5.02 |

**[Table 5]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 23 | A-1 | Cont. | 50 | A-9 | Cont. | 10 | A-11 | Cont. | 40 | Cont. | 100 |
| | | CTC | 2.28 | | CTC | 0.46 | | CTC | 2.20 | CTC | 4.93 |
| 24 | A-2 | Cont. | 50 | A-9 | Cont. | 10 | A-12 | Cont. | 40 | Cont. | 100 |
| | | CTC | 2.75 | | CTC | 0.46 | | CTC | 2.74 | CTC | 5.95 |
| 25 | A-3 | Cont. | 50 | A-9 | Cont. | 10 | A-11 | Cont. | 40 | Cont. | 100 |
| | | CTC | 3.25 | | CTC | 0.46 | | CTC | 2.20 | CTC | 5.90 |
| 26 | A-4 | Cont. | 50 | A-9 | Cont. | 10 | A-12 | Cont. | 40 | Cont. | 100 |
| | | CTC | 3 | | CTC | 0.46 | | CTC | 2.74 | CTC | 6.20 |
| 27 | A-5 | Cont. | 40 | A-9 | Cont. | 20 | A-11 | Cont. | 40 | Cont. | 100 |
| | | CTC | 1.92 | | CTC | 0.91 | | CTC | 2.20 | CTC | 5.03 |
| 28 | A-6 | Cont. | 40 | A-9 | Cont. | 20 | A-12 | Cont. | 40 | Cont. | 100 |
| | | CTC | 2.68 | | CTC | 0.91 | | CTC | 2.74 | CTC | 6.33 |
| 29 | A-7 | Cont. | 40 | A-9 | Cont. | 20 | A-11 | Cont. | 40 | Cont. | 100 |
| | | CTC | 1.972 | | CTC | 0.91 | | CTC | 2.20 | CTC | 5.08 |
| 31 | A-2 | Cont. | 35 | A-9 | Cont. | 30 | A-12 | Cont. | 35 | Cont. | 100 |
| | | CTC | 1.925 | | CTC | 1.37 | | CTC | 2.40 | CTC | 5.69 |
| 32 | A-3 | Cont. | 45 | A-9 | Cont. | 30 | A-11 | Cont. | 25 | Cont. | 100 |
| | | CTC | 2.925 | | CTC | 1.37 | | CTC | 1.37 | CTC | 5.66 |
| 33 | A-4 | Cont. | 45 | A-9 | Cont. | 30 | A-12 | Cont. | 25 | Cont. | 100 |
| | | CTC | 2.7 | | CTC | 1.37 | | CTC | 1.71 | CTC | 5.78 |
| 34 | A-5 | Cont. | 55 | A-9 | Cont. | 30 | A-11 | Cont. | 15 | Cont. | 100 |
| | | CTC | 2.64 | | CTC | 1.37 | | CTC | 0.82 | CTC | 4.83 |
| 35 | A-7 | Cont. | 55 | A-9 | Cont. | 30 | A-11 | Cont. | 15 | Cont. | 100 |
| | | CTC | 2.71 | | CTC | 1.37 | | CTC | 0.82 | CTC | 4.9 |
| 36 | A-8 | Cont. | 55 | A-9 | Cont. | 30 | A-12 | Cont. | 15 | Cont. | 100 |
| | | CTC | 2.90 | | CTC | 1.37 | | CTC | 1.03 | CTC | 5.3 |
| 37 | A-1 | Cont. | 30 | A-2 | Cont. | 60 | A-9 | Cont. | 10 | Cont. | 100 |
| | | CTC | 1.36 | | CTC | 3.3 | | CTC | 0.46 | CTC | 5.12 |
| 38 | A-3 | Cont. | 40 | A-4 | Cont. | 40 | A-9 | Cont. | 20 | Cont. | 100 |
| | | CTC | 2.6 | | CTC | 2.4 | | CTC | 0.91 | CTC | 5.91 |
| 39 | A-5 | Cont. | 30 | A-6 | Cont. | 40 | A-9 | Cont. | 30 | Cont. | 100 |
| | | CTC | 1.44 | | CTC | 2.68 | | CTC | 1.37 | CTC | 5.49 |

**[Table 6]**

| | First diamine | | | Second diamine | | | Total values for diamines | |
|---|---|---|---|---|---|---|---|---|
| Synthesis Example | Code | Content (parts by weight)/ CTC (eV) | | Code | Content (parts by weight)/ CTC (eV) | | Content (parts by weight)/ CTC (eV) | |
| 40 | A-1 | Content | 50 | A-3 | Content | 50 | Content | 100.00 |
| | | CTC | 2.28 | | CTC | 3.25 | CTC | 5.53 |
| 41 | A-2 | Content | 50 | A-4 | Content | 50 | Content | 100.00 |
| | | CTC | 2.75 | | CTC | 3 | CTC | 5.75 |
| 42 | A-3 | Content | 50 | A-5 | Content | 50 | Content | 100.00 |
| | | CTC | 3.25 | | CTC | 2.4 | CTC | 5.65 |
| 43 | A-5 | Content | 50 | A-7 | Content | 50 | Content | 100.00 |
| | | CTC | 2.4 | | CTC | 2.465 | CTC | 4.87 |
| 44 | A-6 | Content | 50 | A-8 | Content | 50 | Content | 100.00 |
| | | CTC | 3.35 | | CTC | 2.65 | CTC | 6.00 |

**[Table 7]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 45 | A-1 | Cont. | 80 | A-9 | Cont. | 10 | A-11 | Cont. | 10 | Cont. | 100 |
| | | CTC | 3.648 | | CTC | 0.46 | | CTC | 0.55 | CTC | 4.65 |
| 46 | A-2 | Cont. | 80 | A-9 | Cont. | 10 | A-12 | Cont. | 10 | Cont. | 100 |
| | | CTC | 4.4 | | CTC | 0.46 | | CTC | 0.69 | CTC | 5.54 |
| 47 | A-3 | Cont. | 80 | A-9 | Cont. | 10 | A-11 | Cont. | 10 | Cont. | 100 |
| | | CTC | 5.2 | | CTC | 0.46 | | CTC | 0.55 | CTC | 6.20 |
| 48 | A-4 | Cont. | 80 | A-9 | Cont. | 10 | A-12 | Cont. | 10 | Cont. | 100 |
| | | CTC | 4.8 | | CTC | 0.46 | | CTC | 0.69 | CTC | 5.94 |
| 49 | A-5 | Cont. | 80 | A-9 | Cont. | 10 | A-11 | Cont. | 10 | Cont. | 100 |
| | | CTC | 3.84 | | CTC | 0.46 | | CTC | 0.55 | CTC | 4.84 |
| 50 | A-8 | Cont. | 80 | A-9 | Cont. | 10 | A-12 | Cont. | 10 | Cont. | 100 |
| | | CTC | 4.232 | | CTC | 0.46 | | CTC | 0.69 | CTC | 5.37 |
| 51 | A-1 | Cont. | 40 | A-2 | Cont. | 40 | A-9 | Cont. | 20 | Cont. | 100 |
| | | CTC | 1.824 | | CTC | 2.2 | | CTC | 0.91 | CTC | 4.93 |

**[Table 8]**

| | First diamine | | | Second diamine | | | Total values for diamines | |
|---|---|---|---|---|---|---|---|---|
| Synthesis Example | Code | Content (parts by weight)/ CTC (eV) | | Code | Content (parts by weight)/ CTC (eV) | | Content (parts by weight)/ CTC (eV) | |
| 52 | A-2 | Content | 80 | A-9 | Content | 20.00 | Content | 100.00 |
| | | CTC | 4.4 | | CTC | 0.91 | CTC | 5.31 |
| 53 | A-3 | Content | 80 | A-9 | Content | 20.00 | Content | 100.00 |
| | | CTC | 5.2 | | CTC | 0.91 | CTC | 6.11 |
| 54 | A-4 | Content | 80 | A-9 | Content | 20.00 | Content | 100.00 |
| | | CTC | 4.8 | | CTC | 0.91 | CTC | 5.71 |
| 55 | A-5 | Content | 80 | A-9 | Content | 20.00 | Content | 100.00 |
| | | CTC | 3.84 | | CTC | 0.91 | CTC | 4.75 |
| 56 | A-6 | Content | 80 | A-9 | Content | 20.00 | Content | 100.00 |
| | | CTC | 5.36 | | CTC | 0.91 | CTC | 6.27 |
| 57 | A-7 | Content | 80 | A-9 | Content | 20.00 | Content | 100.00 |
| | | CTC | 3.944 | | CTC | 0.91 | CTC | 4.85 |
| 58 | A-1 | Content | 30 | A-11 | Content | 70.00 | Content | 100.00 |
| | | CTC | 1.368 | | CTC | 3.84 | CTC | 5.21 |
| 59 | A-3 | Content | 30 | A-11 | Content | 70.00 | Content | 100.00 |
| | | CTC | 1.95 | | CTC | 3.84 | CTC | 5.79 |
| 60 | A-6 | Content | 30 | A-12 | Content | 70.00 | Content | 100.00 |
| | | CTC | 2.01 | | CTC | 4.80 | CTC | 6.81 |
| 61 | A-7 | Content | 30 | A-11 | Content | 70.00 | Content | 100.00 |
| | | CTC | 1.479 | | CTC | 3.84 | CTC | 5.32 |
| 62 | A-1 | Content | 40 | A-11 | Content | 60.00 | Content | 100.00 |
| | | CTC | 1.824 | | CTC | 3.29 | CTC | 5.12 |
| 63 | A-3 | Content | 40 | A-11 | Content | 60.00 | Content | 100.00 |
| | | CTC | 2.6 | | CTC | 3.29 | CTC | 5.89 |
| 64 | A-5 | Content | 40 | A-11 | Content | 60.00 | Content | 100.00 |
| | | CTC | 1.92 | | CTC | 3.29 | CTC | 5.21 |
| 65 | A-6 | Content | 40 | A-12 | Content | 60.00 | Content | 100.00 |
| | | CTC | 2.68 | | CTC | 4.11 | CTC | 6.79 |
| 66 | A-7 | Content | 40 | A-11 | Content | 60.00 | Content | 100.00 |
| | | CTC | 1.972 | | CTC | 3.29 | CTC | 5.27 |
| 67 | A-9 | Content | 40.00 | A-11 | Content | 60.00 | Content | 100.00 |
| | | CTC | 1.82 | | CTC | 3.29 | CTC | 5.11 |
| 68 | A-1 | Content | 50 | A-11 | Content | 50.00 | Content | 100.00 |
| | | CTC | 2.28 | | CTC | 2.75 | CTC | 5.03 |

**[Table 9]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 69 | A-8 | Cont. | 80 | A-10 | Cont. | 10 | A-12 | Cont. | 10 | Cont. | 100 |
| | | CTC | 4.232 | | CTC | 0.46 | | CTC | 0.69 | CTC | 5.38 |
| 70 | A-1 | Cont. | 40 | A-2 | Cont. | 40 | A-10 | Cont. | 20 | Cont. | 100 |
| | | CTC | 1.824 | | CTC | 2.2 | | CTC | 0.92 | CTC | 4.94 |
| 71 | A-2 | Cont. | 80 | A-10 | Cont. | 20 | - | | | Cont. | 100 |
| | | CTC | 4.4 | | CTC | 0.92 | | | | CTC | 5.32 |
| 72 | A-3 | Cont. | 80 | A-10 | Cont. | 20 | - | | | Cont. | 100 |
| | | CTC | 5.2 | | CTC | 0.92 | | | | CTC | 6.12 |
| 73 | A-4 | Cont. | 80 | A-10 | Cont. | 20 | - | | | Cont. | 100 |
| | | CTC | 4.8 | | CTC | 0.92 | | | | CTC | 5.72 |
| 74 | A-5 | Cont. | 80 | A-10 | Cont. | 20 | - | | | Cont. | 100 |
| | | CTC | 3.84 | | CTC | 0.92 | | | | CTC | 4.76 |
| 75 | A-7 | Cont. | 80 | A-10 | Cont. | 20 | - | | | Cont. | 100 |
| | | CTC | 3.944 | | CTC | 0.92 | | | | CTC | 4.86 |
| 76 | A-7 | Cont. | 40 | A-11 | Cont. | 60 | - | | | Cont. | 100 |
| | | CTC | 1.972 | | CTC | 3.29 | | | | CTC | 5.27 |
| 77 | A-11 | Cont. | 70 | A-13 | Cont. | 30 | | | | Cont. | 100 |
| | | CTC | 3.84 | | CTC | 2.10 | | | | CTC | 5.94 |

### Synthesis Examples 78 to 80

Synthesis Example 78: Combination of a first diamine (code: A-1; content: 30 parts by weight; CTC: 1.368 eV), a second diamine (code: A-9; content: 10 parts by weight; CTC: 0.46 eV), a third diamine (code: A-11; content: 30 parts by weight; CTC: 1.65 eV), and a fourth diamine (code: A-13; content: 30 parts by weight; CTC: 2.1 eV).

Total values for diamines (content: 100 parts by weight; CTC: 5.57 eV)

Synthesis Example 79: Combination of a first diamine (code: A-3; content: 10 parts by weight; CTC: 0.65 eV), a second diamine (code: A-9; content: 30 parts by weight; CTC: 1.37 eV), a third diamine (code: A-11; content: 30 parts by weight; CTC: 1.65 eV), and a fourth diamine (code: A-14; content: 30 parts by weight; CTC: 2.04 eV).

Total values for diamines (content: 100 parts by weight; CTC: 5.7 eV)

Synthesis Example 80: Combination of a first diamine (code: A-5; content: 10 parts by weight; CTC: 0.48 eV), a second diamine (code: A-9; content: 20 parts by weight; CTC: 0.91 eV), a third diamine (code: A-11; content: 35 parts by weight; CTC: 1.92 eV), and a fourth diamine (code: A-13; content: 35 parts by weight; CTC: 2.45 eV).

Total values for diamines (content: 100 parts by weight; CTC: 5.76 eV)

**[Table 10]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 81 | A-3 | Cont. | 20 | A-11 | Cont. | 40 | A-13 | Cont. | 40 | Cont. | 100 |
| | | CTC | 1.3 | | CTC | 2.20 | | CTC | 2.80 | CTC | 6.30 |
| 82 | A-9 | Cont. | 40.00 | A-11 | Cont. | 60.00 | | | | Cont. | 100 |
| | | CTC | 1.82 | | CTC | 3.29 | | | | CTC | 5.11 |
| 83 | A-1 | Cont. | 50 | A-11 | Cont. | 50.00 | | | | Cont. | 100 |
| | | CTC | 2.28 | | CTC | 2.75 | | | | CTC | 5.03 |
| 84 | A-3 | Cont. | 40 | A-11 | Cont. | 60.00 | | | | Cont. | 100 |
| | | CTC | 2.6 | | CTC | 3.29 | | | | CTC | 5.89 |
| 85 | A-4 | Cont. | 40 | A-12 | Cont. | 60.00 | | | | Cont. | 100 |
| | | CTC | 2.4 | | CTC | 4.11 | | | | CTC | 6.51 |
| 86 | A-5 | Cont. | 40 | A-11 | Cont. | 60.00 | | | | Cont. | 100 |
| | | CTC | 1.92 | | CTC | 3.29 | | | | CTC | 5.21 |
| 87 | A-6 | Cont. | 40 | A-12 | Cont. | 60.00 | | | | Cont. | 100 |
| | | CTC | 2.68 | | CTC | 4.11 | | | | CTC | 6.79 |
| 88 | A-5 | Cont. | 20 | A-11 | Cont. | 40.00 | A-14 | Cont. | 40 | Cont. | 100 |
| | | CTC | 0.96 | | CTC | 2.20 | | CTC | 2.72 | CTC | 5.88 |
| 89 | A-8 | Cont. | 40 | A-9 | Cont. | 20.00 | A-12 | Cont. | 40 | Cont. | 100 |
| | | CTC | 2.116 | | CTC | 0.91 | | CTC | 2.74 | CTC | 5.77 |
| 90 | A-7 | Cont. | 80 | A-9 | Cont. | 10.00 | A-11 | Cont. | 10 | Cont. | 100 |
| | | CTC | 3.944 | | CTC | 0.46 | | CTC | 0.55 | CTC | 4.95 |
| 91 | A-4 | Cont. | 30 | A-12 | Cont. | 70.00 | | | | Cont. | 100 |
| | | CTC | 1.8 | | CTC | 4.80 | | | | CTC | 6.60 |
| 92 | A-5 | Cont. | 30 | A-11 | Cont. | 70.00 | | | | Cont. | 100 |
| | | CTC | 1.44 | | CTC | 3.84 | | | | CTC | 5.28 |
| 93 | A-9 | Cont. | *30.00* | A-11 | Cont. | 70.00 | | | | Cont. | 100 |
| | | CTC | 1.37 | | CTC | 3.84 | | | | CTC | 5.21 |
| 94 | A-4 | Cont. | 40 | A-12 | Cont. | 60.00 | | | | Cont. | 100 |
| | | CTC | 2.4 | | CTC | 4.11 | | | | CTC | 6.51 |
| 95 | A-8 | Cont. | 40 | A-12 | Cont. | 60.00 | | | | Cont. | 100 |
| | | CTC | 2.116 | | *CTC* | 4.11 | | | | CTC | 6.23 |
| 96 | | Cont. | 80 | A-10 | Cont. | 10.00 | A-11 | Cont. | 10. | Cont. | 100 |
| | A-7 | CTC | 3.944 | | CTC | 0.46 | | CTC | 0.55 | CTC | 4.95 |
| 97 | A-6 | Cont. | 80 | A-10 | Cont. | 20.00 | | | | Cont. | 100 |
| | | CTC | 5.36 | | CTC | 0.92 | | | | CTC | 6.28 |
| 98 | A-11 | Cont. | 70.00 | A-14 | Cont. | 30.00 | | | | Cont. | 100 |
| | | CTC | 3.84 | | CTC | 2.04 | | | | CTC | 5.88 |

### Synthesis Examples 99 and 100

Synthesis Example 99: Combination of a first diamine (code: A-2; content: 20 parts by weight; CTC: 1.1 eV), a second diamine (code: A-9; content: 20 parts by weight; CTC: 0.91 eV), a third diamine (code: A-12; content: 30 parts by weight; CTC: 2.06 eV), and a fourth diamine (code: A-13; content: 30 parts by weight; CTC: 2.10 eV).

Total values for diamines (content: 100 parts by weight; CTC: 6.17 eV)

Synthesis Example 100: Combination of a first diamine (code: A-4; content: 30 parts by weight; CTC: 1.8 eV), a second diamine (code: A-9; content: 10 parts by weight; CTC: 0.46 eV), a third diamine (code: A-12; content: 30 parts by weight; CTC: 2.06 eV), and a fourth diamine (code: A-14; content: 30 parts by weight; CTC: 2.04 eV).

Total values for diamines (content: 100 parts by weight; CTC: 6.35 eV)

**[Table 11]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 101 | A-9 | Cont. | 30.00 | A-12 | Cont. | 35.00 | A-13 | Cont. | 35 | Cont. | 100 |
| | | CTC | 1.37 | | CTC | 2.40 | | CTC | 2.45 | CTC | 6.21 |
| 102 | A-1 | Cont. | 30 | A-11 | Cont. | 35.00 | A-14 | Cont. | 35 | Cont. | 100 |
| | | CTC | 1.368 | | CTC | 1.92 | | CTC | 2.38 | CTC | 5.67 |
| 103 | A-6 | Cont. | 20 | A-12 | Cont. | 40.00 | A-14 | Cont. | 40 | Cont. | 100 |
| | | CTC | 1.34 | | CTC | 2.74 | | CTC | 2.72 | CTC | 6.80 |
| 104 | A-7 | Cont. | 10 | A-11 | Cont. | 45.00 | A-13 | Cont. | 45 | Cont. | 100 |
| | | CTC | 0.493 | | CTC | 2.47 | | CTC | 3.15 | CTC | 6.11 |
| 105 | A-8 | Cont. | 10 | A-12 | Cont. | 45.00 | A-13 | Cont. | 45 | Cont. | 100 |
| | | CTC | 0.529 | | CTC | 3.08 | | CTC | 3.15 | CTC | 6.76 |

### Synthesis Examples 106 and 107

Synthesis Example 106: Combination of a first diamine (code: A-5; content: 10 parts by weight; CTC: 0.48 eV), a second diamine (code: A-9; content: 10 parts by weight; CTC: 0.46 eV), a third diamine (code: A-11; content: 40 parts by weight; CTC: 2.20 eV), and a fourth diamine (code: A-14; content: 40 parts by weight; CTC: 2.72 eV).

Total values for diamines (content: 100 parts by weight; CTC: 5.85 eV)

Synthesis Example 107: Combination of a first diamine (code: A-6; content: 10 parts by weight; CTC: 0.67 eV), a second diamine (code: A-9; content: 10 parts by weight; CTC: 0.46 eV), a third diamine (code: A-12; content: 40 parts by weight; CTC: 2.74 eV), and a fourth diamine (code: A-14; content: 40 parts by weight; CTC: 2.72 eV).

Total values for diamines (content: 100 parts by weight; CTC: 6.59 eV)

**[Table 12]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 108 | A-7 | Cont. | 10 | A-9 | Cont. | 10.00 | A-13 | Cont. | 80 | Cont. | 100 |
| | | CTC | 0.493 | | CTC | 0.46 | | CTC | 5.60 | CTC | 6.55 |
| 109 | A-8 | Cont. | 40 | A-12 | Cont. | 60.00 | | | | Cont. | 100 |
| | | CTC | 2.116 | | CTC | 4.11 | | | | CTC | 6.23 |
| 110 | A-2 | Cont. | 40 | A-12 | Cont. | 60.00 | | | | Cont. | 100 |
| | | CTC | 2.2 | | CTC | 4.11 | | | | CTC | 6.31 |
| 111 | A-8 | Cont. | 30 | A-12 | Cont. | 70.00 | | | | Cont. | 100 |
| | | CTC | 1.587 | | CTC | 4.80 | | | | CTC | 6.38 |
| 112 | A-3 | Cont. | 30 | A-11 | Cont. | 70.00 | | | | Cont. | 100 |
| | | CTC | 1.95 | | CTC | 3.84 | | | | CTC | 5.79 |

### Synthesis Examples 113 and 114

Synthesis Example 113: Combination of a first diamine (code: A-3; content: 10 parts by weight; CTC: 0.65 eV), a second diamine (code: A-9; content: 10 parts by weight; CTC: 0.46 eV), a third diamine (code: A-11; content: 40 parts by weight; CTC: 2.20 eV), and a fourth diamine (code: A-13; content: 40 parts by weight; CTC: 2.80 eV).

Total values for diamines (content: 100 parts by weight; CTC: 6.10 eV)

Synthesis Example 114: Combination of a first diamine (code: A-4; content: 10 parts by weight; CTC: 0.6 eV), a second diamine (code: A-9; content: 10 parts by weight; CTC: 0.46 eV), a third diamine (code: A-12; content: 40 parts by weight; CTC: 2.74 eV), and a fourth diamine (code: A-13; content: 40 parts by weight; CTC: 2.80 eV).

Total values for diamines (content: 100 parts by weight; CTC: 6.60 eV)

**[Table 13]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 115 | A-8 | Cont. | 10 | A-9 | Cont. | 10.00 | A-14 | Cont. | 80 | Cont. | 100 |
| | | CTC | 0.529 | | CTC | 0.46 | | CTC | 5.44 | CTC | 6.42 |
| 116 | A-9 | Cont. | 20.00 | A-13 | Cont. | 80.00 | | | | Cont. | 100 |
| | | CTC | 0.91 | | CTC | 5.60 | | | | CTC | 6.51 |
| 117 | A-6 | Cont. | 50 | A-8 | Cont. | 50 | | | | Cont. | 100 |
| | | CTC | 3.35 | | CTC | 2.645 | | | | CTC | 6.00 |
| 118 | A-1 | Cont. | 80 | A-9 | Cont. | 10.00 | A-11 | Cont. | 10 | Cont. | 100 |
| | | CTC | 3.648 | | CTC | 0.46 | | CTC | 0.55 | CTC | 4.65 |
| 119 | A-8 | Cont. | 80 | A-9 | Cont. | 10.00 | A-12 | Cont. | 10 | Cont. | 100 |
| | | CTC | 4.232 | | CTC | 0.46 | | CTC | 0.69 | CTC | 5.37 |
| 120 | A-1 | Cont. | 40 | A-2 | Cont. | 40 | A-9 | Cont. | 20 | Cont. | 100 |
| | | CTC | 1.824 | | CTC | 1.84 | | CTC | 0.91 | CTC | 4.57 |
| 121 | A-8 | Cont. | 80 | A-10 | Cont. | 10.00 | A-12 | Cont. | 10 | Cont. | 100 |
| | | CTC | 4.232 | | CTC | 0.46 | | CTC | 0.69 | CTC | 5.38 |
| 122 | A-1 | Cont. | 40 | A-2 | Cont. | 40 | A-10 | Cont. | 20 | Cont. | 100 |
| | | CTC | 1.824 | | CTC | 1.84 | | CTC | 0.92 | CTC | 4.58 |

**[Table 14]**

| | First diamine | | | Second diamine | | | Third diamine | | | Total values for diamines | |
|---|---|---|---|---|---|---|---|---|---|---|---|
| Synthesis Example | Code | Content/CTC | | Code | Content/CTC | | Code | Content/CTC | | Content/CTC | |
| 123 | A-9 | Cont. | 14.00 | A-11 | Cont. | 86.00 | | | | Cont. | 100 |
| | | CTC | 0.64 | | CTC | 4.72 | | | | CTC | 5.36 |
| 124 | A-1 | Cont. | 40 | A-9 | Cont. | 20.00 | A-11 | Cont. | 40 | Cont. | 100 |
| | | CTC | 1.824 | | CTC | 0.91 | | CTC | 2.20 | CTC | 4.93 |

**[Table 15]**

| | First diamine | | | Second diamine | | | Third diamine | | | Total values for diamines | |
|---|---|---|---|---|---|---|---|---|---|---|---|
| Comparative Synthesis Example | Code | Content/CTC | | Code | Content/CTC | | Code | Content/CTC | | Content/CTC | |
| 1 | A-6 | Cont. | 30 | A-14 | Cont. | 70.00 | | | | Cont. | 100 |
| | | CTC | 2.01 | | CTC | 4.76 | | | | CTC | 6.77 |
| 2 | A-12 | Cont. | 50.00 | A-14 | Cont. | 50.00 | | | | Cont. | 100 |
| | | CTC | 3.43 | | CTC | 3.40 | | | | CTC | 6.83 |
| 3 | A-2 | Cont. | 10 | A-12 | Cont. | 70.00 | A-13 | Cont. | 20 | Cont. | 100 |
| | | CTC | 0.55 | | CTC | 4.80 | | CTC | 1.40 | CTC | 6.75 |
| 4 | A-12 | Cont. | 30.00 | A-13 | Cont. | 70.00 | | | | Cont. | 100 |
| | | CTC | 2.06 | | CTC | 4.90 | | | | CTC | 6.96 |
| 5 | A-2 | Cont. | 20 | A-12 | Cont. | 60.00 | A-14 | Cont. | 20 | Cont. | 100 |
| | | CTC | 1.1 | | CTC | 4.11 | | CTC | 1.36 | CTC | 6.57 |
| 6 | A-2 | Cont. | 25 | A-12 | Cont. | 50.00 | A-13 | Cont. | 25 | Cont. | 100 |
| | | CTC | 1.375 | | CTC | 3.43 | | CTC | 1.75 | CTC | 6.55 |
| 7 | A-2 | Cont. | 40 | A-12 | Cont. | 20.00 | A-13 | Cont. | 40 | Cont. | 100 |
| | | CTC | 2.2 | | CTC | 1.37 | | CTC | 2.80 | CTC | 6.37 |
| 8 | A-2 | Cont. | 30 | A-12 | Cont. | 35.00 | A-14 | Cont. | 35 | Cont. | 100 |
| | | CTC | 1.65 | | CTC | 2.40 | | CTC | 2.38 | CTC | 6.43 |
| 9 | A-2 | Cont. | 10 | A-12 | Cont. | 45.00 | A-14 | Cont. | 45 | Cont. | 100 |
| | | CTC | 0.55 | | CTC | 3.08 | | CTC | 3.06 | CTC | 6.69 |
| 10 | A-8 | Cont. | 30 | A-12 | Cont. | 30.00 | A-14 | Cont. | 40 | Cont. | 100 |
| | | CTC | 1.587 | | CTC | 2.06 | | CTC | 2.80 | CTC | 6.44 |
| 11 | A-2 | Cont. | 20 | A-12 | Cont. | 80 | | | | Cont. | 100 |
| | | CTC | 1.1 | | CTC | 5.48 | | | | CTC | 6.58 |
| 12 | A-2 | Cont. | 70.00 | A-12 | Cont. | 30.00 | | | | Cont. | 100 |
| | | CTC | 4.80 | | CTC | 2.10 | | | | CTC | 6.90 |
| 13 | A-12 | Cont. | 40.00 | A-13 | Cont. | 40.00 | A-14 | Cont. | 20 | Cont. | 100 |
| | | CTC | 2.74 | | CTC | 2.80 | | CTC | 1.36 | CTC | 6.90 |
| 14 | A-9 | Cont. | 30.00 | A-14 | Cont. | 70.00 | | | | Cont. | 100 |
| | | CTC | 1.37 | | CTC | 4.76 | | | | CTC | 6.13 |
| 15 | A-6 | Cont. | 40 | A-12 | Cont. | 60.00 | | | | Cont. | 100 |
| | | CTC | 2.68 | | CTC | 4.11 | | | | CTC | 6.79 |
| 16 | A-1 | Cont. | 10 | A-11 | Cont. | 45.00 | A-13 | Cont. | 45 | Cont. | 100 |
| | | CTC | 0.456 | | CTC | 2.47 | | CTC | 3.15 | CTC | 6.08 |
| 17 | A-13 | Cont. | 90.00 | A-14 | Cont. | 10.00 | | | | Cont. | 100 |
| | | CTC | 6.30 | | CTC | 0.68 | | | | CTC | 6.98 |
| 18 | A-12 | Cont. | 10.00 | A-14 | Cont. | 90.00 | | | | Cont. | 100 |
| | | CTC | 0.69 | | CTC | 6.12 | | | | CTC | 6.81 |
| 19 | A-12 | Cont. | 40.00 | A-13 | Cont. | 60.00 | | | | Cont. | 100 |
| | | CTC | 2.74 | | CTC | 4.20 | | | | CTC | 6.94 |
| 20 | A-6 | Cont. | 20 | A-13 | Cont. | 60.00 | A-14 | Cont. | 20 | Cont. | 100 |
| | | CTC | 1.34 | | CTC | 4.20 | | CTC | 1.36 | CTC | 6.90 |
| 21 | A-6 | Cont. | 20 | A-12 | Cont. | 40.00 | A-14 | Cont. | 40 | Cont. | 100 |
| | | CTC | 1.34 | | CTC | 2.74 | | CTC | 2.72 | CTC | 6.80 |
| 22 | A-7 | Cont. | 10 | A-13 | Cont. | 80.00 | A-14 | Cont. | 10 | Cont. | 100 |
| | | CTC | 0.493 | | CTC | 5.60 | | CTC | 0.68 | CTC | 6.77 |
| 23 | A-3 | Cont. | 50 | A-12 | Cont. | 25.00 | A-13 | Cont. | 25 | Cont. | 100 |
| | | CTC | 3.25 | | CTC | 1.71 | | CTC | 1.75 | CTC | 6.71 |

### Comparative Synthesis Examples 24 to 26

Comparative Synthesis Example 24: Combination of a first diamine (code: A-6; content: 20 parts by weight; CTC: 1.34 eV), a second diamine (code: A-9; content: 10 parts by weight; CTC: 0.46 eV), a third diamine (code: A-12; content: 10 parts by weight; CTC: 0.69 eV), and a fourth diamine (code: A-13; content: 60 parts by weight; CTC: 4.20 eV).

Total values for diamines (content: 100 parts by weight; CTC: 6.68 eV)

Comparative Synthesis Example 25: Combination of a first diamine (code: A-6; content: 20 parts by weight; CTC: 1.34 eV), a second diamine (code: A-10; content: 10 parts by weight; CTC: 0.46 eV), a third diamine (code: A-12; content: 10 parts by weight; CTC: 0.69 eV), and a fourth diamine (code: A-13; content: 60 parts by weight; CTC: 4.20 eV).

Total values for diamines (content: 100 parts by weight; CTC: 6.69 eV)

Comparative Synthesis Example 26: Combination of a first diamine (code: A-6; content: 25 parts by weight; CTC: 1.675 eV), a second diamine (code: A-12; content: 15 parts by weight; CTC: 1.03 eV), a third diamine (code: A-13; content: 30 parts by weight; CTC: 2.10 eV), and a fourth diamine (code: A-14; content: 30 parts by weight; CTC: 2.04 eV) .

Total values for diamines (content: 100 parts by weight; CTC: 6.84 eV)

### Synthesis of Alkali-Soluble Polymer Resins

**An** alkali-soluble polymer resin was produced by reacting an acid anhydride compound and a capping compound with the above-described combination of diamine compounds (all the diamine compounds) as follows. In Tables below, the content (parts by weight) of the acid anhydride compound and the content (parts by weight) of the capping compound are based on 100 parts by weight of the combination of diamine compounds (all the diamine compounds).

Specifically, the above-described amine-based compound (combination of diamine compounds) was added to gamma-butyrolactone and dissolved at 90°C. Then, an acid anhydride compound was added thereto according to the formulation described below, followed by stirring at 105°C for 4 hours. Thereafter, a capping compound was added thereto according to the formulation described below and reacted at 70°C for 2 hours, and then the temperature was raised to 150°C. Next, the water produced by the reaction was removed using a Dean-Stark extractor, and the reaction was terminated after stirring at 180°C for 4 hours, thereby synthesizing an alkali-soluble polymer resin.

**[Table 16]**

| | Acid anhydride compound (B) | | | Capping compound (C) | | | (B)+(C) | |
|---|---|---|---|---|---|---|---|---|
| Synthesis Example | Code | Content (parts by weight)/ CTC (eV) | | Code | Content (parts by weight)/ CTC (eV) | | Content (parts by weight)/ CTC (eV) | |
| 1 | B-4 | Content | 80.00 | C-4 | Content | 40.00 | Content | 120.00 |
| | | CTC | 3.95 | | CTC | 1.53 | CTC | 5.48 |
| 2 | B-5 | Content | 50.00 | C-1 | Content | 100.00 | Content | 150.00 |
| | | CTC | 2.24 | | CTC | 3.04 | CTC | 5.28 |
| 3 | B-7 | Content | 70.00 | C-3 | Content | 60.00 | Content | 130.00 |
| | | CTC | 0.05 | | CTC | 2.12 | CTC | 2.18 |
| 4 | B-8 | Content | 80.00 | C-4 | Content | 40.00 | Content | 120.00 |
| | | CTC | 3.95 | | CTC | 1.53 | CTC | 5.49 |
| 5 | B-9 | Content | 50.00 | C-1 | Content | 100.00 | Content | 150.00 |
| | | CTC | 1.52 | | CTC | 3.04 | CTC | 4.56 |
| 6 | B-1 | Content | 60.00 | C-2 | Content | 80.00 | Content | 140.00 |
| | | CTC | 1.96 | | CTC | 2.66 | CTC | 4.62 |
| 7 | B-3 | Content | 80.00 | C-4 | Content | 40.00 | Content | 120.00 |
| | | CTC | 4.00 | | CTC | 1.53 | CTC | 5.53 |
| 8 | B-4 | Content | 50.00 | C-1 | Content | 100.00 | Content | 150.00 |
| | | CTC | 1.97 | | CTC | 3.04 | CTC | 5.01 |
| 9 | B-6 | Content | 70.00 | C-3 | Content | 60.00 | Content | 130.00 |
| | | CTC | 2.46 | | CTC | 2.12 | CTC | 4.58 |
| 10 | B-7 | Content | 80.00 | C-4 | Content | 40.00 | Content | 120.00 |
| | | CTC | 3.20 | | CTC | 1.53 | CTC | 4.73 |
| 11 | B-8 | Content | 50.00 | C-1 | Content | 100.00 | Content | 150.00 |
| | | CTC | 1.98 | | CTC | 3.04 | CTC | 5.02 |
| 12 | B-9 | Content | 60.00 | C-2 | Content | 80.00 | Content | 140.00 |
| | | CTC | 1.95 | | CTC | 2.66 | CTC | 4.61 |
| 13 | B-1 | Content | 70.00 | C-3 | Content | 60.00 | Content | 130.00 |
| | | CTC | 2.46 | | CTC | 2.12 | CTC | 4.58 |
| 14 | B-3 | Content | 50.00 | C-1 | Content | 100.00 | Content | 150.00 |
| | | CTC | 2.00 | | CTC | 3.04 | CTC | 5.04 |
| 15 | B-4 | Content | 60.00 | C-2 | Content | 80.00 | Content | 140.00 |
| | | CTC | 2.54 | | CTC | 2.66 | CTC | 5.19 |
| 16 | B-6 | Content | 80.00 | C-4 | Content | 40.00 | Content | 120.00 |
| | | CTC | 3.05 | | CTC | 1.53 | CTC | 4.58 |
| 17 | B-7 | Content | 50.00 | C-1 | Content | 100.00 | Content | 150.00 |
| | | CTC | 1.60 | | CTC | 3.04 | CTC | 4.64 |
| 18 | B-8 | Content | 60.00 | C-2 | Content | 80.00 | Content | 140.00 |
| | | CTC | 2.54 | | CTC | 2.66 | CTC | 5.20 |
| 19 | B-9 | Content | 70.00 | C-3 | Content | 60.00 | Content | 130.00 |
| | | CTC | 2.46 | | CTC | 2.12 | CTC | 4.58 |
| 20 | B-1 | Content | 80.00 | C-4 | Content | 40.00 | Content | 120.00 |
| | | CTC | 3.05 | | CTC | 1.53 | CTC | 4.58 |
| 21 | B-2 | Content | 50.00 | C-1 | Content | 100.00 | Content | 150.00 |
| | | CTC | 1.98 | | CTC | 3.04 | CTC | 5.02 |
| 22 | B-3 | Content | 60 | C-2 | Content | 80 | Content | 140 |
| | | CTC | 2.57 | | CTC | 2.66 | CTC | 5.23 |
| 23 | B-1 | Content | 50 | C-1 | Content | 100 | Content | 150 |
| | | CTC | 1.52 | | CTC | 3.04 | CTC | 4.56 |
| 24 | B-2 | Content | 60 | C-2 | Content | 80 | Content | 140 |
| | | CTC | 2.55 | | CTC | 2.66 | CTC | 5.21 |
| 25 | B-3 | Content | 70 | C-3 | Content | 60 | Content | 130 |
| | | CTC | 3.23 | | CTC | 2.12 | CTC | 5.35 |
| 26 | B-4 | Content | 80 | C-4 | Content | 40 | Content | 120 |
| | | CTC | 3.95 | | CTC | 1.53 | CTC | 5.48 |
| 27 | B-5 | Content | 50 | C-1 | Content | 50 | Content | 100 |
| | | CTC | 3.36 | | CTC | 2.28 | CTC | 5.64 |
| 28 | B-6 | Content | 60 | C-2 | Content | 40 | Content | 100 |
| | | CTC | 2.74 | | CTC | 1.86 | CTC | 4.60 |
| 29 | B-7 | Content | 70 | C-3 | Content | 30 | Content | 100 |
| | | CTC | 3.36 | | CTC | 1.38 | CTC | 4.74 |
| 30 | B-9 | Content | 50 | C-1 | Content | 100 | Content | 150 |
| | | CTC | 1.52 | | CTC | 3.04 | CTC | 4.56 |
| 31 | B-1 | Content | 60 | C-2 | Content | 80 | Content | 140 |
| | | CTC | 1.96 | | CTC | 2.66 | CTC | 4.62 |
| 32 | B-2 | Content | 70 | C-3 | Content | 60 | Content | 130 |
| | | CTC | 3.20 | | CTC | 2.12 | CTC | 5.33 |
| 33 | B-3 | Content | 80 | C-4 | Content | 40 | Content | 120 |
| | | CTC | 4.00 | | CTC | 1.53 | CTC | 5.53 |
| 34 | B-4 | Content | 50 | C-1 | Content | 50 | Content | 100 |
| | | CTC | 2.96 | | CTC | 2.28 | CTC | 5.24 |
| 35 | B-6 | Content | 70 | C-3 | Content | 30 | Content | 100 |
| | | CTC | 3.20 | | CTC | 1.38 | CTC | 4.58 |
| 36 | B-7 | Content | 80 | C-4 | Content | 20 | Content | 100 |
| | | CTC | 3.84 | | CTC | 0.92 | CTC | 4.76 |
| 37 | B-8 | Content | 50 | C-1 | Content | 100 | Content | 150 |
| | | CTC | 1.98 | | CTC | 3.04 | CTC | 5.02 |
| 38 | B-9 | Content | 60 | C-2 | Content | 80 | Content | 140 |
| | | CTC | 1.95 | | CTC | 2.66 | CTC | 4.61 |
| 39 | B-1 | Content | 50 | C-3 | Content | 60 | Content | 110 |
| | | CTC | 2.08 | | CTC | 2.51 | CTC | 4.59 |
| 40 | B-2 | Content | 60.00 | C-4 | Content | 40.00 | Content | 100.00 |
| | | CTC | 3.57 | | CTC | 1.84 | CTC | 5.41 |
| 41 | B-3 | Content | 70.00 | C-1 | Content | 50.00 | Content | 120.00 |
| | | CTC | 3.50 | | CTC | 1.90 | CTC | 5.40 |
| 42 | B-4 | Content | 80.00 | C-2 | Content | 40.00 | Content | 120.00 |
| | | CTC | 3.95 | | CTC | 1.55 | CTC | 5.50 |
| 43 | B-6 | Content | 60.00 | C-4 | Content | 20.00 | Content | 80.00 |
| | | CTC | 3.43 | | CTC | 1.15 | CTC | 4.58 |
| 44 | B-7 | Content | 70.00 | C-1 | Content | 100.00 | Content | 170.00 |
| | | CTC | 1.98 | | CTC | 2.68 | CTC | 4.66 |
| 45 | B-8 | Content | 80 | C-2 | Content | 80 | Content | 160 |
| | | CTC | 2.97 | | CTC | 2.33 | CTC | 5.29 |
| 46 | B-9 | Content | 50 | C-3 | Content | 60 | Content | 110 |
| | | CTC | 2.07 | | CTC | 2.51 | CTC | 4.58 |
| 47 | B-1 | Content | 60 | C-4 | Content | 40 | Content | 100 |
| | | CTC | 2.74 | | CTC | 1.84 | CTC | 4.58 |
| 48 | B-2 | Content | 70 | C-1 | Content | 50 | Content | 120 |
| | | CTC | 3.47 | | CTC | 1.90 | CTC | 5.37 |
| 49 | B-3 | Content | 80 | C-2 | Content | 40 | Content | 120 |
| | | CTC | 4.00 | | CTC | 1.55 | CTC | 5.55 |
| 50 | B-6 | Content | 70 | C-1 | Content | 100 | Content | 170 |
| | | CTC | 1.88 | | CTC | 2.68 | CTC | 4.56 |

**[Table 17]**

| | Acid anhydride compound (B) | | | Capping compound (C) | | | (B)+(C) | |
|---|---|---|---|---|---|---|---|---|
| Synthesis Example | Code | Content (parts by weight)/ CTC (eV) | | Code | Content (parts by weight)/ CTC (eV) | | Content (parts by weight)/ CTC (eV) | |
| 51 | B-7 | Content | 80 | C-2 | Content | 80 | Content | 160 |
| | | CTC | 2.40 | | CTC | 2.33 | CTC | 4.73 |
| 52 | B-8 | Content | 50.00 | C-3 | Content | 60.00 | Content | 110.00 |
| | | CTC | 2.70 | | CTC | 2.51 | CTC | 5.20 |
| 53 | B-9 | Content | 60.00 | C-4 | Content | 40.00 | Content | 100.00 |
| | | CTC | 2.74 | | CTC | 1.84 | CTC | 4.58 |
| 54 | B-1 | Content | 50.00 | C-1 | Content | 50.00 | Content | 100.00 |
| | | CTC | 2.29 | | CTC | 2.28 | CTC | 4.57 |
| 55 | B-2 | Content | 60.00 | C-2 | Content | 40.00 | Content | 100.00 |
| | | CTC | 3.57 | | CTC | 1.86 | CTC | 5.43 |
| 56 | B-3 | Content | 70.00 | C-3 | Content | 30.00 | Content | 100.00 |
| | | CTC | 4.20 | | CTC | 1.38 | CTC | 5.58 |
| 57 | B-4 | Content | 80.00 | C-4 | Content | 20.00 | Content | 100.00 |
| | | CTC | 4.74 | | CTC | 0.92 | CTC | 5.66 |
| 58 | B-4 | Content | 80.00 | C-4 | Content | 20.00 | Content | 100.00 |
| | | CTC | 4.74 | | CTC | 0.92 | CTC | 5.66 |
| 59 | B-6 | Content | 60.00 | C-2 | Content | 40.00 | Content | 100.00 |
| | | CTC | 2.74 | | CTC | 1.86 | CTC | 4.60 |
| 60 | B-9 | Content | 50.00 | C-1 | Content | 50.00 | Content | 100.00 |
| | | CTC | 2.28 | | CTC | 2.28 | CTC | 4.56 |
| 61 | B-1 | Content | 60.00 | C-2 | Content | 40.00 | Content | 100.00 |
| | | CTC | 2.74 | | CTC | 1.86 | CTC | 4.60 |
| 62 | B-4 | Content | 50.00 | C-1 | Content | 50.00 | Content | 100.00 |
| | | CTC | 2.96 | | CTC | 2.28 | CTC | 5.24 |
| 63 | B-6 | Content | 70.00 | C-3 | Content | 45.00 | Content | 115.00 |
| | | CTC | 2.78 | | CTC | 1.80 | CTC | 4.58 |
| 64 | B-8 | Content | 50.00 | C-1 | Content | 75.00 | Content | 125.00 |
| | | CTC | 2.37 | | CTC | 2.74 | CTC | 5.11 |
| 65 | B-9 | Content | 60.00 | C-2 | Content | 60.00 | Content | 120.00 |
| | | CTC | 2.28 | | CTC | 2.33 | CTC | 4.61 |
| 66 | B-1 | Content | 70.00 | C-3 | Content | 45.00 | Content | 115.00 |
| | | CTC | 2.78 | | CTC | 1.80 | CTC | 4.58 |
| 67 | B-3 | Content | 50.00 | C-1 | Content | 75.00 | Content | 125.00 |
| | | CTC | 2.40 | | CTC | 2.74 | CTC | 5.14 |
| 68 | B-4 | Content | 60.00 | C-2 | Content | 60.00 | Content | 120.00 |
| | | CTC | 2.96 | | CTC | 2.33 | CTC | 5.29 |
| 69 | B-6 | Content | 70.00 | C-1 | Content | 100.00 | Content | 170.00 |
| | | CTC | 1.88 | | CTC | 2.68 | CTC | 4.56 |
| 70 | B-7 | Content | 80.00 | C-2 | Content | 80.00 | Content | 160.00 |
| | | CTC | 2.40 | | CTC | 2.33 | CTC | 4.73 |
| 71 | B-8 | Content | 50.00 | C-3 | Content | 60.00 | Content | 110.00 |
| | | CTC | 2.70 | | CTC | 2.51 | CTC | 5.20 |
| 72 | B-9 | Content | 60.00 | C-4 | Content | 40.00 | Content | 100.00 |
| | | CTC | 2.74 | | CTC | 1.84 | CTC | 4.58 |
| 73 | B-1 | Content | 50.00 | C-1 | Content | 50.00 | Content | 100.00 |
| | | CTC | 2.29 | | CTC | 2.28 | CTC | 4.57 |
| 74 | B-2 | Content | 60.00 | C-2 | Content | 40.00 | Content | 100.00 |
| | | CTC | 3.57 | | CTC | 1.86 | CTC | 5.43 |
| 75 | B-4 | Content | 80.00 | C-4 | Content | 20.00 | Content | 100.00 |
| | | CTC | 4.74 | | CTC | 0.92 | CTC | 5.66 |
| 76 | B-1 | Content | 100.00 | | | | Content | 100.00 |
| | | CTC | 4.57 | | | | CTC | 4.57 |
| 77 | B-9 | Content | 60.00 | C-1 | Content | 80.00 | Content | 140.00 |
| | | CTC | 1.95 | | CTC | 2.61 | CTC | 4.56 |
| 78 | B-5 | Content | 50.00 | C-1 | Content | 100.00 | Content | 150.00 |
| | | CTC | 2.24 | | CTC | 3.04 | CTC | 5.28 |
| 79 | B-7 | Content | 70.00 | C-3 | Content | 60.00 | Content | 130.00 |
| | | CTC | 2.58 | | CTC | 2.12 | CTC | 4.71 |
| 80 | B-9 | Content | 50.00 | C-1 | Content | 50.00 | Content | 100.00 |
| | | CTC | 2.28 | | CTC | 2.28 | CTC | 4.56 |
| 81 | B-4 | Content | 50.00 | C-1 | Content | 100.00 | Content | 150.00 |
| | | CTC | 1.97 | | CTC | 3.04 | CTC | 5.01 |
| 82 | B-3 | Content | 120.00 | C-5 | Content | 40.00 | Content | 160.00 |
| | | CTC | 4.50 | | CTC | 1.14 | CTC | 5.64 |
| 83 | B-4 | Content | 130.00 | C-5 | Content | 60.00 | Content | 190.00 |
| | | CTC | 4.05 | | CTC | 1.44 | CTC | 5.49 |
| 84 | B-6 | Content | 110.00 | C-5 | Content | 20.00 | Content | 130.00 |
| | | CTC | 3.87 | | CTC | 0.70 | CTC | 4.57 |
| 85 | B-7 | Content | 120.00 | C-5 | Content | 40.00 | Content | 160.00 |
| | | CTC | 3.60 | | CTC | 1.14 | CTC | 4.74 |
| 86 | B-8 | Content | 130.00 | C-5 | Content | 60.00 | Content | 190.00 |
| | | CTC | 4.06 | | CTC | 1.44 | CTC | 5.50 |
| 87 | B-9 | Content | 140.00 | C-5 | Content | 80.00 | Content | 220.00 |
| | | CTC | 2.90 | | CTC | 1.66 | CTC | 4.56 |
| 88 | B-6 | Content | 70.00 | C-3 | Content | 60.00 | Content | 130.00 |
| | | CTC | 2.46 | | CTC | 2.12 | CTC | 4.58 |
| 89 | B-8 | Content | 80.00 | C-4 | Content | 20.00 | Content | 100.00 |
| | | CTC | 4.74 | | CTC | 0.92 | CTC | 5.66 |
| 90 | B-5 | Content | 60.00 | C-4 | Content | 20.00 | Content | 80.00 |
| | | CTC | 5.03 | | CTC | 1.15 | CTC | 6.18 |
| 91 | B-7 | Content | 70.00 | C-3 | Content | 30.00 | Content | 100.00 |
| | | CTC | 3.36 | | CTC | 1.38 | CTC | 4.74 |
| 92 | B-8 | Content | 80.00 | C-4 | Content | 20.00 | Content | 100.00 |
| | | CTC | 4.74 | | CTC | 0.92 | CTC | 5.66 |
| 93 | B-3 | Content | 80.00 | C-4 | Content | 20.00 | Content | 100.00 |
| | | CTC | 4.80 | | CTC | 0.92 | CTC | 5.72 |
| 94 | B-7 | Content | 80.00 | C-4 | Content | 30.00 | Content | 110.00 |
| | | CTC | 3.49 | | CTC | 1.25 | CTC | 4.75 |
| 95 | B-2 | Content | 80.00 | C-4 | Content | 30.00 | Content | 110.00 |
| | | CTC | 4.33 | | CTC | 1.25 | CTC | 5.58 |
| 96 | B-5 | Content | 60.00 | C-4 | Content | 20.00 | Content | 80.00 |
| | | CTC | 5.03 | | CTC | 1.15 | CTC | 6.18 |
| 97 | B-3 | Content | 70.00 | C-3 | Content | 30.00 | Content | 100.00 |
| | | CTC | 4.20 | | CTC | 1.38 | CTC | 5.58 |
| 98 | B-3 | Content | 70.00 | C-3 | Content | 60.00 | Content | 130.00 |
| | | CTC | 3.23 | | CTC | 2.12 | CTC | 5.35 |
| 99 | B-6 | Content | 60.00 | C-2 | Content | 80.00 | Content | 140.00 |
| | | CTC | 1.96 | | CTC | 2.66 | CTC | 4.62 |
| 100 | B-8 | Content | 80.00 | C-4 | Content | 40.00 | Content | 120.00 |
| | | CTC | 3.95 | | CTC | 1.53 | CTC | 5.49 |

**[Table 18]**

| | Acid anhydride compound (B) | | | Capping compound (C) | | | (B)+(C) | |
|---|---|---|---|---|---|---|---|---|
| Synthesis Example | Code | Content (parts by weight)/ CTC (eV) | | Code | Content (parts by weight)/ CTC (eV) | | Content (parts by weight)/ CTC (eV) | |
| 101 | B-1 | Content | 60.00 | C-2 | Content | 40.00 | Content | 100.00 |
| | | CTC | 2.74 | | CTC | 1.86 | CTC | 4.60 |
| 102 | B-2 | Content | 70.00 | C-3 | Content | 30.00 | Content | 100.00 |
| | | CTC | 4.17 | | CTC | 1.38 | CTC | 5.55 |
| 103 | B-7 | Content | 80.00 | C-4 | Content | 40.00 | Content | 120.00 |
| | | CTC | 3.20 | | CTC | 1.53 | CTC | 4.73 |
| 104 | B-8 | Content | 50.00 | C-1 | Content | 50.00 | Content | 100.00 |
| | | CTC | 2.97 | | CTC | 2.28 | CTC | 5.25 |
| 105 | B-9 | Content | 60.00 | C-2 | Content | 40.00 | Content | 100.00 |
| | | CTC | 2.74 | | CTC | 1.86 | CTC | 4.60 |
| 106 | B-5 | Content | 50.00 | C-3 | Content | 60.00 | Content | 110.00 |
| | | CTC | 3.05 | | CTC | 2.51 | CTC | 5.56 |
| 107 | B-6 | Content | 60.00 | C-4 | Content | 40.00 | Content | 100.00 |
| | | CTC | 2.74 | | CTC | 1.84 | CTC | 4.58 |
| 108 | B-7 | Content | 70.00 | C-1 | Content | 50.00 | Content | 120.00 |
| | | CTC | 2.80 | | CTC | 1.90 | CTC | 4.70 |
| 109 | B-2 | Content | 80.00 | C-4 | Content | 40.00 | Content | 120.00 |
| | | CTC | 3.97 | | CTC | 1.53 | CTC | 5.50 |
| 110 | B-5 | Content | 60.00 | C-2 | Content | 80.00 | Content | 140.00 |
| | | CTC | 2.88 | | CTC | 2.66 | CTC | 5.53 |
| 111 | B-2 | Content | 70.00 | C-3 | Content | 60.00 | Content | 130.00 |
| | | CTC | 3.20 | | CTC | 2.12 | CTC | 5.33 |
| 112 | B-6 | Content | 60.00 | C-2 | Content | 80.00 | Content | 140.00 |
| | | CTC | 2.51 | | CTC | 2.66 | CTC | 5.17 |
| 113 | B-3 | Content | 70.00 | C-1 | Content | 100.00 | Content | 170.00 |
| | | CTC | 2.47 | | CTC | 2.68 | CTC | 5.15 |
| 114 | B-4 | Content | 80.00 | C-2 | Content | 80.00 | Content | 160.00 |
| | | CTC | 2.96 | | CTC | 2.33 | CTC | 5.29 |
| 115 | B-8 | Content | 80.00 | C-2 | Content | 40.00 | Content | 120.00 |
| | | CTC | 3.95 | | CTC | 1.55 | CTC | 5.50 |
| 116 | B-2 | Content | 70.00 | C-1 | Content | 100.00 | Content | 170.00 |
| | | CTC | 2.45 | | CTC | 2.68 | CTC | 5.13 |
| 117 | B-10 | Content | 70.00 | C-1 | Content | 100.00 | Content | 170.00 |
| | | CTC | 2.26 | | CTC | 2.68 | CTC | 4.95 |
| 118 | B-10 | Content | 80.00 | C-2 | Content | 80.00 | Content | 160.00 |
| | | CTC | 2.75 | | CTC | 2.33 | CTC | 5.08 |
| 119 | B-10 | Content | 70.00 | C-1 | Content | 100.00 | Content | 170.00 |
| | | CTC | 2.26 | | CTC | 2.68 | CTC | 4.95 |
| 120 | B-10 | Content | 80.00 | C-2 | Content | 80.00 | Content | 160.00 |
| | | CTC | 2.75 | | CTC | 2.33 | CTC | 5.08 |
| 121 | B-10 | Content | 70.00 | C-1 | Content | 100.00 | Content | 170.00 |
| | | CTC | 2.26 | | CTC | 2.68 | CTC | 4.95 |
| 122 | B-10 | Content | 80.00 | C-2 | Content | 80.00 | Content | 160.00 |
| | | CTC | 2.75 | | CTC | 2.33 | CTC | 5.08 |

**[Table 19]**

| | Acid anhydride compound (B) | | | | | | Capping compound (C) | | | (B)+(C) | |
|---|---|---|---|---|---|---|---|---|---|---|---|
| | First | | | Second | | | | | | Total diamines | |
| Composit ion | Code | Content/CTC | | Code | Content/CTC | | Code | Content/CTC | | Content/CTC | |
| 123 | B-2 | Cont. | 42 | B-9 | Cont. | 42.00 | C-3 | Cont. | 32 | Cont. | 116 |
| | | CTC | 2.15 | | CTC | 1.65 | | CTC | 1.27 | CTC | 5.07 |
| 124 | B-2 | Cont. | 32 | B-9 | Cont. | 32.00 | C-3 | Cont. | 36 | Cont. | 100 |
| | | CTC | 1.90 | | CTC | 1.46 | | CTC | 1.66 | CTC | 5.02 |

**[Table 20]**

| | Acid anhydride compound (B) | | | | | | Capping compound (C) | | | (B)+(C) | |
|---|---|---|---|---|---|---|---|---|---|---|---|
| | First | | | Second | | | | | | Total diamines | |
| Comparative Synthesis Example | Code | Content /CTC | | Code | Cont ent/CTC | | Code | Content/CTC | | Content/CTC | |
| 1 | B-3 | Cont. | 10 | B-10 | Cont. | 40.00 | C-2 | Cont. | 30 | Cont. | 80 |
| | | CTC | 0.75 | | CTC | 2.75 | | CTC | 1.74 | CTC | 5.24 |
| 2 | B-4 | Cont. | 25 | B-10 | Cont. | 25.00 | C-2 | Cont. | 30 | Cont. | 80 |
| | | CTC | 1.85 | | CTC | 1.72 | | CTC | 1.74 | CTC | 5.31 |
| 3 | B-5 | Cont. | 70 | | | | C-2 | Cont. | 60 | Cont. | 130 |
| | | CTC | 3.61 | | | | | CTC | 2.15 | CTC | 5.76 |
| 4 | B-5 | Cont. | 30 | B-10 | Cont. | 30.00 | C-2 | Cont. | 40 | Cont. | 100 |
| | | CTC | 2.01 | | CTC | 1.65 | | CTC | 1.86 | CTC | 5.52 |
| 5 | B-5 | Cont. | 35 | B-10 | Cont. | 15.00 | C-4 | Cont. | 50 | Cont. | 100 |
| | | CTC | 2.35 | | CTC | 0.83 | | CTC | 2.30 | CTC | 5.47 |
| 6 | B-2 | Cont. | 40 | B-10 | Cont. | 30.00 | C-3 | Cont. | 30 | Cont. | 100 |
| | | CTC | 2.38 | | CTC | 1.65 | | CTC | 1.38 | CTC | 5.41 |
| 7 | B-5 | Cont. | 35 | B-10 | Cont. | 25.00 | C-2 | Cont. | 60 | Cont. | 120 |
| | | CTC | 1.96 | | CTC | 1.15 | | CTC | 2.33 | CTC | 5.43 |
| 8 | B-5 | Cont. | 30 | B-10 | Cont. | 40.00 | C-2 | Cont. | 45 | Cont. | 115 |
| | | CTC | 1.75 | | CTC | 1.91 | | CTC | 1.82 | CTC | 5.48 |
| 9 | B-5 | Cont. | 50 | B-10 | Cont. | 50 | | | | Cont. | 100 |
| | | CTC | 3.36 | | CTC | 2.75 | | | | CTC | 6.11 |
| 10 | B-3 | Cont. | 80 | | | | C-4 | Cont. | 20 | Cont. | 100 |
| | | CTC | 4.80 | | | | | CTC | 0.92 | CTC | 5.72 |
| 11 | B-2 | Cont. | 60 | | | | C-4 | Cont. | 20 | Cont. | 80 |
| | | CTC | 4.46 | | | | | CTC | 1.15 | CTC | 5.61 |
| 12 | B-2 | Cont. | 70 | B-10 | Cont. | 40.00 | C-5 | Cont. | 20 | Cont. | 130 |
| | | CTC | 3.20 | | CTC | 1.69 | | CTC | 0.70 | CTC | 5.60 |
| 13 | B-5 | Cont. | 50 | B-10 | Cont. | 90 | C-5 | Cont. | 80 | Cont. | 220 |
| | | CTC | 1.53 | | CTC | 2.25 | | CTC | 1.66 | CTC | 5.43 |
| 14 | B-2 | Cont. | 30 | B-10 | Cont. | 30 | C-2 | Cont. | 80 | Cont. | 140 |
| | | CTC | 1.28 | | CTC | 1.18 | | CTC | 2.66 | CTC | 5.11 |
| 15 | B-5 | Cont. | 30 | B-10 | Cont. | 30 | C-2 | Cont. | 80 | Cont. | 140 |
| | | CTC | 1.44 | | CTC | 1.18 | | CTC | 2.66 | CTC | 5.27 |
| 16 | B-10 | Cont. | 80 | | | | C-2 | Cont. | 80 | Cont. | 80 |
| | | CTC | 2.75 | | | | | CTC | 3.72 | CTC | 3.72 |
| 17 | B-10 | Cont. | 140 | | | | C-5 | Cont. | 60 | Cont. | 200 |
| | | CTC | 3.85 | | | | | CTC | 1.37 | CTC | 5.22 |
| 18 | B-5 | Cont. | 50 | | | | C-2 | Cont. | 30 | Cont. | 80 |
| | | CTC | 4.19 | | | | | CTC | 1.74 | CTC | 5.94 |
| 19 | B-10 | Cont. | 70 | | | | C-3 | Cont. | 30 | Cont. | 100 |
| | | CTC | 3.85 | | | | | CTC | 1.38 | CTC | 5.23 |
| 20 | B-10 | Cont. | 60 | | | | C-2 | Cont. | 20 | Cont. | 80 |
| | | CTC | 4.13 | | | | | CTC | 1.16 | CTC | 5.29 |
| 21 | B-5 | Cont. | 50 | B-10 | Cont. | 50 | | | | Cont. | 100 |
| | | CTC | 3.36 | | CTC | 2.75 | | | | CTC | 6.11 |
| 22 | B-10 | Cont. | 100 | | | | | | | Cont. | 100 |
| | | CTC | 5.50 | | | | | | | CTC | 5.50 |
| 23 | B-10 | Cont. | 80 | | | | C-2 | Cont. | 40 | Cont. | 120 |
| | | CTC | 3.67 | | | | | CTC | 1.55 | CTC | 5.22 |
| 24 | B-5 | Cont. | 30 | B-10 | Cont. | 40.00 | C-1 | Cont. | 50 | Cont. | 120 |
| | | CTC | 1.68 | | CTC | 1.83 | | CTC | 1.90 | CTC | 5.41 |
| 25 | B-2 | Cont. | 40 | B-10 | Cont. | 100 | C-5 | Cont. | 50 | Cont. | 190 |
| | | CTC | 1.25 | | CTC | 2.89 | | CTC | 1.20 | CTC | 5.35 |

Comparative Synthesis Example 26: Combination of a first acid anhydride compound (code: B-5; content: 20 parts by weight; CTC: 1.68 eV), a second acid anhydride compound (code: B-10; content: 30 parts by weight; CTC: 2.06 eV), a first capping compound (code: C-2; content: 20 parts by weight; CTC: 1.16 eV), and a second capping compound (code: C-3; content: 10 parts by weight; CTC: 0.58 eV).

Total values for acid anhydride compound and capping compound (content: 80 parts by weight; CTC: 5.48 eV)

### Analysis of Physical Properties of Alkali-Soluble Polymer Resins

The CTC values (eV) and degrees of imidization of the alkali-soluble polymer resins prepared in the Synthesis Examples and the Comparative Synthesis Examples were calculated, and the results are shown in Tables below.

In Tables 21 to 24 below, the calculated CTC values are those obtained by calculation using Equation 1-1 below. [Equation 1-1] $CTC \left(eV\right) of alkali - soluble polymer resin = \left(A+B\right) / 2$

In addition, in Tables 21 to 24 below, the degree of imidization refers to the content of the repeating unit represented by Formula B based on a total of 100 mol% of the repeating unit represented by Formula A and the repeating unit represented by Formula B in the alkali-soluble polymer resin.

Here, the mole% of the repeating units contained in the alkali-soluble polymer resin may be calculated by determining the conversion rate through the comparison of the -C-N-C- peak of the imide bond in the FT-IR measurement results. Specifically, sample (a) was obtained by coating a glass surface with the alkali-soluble polymer resin, followed by heating at a temperature of 120°C for 120 seconds. In addition, sample (b) was obtained by coating a glass surface with the alkali-soluble polymer resin, followed by heating at a temperature of 120°C for 120 seconds and heating at a temperature of 350°C for 60 minutes.

FT-IR measurements were performed on the obtained samples (a) and (b). At this time, C=C (aromatic, 1510 cm⁻¹) and C-N-C (1370 cm⁻¹) were measured. Subsequently, the mol% (degree of imidization) of the repeating unit represented by Formula B was calculated by comparing the degree of imidization.

**[Table 21]**

| Synthesis Example | Calculated CTC (eV) | Degree of imidization (mol%) |
|---|---|---|
| 1 | 5.35 | 90 |
| 2 | 5.86 | 80 |
| 3 | 4.39 | 85 |
| 4 | 5.38 | 70 |
| 5 | 5.68 | 85 |
| 6 | 4.97 | 95 |
| 7 | 5.37 | 60 |
| 8 | 5.07 | 55 |
| 9 | 5.24 | 51 |
| 10 | 5.62 | 70 |
| 11 | 5.12 | 75 |
| 12 | 5.70 | 65 |
| 13 | 4.92 | 52 |
| 14 | 5.08 | 80 |
| 15 | 5.11 | 90 |
| 16 | 5.29 | 95 |
| 17 | 5.53 | 85 |
| 18 | 5.17 | 80 |
| 19 | 5.68 | 85 |
| 20 | 4.90 | 70 |
| 21 | 5.55 | 80 |
| 22 | 5.12 | 75 |
| 23 | 4.75 | 65 |
| 24 | 5.58 | 60 |
| 25 | 5.63 | 70 |
| 26 | 5.84 | 75 |
| 27 | 5.33 | 55 |
| 28 | 5.47 | 95 |
| 29 | 4.91 | 90 |
| 30 | 4.72 | 51 |
| 31 | 5.15 | 90 |
| 32 | 5.49 | 80 |
| 33 | 5.66 | 75 |
| 34 | 5.03 | 75 |
| 35 | 4.74 | 65 |
| 36 | 5.03 | 70 |
| 37 | 5.07 | 60 |
| 38 | 5.26 | 51 |
| 39 | 5.04 | 65 |
| 40 | 5.47 | 70 |
| 41 | 5.58 | 80 |
| 42 | 5.57 | 90 |
| 43 | 4.72 | 95 |
| 44 | 5.33 | 90 |
| 45 | 4.97 | 80 |
| 46 | 5.06 | 85 |
| 47 | 5.39 | 75 |
| 48 | 5.66 | 60 |
| 49 | 5.20 | 55 |
| 50 | 4.97 | 75 |

**[Table 22]**

| Synthesis Example | Calculated CTC (eV) | Degree of imidization (mol%) |
|---|---|---|
| 51 | 4.83 | 70 |
| 52 | 5.26 | 85 |
| 53 | 5.34 | 85 |
| 54 | 5.14 | 90 |
| 55 | 5.09 | 90 |
| 56 | 5.93 | 55 |
| 57 | 5.26 | 60 |
| 58 | 5.43 | 65 |
| 59 | 5.20 | 80 |
| 60 | 5.68 | 80 |
| 61 | 4.96 | 85 |
| 62 | 5.18 | 90 |
| 63 | 5.24 | 80 |
| 64 | 5.16 | 80 |
| 65 | 5.70 | 75 |
| 66 | 4.92 | 95 |
| 67 | 5.13 | 80 |
| 68 | 5.16 | 85 |
| 69 | 4.97 | 85 |
| 70 | 4.83 | 80 |
| 71 | 5.26 | 80 |
| 72 | 5.35 | 80 |
| 73 | 5.14 | 95 |
| 74 | 5.10 | 80 |
| 75 | 5.26 | 80 |
| 76 | 4.92 | 75 |
| 77 | 5.25 | 80 |
| 78 | 5.42 | 85 |
| 79 | 5.20 | 90 |
| 80 | 5.16 | 95 |
| 81 | 5.65 | 80 |
| 82 | 5.38 | 85 |
| 83 | 5.26 | 55 |
| 84 | 5.23 | 65 |
| 85 | 5.63 | 70 |
| 86 | 5.36 | 60 |
| 87 | 5.68 | 80 |
| 88 | 5.23 | 55 |
| 89 | 5.72 | 65 |
| 90 | 5.57 | 85 |
| 91 | 5.67 | 80 |
| 92 | 5.47 | 90 |
| 93 | 5.46 | 95 |
| 94 | 5.63 | 80 |
| 95 | 5.90 | 85 |
| 96 | 5.57 | 75 |
| 97 | 5.93 | 70 |
| 98 | 5.62 | 65 |
| 99 | 5.39 | 60 |
| 100 | 5.92 | 55 |

**[Table 23]**

| Synthesis Example | Calculated CTC (eV) | Degree of imidization (mol%) |
|---|---|---|
| 101 | 5.41 | 80 |
| 102 | 5.61 | 85 |
| 103 | 5.77 | 90 |
| 104 | 5.68 | 95 |
| 105 | 5.68 | 80 |
| 106 | 5.71 | 80 |
| 107 | 5.58 | 85 |
| 108 | 5.62 | 80 |
| 109 | 5.86 | 75 |
| 110 | 5.92 | 75 |
| 111 | 5.85 | 80 |
| 112 | 5.48 | 70 |
| 113 | 5.63 | 65 |
| 114 | 5.94 | 60 |
| 115 | 5.96 | 80 |
| 116 | 5.82 | 55 |
| 117 | 5.47 | 55 |
| 118 | 4.86 | 80 |
| 119 | 5.16 | 85 |
| 120 | 4.82 | 75 |
| 121 | 5.16 | 70 |
| 122 | 4.83 | 65 |
| 123 | 5.22 | 80 |
| 124 | 4.97 | 80 |

**[Table 24]**

| Comparative Synthesis Example | Calculated CTC (eV) | Degree of imidization (mol%) |
|---|---|---|
| 1 | 6.01 | 50 |
| 2 | 6.08 | 40 |
| 3 | 6.00 | 45 |
| 4 | 6.29 | 40 |
| 5 | 6.18 | 30 |
| 6 | 6.11 | 50 |
| 7 | 6.18 | 45 |
| 8 | 6.00 | 45 |
| 9 | 6.02 | 40 |
| 10 | 6.24 | 30 |
| 11 | 6.07 | 45 |
| 12 | 6.15 | 45 |
| 13 | 6.02 | 50 |
| 14 | 6.01 | 50 |
| 15 | 6.00 | 30 |
| 16 | 6.09 | 40 |
| 17 | 6.30 | 35 |
| 18 | 6.00 | 40 |
| 19 | 6.01 | 50 |
| 20 | 6.11 | 45 |
| 21 | 6.05 | 50 |
| 22 | 6.52 | 45 |
| 23 | 6.20 | 50 |
| 24 | 6.01 | 40 |
| 25 | 6.09 | 30 |
| 26 | 6.03 | 35 |

### Examples (Preparation of Positive Photosensitive Resin Compositions)

### Esterified Quinone Diazide Compound

An esterified quinone diazide compound represented by Formula 3-A1 below was prepared.

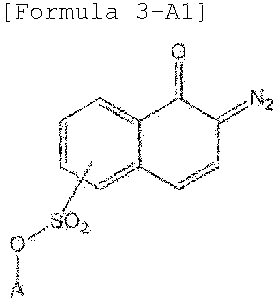

Here, Formula 3-A1 includes a reaction product of a naphthoquinone diazide compound and a phenol compound disclosed in Table 25 below. In addition, "A" in Formula 3-A1 above corresponds to the structure (moiety) of the phenol compound disclosed in Table 25 below, and the oxygen of the "A-O" bond corresponds to the oxygen of the phenolic hydroxyl group of the phenol compound.

**[Table 25]**

| Code | Structure of phenol compound |
|---|---|
| (3-1) <Compound 3-1> | 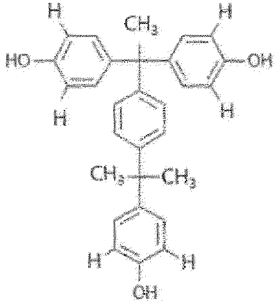 |
| (3-2) <Compound 3-2> | 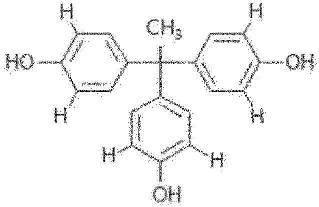 |

In the case of the esterified quinone diazide compound corresponding to the reaction product of the phenol compound of Code 3-1 in Table 25 above and the naphthoquinone diazide compound, 2 mol of the naphthoquinone diazide compound was bonded to 1 mol of the phenol compound. In the case of the esterified quinone diazide compound corresponding to the reaction product of the phenol compound of Code 3-2 in Table 25 above and the naphthoquinone diazide compound, 2 mol of the naphthoquinone diazide compound was bonded to 1 mol of the phenol compound.

### Crosslinking Agents

The following compounds were prepared as crosslinking agents containing phenol groups.

**[Table 26]**

| Code | Structure |
|---|---|
| (4-1) <Formula 4-9> | 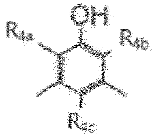 R₄ₐ, R_{4b}: -CH₂OCH₃ |
| (4-2) <Formula 4-1> | 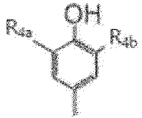 R₄ₐ, R_{4b}: -CH₂OCH₃ |
| (4-3) <Formula 4-2> | 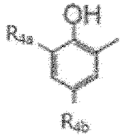 R₄ₐ, R_{4b}: -CH₂OCH₃ |
| (4-4) <Formula 4-3> | 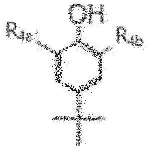 R₄ₐ, R_{4b}: -CH₂OCH₃ |
| (4-5) <Formula 4-10> | 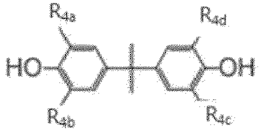 R₄ₐ, R_{4b}, R_{4c}, R_{4d}: -CH₂OCH₃ |
| (4-6) <Formula 4-11> | 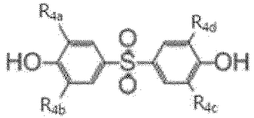 R₄ₐ, R_{4b}, R_{4c}, R_{4d}: -CH₂OCH₃ |
| (4-7) <Formula 4-16> | 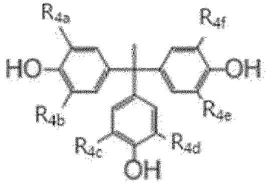 R₄ₐ, R_{4b}, R_{4c}, R_{4d}, R₄ₑ, R_{4f}: - CH₂OCH₃ |
| (4-8) <Formula 4-17> | 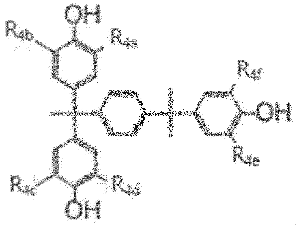 R₄ₐ, R_{4b}, R_{4c}, R_{4d}, R₄ₑ, R_{4f}: - CH₂OCH₃ |

A positive photosensitive resin composition was prepared by mixing a quinone diazide compound and a crosslinking agent with the alkali-soluble polymer resin (polyimide polymer) produced in the Synthesis Example as follows. The contents (parts by weight) of the quinone diazide compound and the crosslinking agent are based on 100 parts by weight of the alkali-soluble polymer resin (polyimide polymer).

**[Table 27]**

| | Polyimide polymer | | Quinone diazide compound | | Crosslinking agent | | | | |
|---|---|---|---|---|---|---|---|---|---|
| Example | Kind | Content | Code | Content | Code | Content | Structure | Content | Total content |
| 1 | Synthesis Example 1 | 100 | 3-1 | 25 | 4-1 | 8 | - | - | 8 |
| 2 | Synthesis Example 2 | 100 | 3-2 | 25 | 4-2 | 10 | - | - | 10 |
| 3 | Synthesis Example 3 | 100 | 3-1 | 25 | 4-3 | 15 | - | - | 15 |
| 4 | Synthesis Example 4 | 100 | 3-2 | 25 | 4-4 | 20 | - | - | 20 |
| 5 | Synthesis Example 5 | 100 | 3-1 | 25 | 4-5 | 13 | - | - | 13 |
| 6 | Synthesis Example 6 | 100 | 3-2 | 25 | 4-6 | 11 | - | - | 11 |
| 7 | Synthesis Example 7 | 100 | 3-1 | 25 | 4-7 | 15 | - | - | 15 |
| 8 | Synthesis Example 8 | 100 | 3-2 | 25 | 4-8 | 11 | - | - | 11 |
| 9 | Synthesis Example 9 | 100 | 3-1 | 25 | 4-1 | 15 | - | - | 15 |
| 10 | Synthesis Example 10 | 100 | 3-2 | 25 | 4-2 | 20 | - | - | 20 |
| 11 | Synthesis Example 11 | 100 | 3-1 | 25 | 4-3 | 18 | - | - | 18 |
| 12 | Synthesis Example 12 | 100 | 3-2 | 25 | 4-4 | 9 | - | - | 9 |
| 13 | Synthesis Example 13 | 100 | 3-1 | 25 | 4-5 | 12 | - | - | 12 |
| 14 | Synthesis Example 14 | 100 | 3-2 | 25 | 4-6 | 15 | - | - | 15 |
| 15 | Synthesis Example 15 | 100 | 3-1 | 25 | 4-7 | 16 | - | - | 16 |
| 16 | Synthesis Example 16 | 100 | 3-2 | 25 | 4-8 | 18 | - | - | 18 |
| 17 | Synthesis Example 17 | 100 | 3-1 | 25 | 4-1 | 5 | 4-8 | 3 | 8 |
| 18 | Synthesis Example 18 | 100 | 3-2 | 25 | 4-2 | 5 | 4-7 | 5 | 10 |
| 19 | Synthesis Example 19 | 100 | 3-1 | 25 | 4-3 | 5 | 4-6 | 10 | 15 |
| 20 | Synthesis Example 20 | 100 | 3-2 | 25 | 4-4 | 5 | 4-5 | 15 | 20 |
| 21 | Synthesis Example 21 | 100 | 3-1 | 25 | 4-5 | 5 | 4-4 | 3 | 8 |
| 22 | Synthesis Example 22 | 100 | 3-2 | 25 | 4-6 | 5 | 4-3 | 5 | 10 |
| 23 | Synthesis Example 23 | 100 | 3-1 | 25 | 4-7 | 5 | 4-2 | 10 | 15 |
| 24 | Synthesis Example 24 | 100 | 3-1 | 25 | 4-8 | 5 | 4-1 | 15 | 20 |
| 25 | Synthesis Example 25 | 100 | 3-2 | 25 | 4-1 | 8 | - | - | 8 |
| 26 | Synthesis Example 26 | 100 | 3-1 | 25 | 4-2 | 10 | - | - | 10 |
| 27 | Synthesis Example 27 | 100 | 3-2 | 25 | 4-3 | 15 | - | - | 15 |
| 28 | Synthesis Example 28 | 100 | 3-1 | 25 | 4-4 | 20 | - | - | 20 |
| 29 | Synthesis Example 29 | 100 | 3-2 | 25 | 4-5 | 13 | - | - | 13 |
| 30 | Synthesis Example 30 | 100 | 3-1 | 25 | 4-6 | 11 | - | - | 11 |
| 31 | Synthesis Example 31 | 100 | 3-2 | 25 | 4-7 | 15 | - | - | 15 |
| 32 | Synthesis Example 32 | 100 | 3-1 | 25 | 4-8 | 11 | - | - | 11 |
| 33 | Synthesis Example 33 | 100 | 3-2 | 25 | 4-1 | 15 | - | - | 15 |
| 34 | Synthesis Example 34 | 100 | 3-1 | 25 | 4-2 | 20 | - | - | 20 |
| 35 | Synthesis Example 35 | 100 | 3-2 | 25 | 4-3 | 18 | - | - | 18 |
| 36 | Synthesis Example 36 | 100 | 3-1 | 25 | 4-4 | 9 | - | - | 9 |
| 37 | Synthesis Example 37 | 100 | 3-2 | 25 | 4-5 | 12 | - | - | 12 |
| 38 | Synthesis Example 38 | 100 | 3-1 | 25 | 4-6 | 15 | - | - | 15 |
| 39 | Synthesis Example 39 | 100 | 3-2 | 25 | 4-7 | 16 | - | - | 16 |
| 40 | Synthesis Example 40 | 100 | 3-1 | 25 | 4-8 | 18 | - | - | 18 |
| 41 | Synthesis Example 41 | 100 | 3-1 | 25 | 4-1 | 5 | 4-8 | 3 | 8 |
| 42 | Synthesis Example 42 | 100 | 3-2 | 25 | 4-2 | 5 | 4-7 | 5 | 10 |
| 43 | Synthesis Example 43 | 100 | 3-1 | 25 | 4-3 | 5 | 4-6 | 10 | 15 |
| 44 | Synthesis Example 44 | 100 | 3-2 | 25 | 4-4 | 5 | 4-5 | 15 | 20 |
| 45 | Synthesis Example 45 | 100 | 3-1 | 25 | 4-5 | 5 | 4-4 | 3 | 8 |
| 46 | Synthesis Example 46 | 100 | 3-2 | 25 | 4-6 | 5 | 4-3 | 5 | 10 |
| 47 | Synthesis Example 47 | 100 | 3-1 | 25 | 4-7 | 5 | 4-2 | 10 | 15 |
| 48 | Synthesis Example 48 | 100 | 3-2 | 25 | 4-8 | 5 | 4-1 | 15 | 20 |
| 49 | Synthesis Example 49 | 100 | 3-1 | 25 | 4-1 | 8 | - | - | 8 |
| 50 | Synthesis Example 50 | 100 | 3-2 | 25 | 4-2 | 10 | - | - | 10 |

**[Table 28]**

| | Polyimide polymer | | Quinone diazide compound | | Crosslinking agent | | | | |
|---|---|---|---|---|---|---|---|---|---|
| Example | Kind | Content | Code | Content | Code | Content | Structure | Content | Total content |
| 51 | Synthesis Example 51 | 100 | 3-1 | 25 | 4-3 | 15 | - | - | 15 |
| 52 | Synthesis Example 52 | 100 | 3-2 | 25 | 4-4 | 20 | - | - | 20 |
| 53 | Synthesis Example 53 | 100 | 3-1 | 25 | 4-5 | 13 | - | - | 13 |
| 54 | Synthesis Example 54 | 100 | 3-2 | 25 | 4-6 | 11 | - | - | 11 |
| 55 | Synthesis Example 55 | 100 | 3-1 | 25 | 4-7 | 15 | - | - | 15 |
| 56 | Synthesis Example 56 | 100 | 3-2 | 25 | 4-8 | 11 | - | - | 11 |
| 57 | Synthesis Example 57 | 100 | 3-1 | 25 | 4-1 | 15 | - | - | 15 |
| 58 | Synthesis Example 58 | 100 | 3-2 | 25 | 4-2 | 20 | - | - | 20 |
| 59 | Synthesis Example 59 | 100 | 3-1 | 25 | 4-3 | 18 | - | - | 18 |
| 60 | Synthesis Example 60 | 100 | 3-2 | 25 | 4-4 | 9 | - | - | 9 |
| 61 | Synthesis Example 61 | 100 | 3-1 | 25 | 4-5 | 12 | - | - | 12 |
| 62 | Synthesis Example 62 | 100 | 3-2 | 25 | 4-6 | 15 | - | - | 15 |
| 63 | Synthesis Example 63 | 100 | 3-1 | 25 | 4-7 | 16 | - | - | 16 |
| 64 | Synthesis Example 64 | 100 | 3-2 | 25 | 4-8 | 18 | - | - | 18 |
| 65 | Synthesis Example 65 | 100 | 3-1 | 25 | 4-1 | 5 | 4-8 | 3 | 8 |
| 66 | Synthesis Example 66 | 100 | 3-2 | 25 | 4-2 | 5 | 4-7 | 5 | 10 |
| 67 | Synthesis Example 67 | 100 | 3-1 | 25 | 4-3 | 5 | 4-6 | 10 | 15 |
| 68 | Synthesis Example 68 | 100 | 3-2 | 25 | 4-4 | 5 | 4-5 | 15 | 20 |
| 69 | Synthesis Example 69 | 100 | 3-1 | 25 | 4-5 | 5 | 4-4 | 3 | 8 |
| 70 | Synthesis Example 70 | 100 | 3-2 | 25 | 4-6 | 5 | 4-3 | 5 | 10 |
| 71 | Synthesis Example 71 | 100 | 3-1 | 25 | 4-7 | 5 | 4-2 | 10 | 15 |
| 72 | Synthesis Example 72 | 100 | 3-2 | 25 | 4-8 | 5 | 4-1 | 15 | 20 |
| 73 | Synthesis Example 73 | 100 | 3-1 | 25 | 4-1 | 8 | - | - | 8 |
| 74 | Synthesis Example 74 | 100 | 3-2 | 25 | 4-2 | 10 | - | - | 10 |
| 75 | Synthesis Example 75 | 100 | 3-1 | 25 | 4-3 | 15 | - | - | 15 |
| 76 | Synthesis Example 76 | 100 | 3-2 | 25 | 4-4 | 20 | - | - | 20 |
| 77 | Synthesis Example 77 | 100 | 3-1 | 25 | 4-5 | 13 | - | - | 13 |
| 78 | Synthesis Example 78 | 100 | 3-2 | 25 | 4-6 | 11 | - | - | 11 |
| 79 | Synthesis Example 79 | 100 | 3-1 | 25 | 4-7 | 15 | - | - | 15 |
| 80 | Synthesis Example 80 | 100 | 3-2 | 25 | 4-8 | 11 | - | - | 11 |
| 81 | Synthesis Example 81 | 100 | 3-1 | 25 | 4-1 | 15 | - | - | 15 |
| 82 | Synthesis Example 82 | 100 | 3-2 | 25 | 4-2 | 20 | - | - | 20 |
| 83 | Synthesis Example 83 | 100 | 3-1 | 25 | 4-3 | 18 | - | - | 18 |
| 84 | Synthesis Example 84 | 100 | 3-2 | 25 | 4-4 | 9 | - | - | 9 |
| 85 | Synthesis Example 85 | 100 | 3-1 | 25 | 4-5 | 12 | - | - | 12 |
| 86 | Synthesis Example 86 | 100 | 3-2 | 25 | 4-6 | 15 | - | - | 15 |
| 87 | Synthesis Example 87 | 100 | 3-1 | 25 | 4-7 | 16 | - | - | 16 |
| 88 | Synthesis Example 88 | 100 | 3-2 | 25 | 4-8 | 18 | - | - | 18 |
| 89 | Synthesis Example 89 | 100 | 3-1 | 25 | 4-1 | 5 | 4-8 | 3 | 8 |
| 90 | Synthesis Example 90 | 100 | 3-2 | 25 | 4-2 | 5 | 4-7 | 5 | 10 |
| 91 | Synthesis Example 91 | 100 | 3-1 | 25 | 4-3 | 5 | 4-6 | 10 | 15 |
| 92 | Synthesis Example 92 | 100 | 3-2 | 25 | 4-4 | 5 | 4-5 | 15 | 20 |
| 93 | Synthesis Example 93 | 100 | 3-1 | 25 | 4-5 | 5 | 4-4 | 3 | 8 |
| 94 | Synthesis Example 94 | 100 | 3-2 | 25 | 4-6 | 5 | 4-3 | 5 | 10 |
| 95 | Synthesis Example 95 | 100 | 3-1 | 25 | 4-7 | 5 | 4-2 | 10 | 15 |
| 96 | Synthesis Example 96 | 100 | 3-2 | 25 | 4-8 | 5 | 4-1 | 15 | 20 |
| 97 | Synthesis Example 97 | 100 | 3-1 | 25 | 4-1 | 8 | - | - | 8 |
| 98 | Synthesis Example 98 | 100 | 3-1 | 25 | 4-1 | 7 | - | - | 7 |
| 99 | Synthesis Example 99 | 100 | 3-1 | 25 | 4-1 | 25 | - | - | 25 |
| 100 | Synthesis Example 100 | 100 | 3-2 | 25 | 4-2 | 10 | - | - | 10 |
| 101 | Synthesis Example 101 | 100 | 3-1 | 25 | 4-3 | 15 | - | - | 15 |
| 102 | Synthesis Example 102 | 100 | 3-2 | 25 | 4-4 | 20 | - | - | 20 |
| 103 | Synthesis Example 103 | 100 | 3-1 | 25 | 4-5 | 13 | - | - | 13 |
| 104 | Synthesis Example 104 | 100 | 3-2 | 25 | 4-6 | 11 | - | - | 11 |
| 105 | Synthesis Example 105 | 100 | 3-1 | 25 | 4-7 | 15 | - | - | 15 |
| 106 | Synthesis Example 106 | 100 | 3-2 | 25 | 4-8 | 11 | - | - | 11 |
| 107 | Synthesis Example 107 | 100 | 3-1 | 25 | 4-1 | 15 | - | - | 15 |
| 108 | Synthesis Example 108 | 100 | 3-2 | 25 | 4-2 | 20 | - | - | 20 |
| 109 | Synthesis Example 109 | 100 | 3-1 | 25 | 4-3 | 18 | - | - | 18 |
| 110 | Synthesis Example 110 | 100 | 3-2 | 25 | 4-4 | 9 | - | - | 9 |
| 111 | Synthesis Example 111 | 100 | 3-1 | 25 | 4-5 | 12 | - | - | 12 |
| 112 | Synthesis Example 112 | 100 | 3-2 | 25 | 4-6 | 15 | - | - | 15 |
| 113 | Synthesis Example 113 | 100 | 3-1 | 25 | 4-7 | 16 | - | - | 16 |
| 114 | Synthesis Example 114 | 100 | 3-2 | 25 | 4-8 | 18 | - | - | 18 |
| 115 | Synthesis Example 115 | 100 | 3-1 | 25 | 4-1 | 5 | 4-8 | 3 | 8 |
| 116 | Synthesis Example 116 | 100 | 3-2 | 25 | 4-2 | 5 | 4-7 | 5 | 10 |
| 117 | Synthesis Example 117 | 100 | 3-1 | 25 | 4-3 | 5 | 4-6 | 10 | 15 |
| 118 | Synthesis Example 118 | 100 | 3-2 | 25 | 4-4 | 5 | 4-5 | 15 | 20 |
| 119 | Synthesis Example 119 | 100 | 3-1 | 25 | 4-5 | 5 | 4-4 | 3 | 8 |
| 120 | Synthesis Example 120 | 100 | 3-2 | 25 | 4-6 | 5 | 4-3 | 5 | 10 |
| 121 | Synthesis Example 121 | 100 | 3-1 | 25 | 4-7 | 5 | 4-2 | 10 | 15 |
| 122 | Synthesis Example 122 | 100 | 3-2 | 25 | 4-8 | 5 | 4-1 | 15 | 20 |
| 123 | Synthesis Example 123 | 100 | 3-1 | 25 | 4-1 | 15 | - | - | 15 |
| 124 | Synthesis Example 124 | 100 | 3-2 | 25 | 4-2 | 15 | - | - | 15 |

### Comparative Examples (Preparation of Positive Photosensitive Resin Compositions)

**A** positive photosensitive resin composition was prepared by mixing a quinone diazide compound and a crosslinking agent with the alkali-soluble polymer resin (polyimide polymer) produced in the Synthesis Example as follows. The contents (parts by weight) of the quinone diazide compound and the crosslinking agent are based on 100 parts by weight of the alkali-soluble polymer resin (polyimide polymer).

**[Table 29]**

| | Polyimide polymer | | Quinone diazide compound | | Crosslinking agent | | | | |
|---|---|---|---|---|---|---|---|---|---|
| Comparat ive Example | Kind | Content | Code | Content | Code | Content | Structure | Content | Total content |
| 1 | Comparative Synthesis Example 1 | 100 | 3-1 | 25 | 4-3 | 1 | - | - | 1 |
| 2 | Comparative Synthesis Example 2 | 100 | 3-2 | 25 | 4-4 | 3 | - | - | 3 |
| 3 | Comparative Synthesis Example 3 | 100 | 3-1 | 25 | 4-5 | 5 | - | - | 5 |
| 4 | Comparative Synthesis Example 4 | 100 | 3-2 | 25 | 4-6 | 7 | - | - | 7 |
| 5 | Comparative Synthesis Example 5 | 100 | 3-1 | 25 | 4-7 | 2 | 4-1 | 2 | 4 |
| 6 | Comparative Synthesis Example 6 | 100 | 3-2 | 25 | 4-8 | 3 | 4-2 | 3 | 6 |
| 7 | Comparative Synthesis Example 7 | 100 | 3-1 | 25 | 4-1 | 15 | 4-3 | 10 | 25 |
| 8 | Comparative Synthesis Example 8 | 100 | 3-2 | 25 | 4-2 | 15 | 4-4 | 15 | 30 |
| 9 | Comparative Synthesis Example 9 | 100 | 3-1 | 25 | 4-3 | 10 | 4-5 | 15 | 25 |
| 10 | Comparative Synthesis Example 10 | 100 | 3-2 | 25 | 4-4 | 25 | - | - | 25 |
| 11 | Comparative Synthesis Example 11 | 100 | 3-1 | 25 | 4-5 | 30 | - | - | 30 |
| 12 | Comparative Synthesis Example 12 | 100 | 3-2 | 25 | 4-6 | 1 | - | - | 1 |
| 13 | Comparative Synthesis Example 13 | 100 | 3-1 | 25 | 4-7 | 3 | - | - | 3 |
| 14 | Comparative Synthesis Example 14 | 100 | 3-2 | 25 | 4-8 | 5 | - | - | 5 |
| 15 | Comparative Synthesis Example 15 | 100 | 3-1 | 25 | 4-1 | 7 | - | - | 7 |
| 16 | Comparative Synthesis Example 16 | 100 | 3-2 | 25 | 4-2 | 2 | 4-8 | 2 | 4 |
| 17 | Comparative Synthesis Example 17 | 100 | 3-1 | 25 | 4-3 | 3 | 4-7 | 3 | 6 |
| 18 | Comparative Synthesis Example 18 | 100 | 3-2 | 25 | 4-4 | 15 | 4-6 | 10 | 25 |
| 19 | Comparative Synthesis Example 19 | 100 | 3-1 | 25 | 4-5 | 15 | 4-5 | 15 | 30 |
| 20 | Comparative Synthesis Example 20 | 100 | 3-2 | 25 | 4-6 | 10 | 4-4 | 15 | 25 |
| 21 | Comparative Synthesis Example 21 | 100 | 3-1 | 25 | 4-7 | 25 | - | - | 25 |
| 22 | Comparative Synthesis Example 22 | 100 | 3-2 | 25 | 4-8 | 25 | - | - | 25 |
| 23 | Comparative Synthesis Example 23 | 100 | 3-1 | 25 | 4-1 | 25 | - | - | 25 |
| 24 | Comparative Synthesis Example 24 | 100 | 3-2 | 25 | 4-2 | 30 | - | - | 30 |
| 25 | Comparative Synthesis Example 25 | 100 | 3-1 | 25 | 4-3 | 30 | - | - | 30 |
| 26 | Comparative Synthesis Example 26 | 100 | 3-2 | 25 | 4-4 | 30 | - | - | 30 |

### Experimental Example

For the positive photosensitive resin compositions prepared in the Examples and the Comparative Examples, fluorine content, sensitivity, film retention rate, adhesion, chemical resistance, heat resistance, solar resistance, hygroscopicity, operation reliability, and bending characteristics were measured by the following methods. The measured results are shown in Tables 30 to 33 below.

### Measurement of Fluorine Content

The content of fluorine in the photosensitive resin composition was measured using combustion ion chromatography (CIC).

### Measurement of Sensitivity

**Using** a predetermined pattern mask, a substrate having the photosensitive resin composition applied thereto was irradiated with UV light having an intensity of 20 mW/cm² in a broadband at a dose corresponding to a 5 µm contact hole CD. Next, the film formed on the substrate was developed with an aqueous solution containing 2.38 parts by weight of tetramethyl ammonium hydroxide at 23°C for 1 minute, and then rinsed with ultrapure water for 1 minute. Then, the film was cured in an oven at 250°C for 60 minutes to obtain a patterned film having a contact hole CD of 7 µm. An appropriate sensitivity value is 40 to 150 mJ/cm², and a case satisfying this value was marked as O.

### Measurement of Film Retention Rate

**The** film retention rate was measured by comparing the initial coating thickness of the prepared substrate with the final thickness of the substrate after all processes. The case where the ratio of the final thickness to the initial thickness was 60% or more was marked as O, and the case where the ratio was less than 60% was marked as X.

### Measurement of Adhesion

A patterned film was formed in the same manner as in the measurement of sensitivity, and the adhesion depending on the baking temperature was compared based on the case where the 10 µm line width and the slit width were 1:1. At this time, the case where the adhesion was secured at a prebaking temperature of 90°C to 100°C was marked as O, and the case where the adhesion was secured or not secured at a prebaking temperature of 120°C or higher was marked as X.

### Measurement of Chemical Resistance

The prepared substrate was immersed in an evaluation solvent (stripper) at 25°C for 120 seconds, and the change in the thickness of the cured film between before and after immersion was measured. Chemical resistance was marked as follows. ⊚: the change in the thickness is 0 Å or more and less than 150 Å; O: the change in the thickness is 150 Å or more and less than 300 Å; △: the change in the thickness is 300 Å or more and less than 600 Å, and X: the change in the thickness is 600 Å or more. (Evaluation solvent is propylene glycol methyl ether: propylene glycol methyl ether acetate = 7:3 molar ratio).

### Measurement of Heat Resistance

The organic film portion of the substrate (up to the curing process completed) prepared for the evaluation of sensitivity as described above was recovered and evaluated using a thermogravimetric analyzer (TGA) at a temperature of 50 to 500°C and a heating rate of 10°C/min. Heat resistance was marked as follows. ⊚: the 5 wt% loss temperature is 350°C or higher; O: the 5 wt% loss temperature is 300°C or higher and lower than 350°C; and X: the 5 wt% loss temperature is lower than 300°C.

### Measurement of Solar Resistance

A patterned film was formed on a patterned ITO substrate in the same manner as in the measurement of sensitivity, and an EL was deposited thereon. Al was deposited as a cathode electrode thereon, and an encapsulation process was performed. After the substrate was irradiated 10 times with a dose of 2,100 J using a Xenon Lamp Solar Simulator, the time (T97) for a 3% luminance drop in the "on" state was evaluated. Solar resistance was marked as follows. O: the time is 1,000 hours or more; and X: the time is less than 1,000 hours.

### Measurement of Hygroscopicity

The substrate prepared for the evaluation of sensitivity as described above was purified in a constant temperature and constant humidity oven at 85°C and 85% RH for 240 hours, and then the hygroscopicity was evaluated based on the change in film thickness between before and after being placed in the oven. The hygroscopicity was marked as follows. ⊚: the change in the thickness is less than 300Å; O: the change in the thickness is 300 Å or more to less than 600 Å; and X: the change in the thickness is 600Å or more.

### Measurement of Operation Reliability

A patterned film may be formed in the same manner as in the measurement of sensitivity above.

Fig. 1 is a view showing forming a patterned film on a patterned ITO substrate and depositing an EL thereon. Specifically, in Fig. 1, 10 is a source/drain (Ti/Al/Ti), 20 corresponds to the organic film, 30 is an anode (ITO/Ag/ITO), and 40 is a pixel define layer (PDL).

**As** shown in Fig. 1, Al was deposited as a cathode on the top and encapsulation was performed. The time (T97) for a 3% luminance drop in the "on" state of the device at 85°C and 85% RH was evaluated. Operation reliability was marked as follows. ⊚: the time is 1,000 hours or more; O: the time is less than 1,000 hours and 950 hours or more; and X: the time is less than 950 hours.

### Measurement of Bending Characteristics

**A** 100 µm thick polyimide (PI) film was coated with a material to a thickness of 3 µm and folded 200,000 times at a radius of curvature of 1R. The case where multiple cracks were observed in the folded part was marked X, and the case where no cracks were observed was marked O.

**[Table 30]**

| | Fluorine content (ppm) | Sensitivity | Film retention rate | Adhesion | Chemical resistance |
|---|---|---|---|---|---|
| Example 1 | 6,569 | ○ | ○ | ○ | ○ |
| Example 2 | 5,781 | ○ | ○ | ○ | ○ |
| Example 3 | 6,283 | ○ | ○ | ○ | ○ |
| Example 4 | 6,569 | ○ | ○ | ○ | ○ |
| Example 5 | 5,781 | ○ | ○ | ○ | ○ |
| Example 6 | 6,021 | ○ | ○ | ○ | ○ |
| Example 7 | 6,569 | ○ | ○ | ○ | ○ |
| Example 8 | 4,955 | ○ | ○ | ○ | ○ |
| Example 9 | 5,386 | ○ | ○ | ○ | ○ |
| Example 10 | 5,630 | ○ | ○ | ○ | ○ |
| Example 11 | 4,955 | ○ | ○ | ○ | ○ |
| Example 12 | 5,161 | ○ | ○ | ○ | ○ |
| Example 13 | 5,386 | ○ | ○ | ○ | ○ |
| Example 14 | 4,955 | ○ | ○ | ○ | ○ |
| Example 15 | 4,301 | ○ | ○ | ○ | ○ |
| Example 16 | 4,692 | ○ | ○ | ○ | ○ |
| Example 17 | 4,129 | ○ | ○ | ○ | ○ |
| Example 18 | 4,301 | ○ | ○ | ○ | ○ |
| Example 19 | 4,488 | ○ | ○ | ○ | ○ |
| Example 20 | 4,692 | ○ | ○ | ○ | ○ |
| Example 21 | 4,129 | ○ | ○ | ○ | ○ |
| Example 22 | 4,301 | ○ | ○ | ○ | ○ |
| Example 23 | 3,303 | ○ | ○ | ○ | ○ |
| Example 24 | 3,441 | ○ | ○ | ○ | ○ |
| Example 25 | 3,590 | ○ | ○ | ○ | ○ |
| Example 26 | 3,754 | ○ | ○ | ○ | ○ |
| Example 27 | 4,129 | ○ | ○ | ○ | ○ |
| Example 28 | 4,129 | ○ | ○ | ○ | ○ |
| Example 29 | 4,129 | ○ | ○ | ○ | ○ |
| Example 30 | 2,890 | ○ | ○ | ○ | ○ |
| Example 31 | 3,011 | ○ | ○ | ○ | ○ |
| Example 32 | 2,244 | ○ | ○ | ○ | ○ |
| Example 33 | 2,346 | ○ | ○ | ○ | ○ |
| Example 34 | 1,548 | ○ | ○ | ○ | ○ |
| Example 35 | 1,548 | ○ | ○ | ○ | ○ |
| Example 36 | 1,548 | ○ | ○ | ○ | ○ |
| Example 37 | 0 | ○ | ○ | ○ | ○ |
| Example 38 | 0 | ○ | ○ | ○ | ○ |
| Example 39 | 0 | ○ | ○ | ○ | ○ |
| Example 40 | 0 | ○ | ○ | ○ | ○ |
| Example 41 | 0 | ○ | ○ | ○ | ○ |
| Example 42 | 0 | ○ | ○ | ○ | ○ |
| Example 43 | 0 | ○ | ○ | ○ | ○ |
| Example 44 | 0 | ○ | ○ | ○ | ○ |
| Example 45 | 794 | ○ | ○ | ○ | ○ |
| Example 46 | 983 | ○ | ○ | ○ | ○ |
| Example 47 | 1,032 | ○ | ○ | ○ | ○ |
| Example 48 | 938 | ○ | ○ | ○ | ○ |
| Example 49 | 938 | ○ | ○ | ○ | ○ |
| Example 50 | 765 | ○ | ○ | ○ | ○ |
| Example 51 | 0 | ○ | ○ | ○ | ○ |
| Example 52 | 0 | ○ | ○ | ○ | ○ |
| Example 53 | 0 | ○ | ○ | ○ | ○ |
| Example 54 | 0 | ○ | ○ | ○ | ○ |
| Example 55 | 0 | ○ | ○ | ○ | ○ |
| Example 56 | 0 | ○ | ○ | ○ | ○ |
| Example 57 | 0 | ○ | ○ | ○ | ○ |
| Example 58 | 7,226 | ○ | ○ | ○ | ○ |
| Example 59 | 7,226 | ○ | ○ | ○ | ○ |
| Example 60 | 7,226 | ○ | ○ | ○ | ○ |
| Example 61 | 7,226 | ○ | ○ | ○ | ○ |
| Example 62 | 6,194 | ○ | ○ | ○ | ○ |
| Example 63 | 5,761 | ○ | ○ | ○ | ○ |
| Example 64 | 5,505 | ○ | ○ | ○ | ○ |
| Example 65 | 5,630 | ○ | ○ | ○ | ○ |
| Example 66 | 5,761 | ○ | ○ | ○ | ○ |
| Example 67 | 5,505 | ○ | ○ | ○ | ○ |
| Example 68 | 4,692 | ○ | ○ | ○ | ○ |
| Example 69 | 765 | ○ | ○ | ○ | ○ |
| Example 70 | 0 | ○ | ○ | ○ | ○ |
| Example 71 | 0 | ○ | ○ | ○ | ○ |
| Example 72 | 0 | ○ | ○ | ○ | ○ |
| Example 73 | 0 | ○ | ○ | ○ | ○ |
| Example 74 | 0 | ○ | ○ | ○ | ○ |
| Example 75 | 0 | ○ | ○ | ○ | ○ |
| Example 76 | 6,194 | ○ | ○ | ○ | ○ |
| Example 77 | 8,602 | ○ | ○ | ○ | ○ |
| Example 78 | 4,955 | ○ | ○ | ○ | ○ |
| Example 79 | 5,386 | ○ | ○ | ○ | ○ |
| Example 80 | 7,226 | ○ | ○ | ○ | ○ |
| Example 81 | 6,606 | ○ | ○ | ○ | ○ |
| Example 82 | 4,764 | ○ | ○ | ○ | ○ |
| Example 83 | 3,559 | ○ | ○ | ○ | ○ |
| Example 84 | 5,386 | ○ | ○ | ○ | ○ |
| Example 85 | 4,764 | ○ | ○ | ○ | ○ |
| Example 86 | 4,271 | ○ | ○ | ○ | ○ |
| Example 87 | 3,871 | ○ | ○ | ○ | ○ |
| Example 88 | 7,181 | ○ | ○ | ○ | ○ |
| Example 89 | 4,129 | ○ | ○ | ○ | ○ |
| Example 90 | 1,147 | ○ | ○ | ○ | ○ |
| Example 91 | 7,226 | ○ | ○ | ○ | ○ |
| Example 92 | 7,226 | ○ | ○ | ○ | ○ |
| Example 93 | 7,226 | ○ | ○ | ○ | ○ |
| Example 94 | 5,899 | ○ | ○ | ○ | ○ |
| Example 95 | 5,899 | ○ | ○ | ○ | ○ |
| Example 96 | 1,147 | ○ | ○ | ○ | ○ |
| Example 97 | 0 | ○ | ○ | ○ | ○ |
| Example 98 | 8,976 | ○ | ○ | ○ | ○ |
| Example 99 | 5,161 | ○ | ○ | ○ | ○ |
| Example 100 | 5,630 | ○ | ○ | ○ | ○ |
| Example 101 | 7,226 | ○ | ○ | ○ | ○ |
| Example 102 | 7,226 | ○ | ○ | ○ | ○ |
| Example 103 | 7,507 | ○ | ○ | ○ | ○ |
| Example 104 | 9,290 | ○ | ○ | ○ | ○ |
| Example 105 | 9,290 | ○ | ○ | ○ | ○ |
| Example 106 | 7,865 | ○ | ○ | ○ | ○ |
| Example 107 | 8,258 | ○ | ○ | ○ | ○ |
| Example 108 | 7,507 | ○ | ○ | ○ | ○ |
| Example 109 | 5,630 | ○ | ○ | ○ | ○ |
| Example 110 | 5,161 | ○ | ○ | ○ | ○ |
| Example 111 | 6,283 | ○ | ○ | ○ | ○ |
| Example 112 | 6,021 | ○ | ○ | ○ | ○ |
| Example 113 | 6,117 | ○ | ○ | ○ | ○ |
| Example 114 | 6,352 | ○ | ○ | ○ | ○ |
| Example 115 | 7,507 | ○ | ○ | ○ | ○ |
| Example 116 | 6,117 | ○ | ○ | ○ | ○ |
| Example 117 | 5,352 | ○ | ○ | ○ | ○ |
| Example 118 | 7,146 | ○ | ○ | ○ | ○ |
| Example 119 | 6,117 | ○ | ○ | ○ | ○ |
| Example 120 | 6,352 | ○ | ○ | ○ | ○ |
| Example 121 | 6,117 | ○ | ○ | ○ | ○ |
| Example 122 | 6,352 | ○ | ○ | ○ | ○ |
| Example 123 | 8,220 | ○ | ○ | ○ | ○ |
| Example 124 | 3,380 | ○ | ○ | ○ | ○ |

**[Table 31]**

| | Heat resistance | Solar resistance | Hygroscopicity | Operation reliability | Bending characteristics |
|---|---|---|---|---|---|
| Example 1 | ○ | ○ | ○ | ○ | ○ |
| Example 2 | ○ | ○ | ○ | ○ | ○ |
| Example 3 | ○ | ○ | ○ | ○ | ○ |
| Example 4 | ○ | ○ | ○ | ○ | ○ |
| Example 5 | ○ | ○ | ○ | ○ | ○ |
| Example 6 | ○ | ○ | ○ | ○ | ○ |
| Example 7 | ○ | ○ | ○ | ○ | ○ |
| Example 8 | ⊚ | ○ | ⊚ | ⊚ | ○ |
| Example 9 | ○ | ○ | ○ | ○ | ○ |
| Example 10 | ○ | ○ | ○ | ○ | ○ |
| Example 11 | ⊚ | ○ | ⊚ | ⊚ | ○ |
| Example 12 | ○ | ○ | ○ | ○ | ○ |
| Example 13 | ○ | ○ | ○ | ○ | ○ |
| Example 14 | ⊚ | ○ | ⊚ | ⊚ | ○ |
| Example 15 | ⊚ | ○ | ⊚ | ⊚ | ○ |
| Example 16 | ⊚ | ○ | ⊚ | ⊚ | ○ |
| Example 17 | ⊚ | ○ | ⊚ | ⊚ | ○ |
| Example 18 | ⊚ | ○ | ⊚ | ⊚ | ○ |
| Example 19 | ⊚ | ○ | ⊚ | ⊚ | ○ |
| Example 20 | ⊚ | ○ | ⊚ | ⊚ | ○ |
| Example 21 | ⊚ | ○ | ⊚ | ⊚ | ○ |
| Example 22 | ⊚ | ○ | ⊚ | ⊚ | ○ |
| Example 23 | ⊚ | ○ | ⊚ | ⊚ | ○ |
| Example 24 | ⊚ | ○ | ⊚ | ⊚ | ○ |
| Example 25 | ⊚ | ○ | ⊚ | ⊚ | ○ |
| Example 26 | ⊚ | ○ | ⊚ | ⊚ | ○ |
| Example 27 | ⊚ | ○ | ⊚ | ⊚ | ○ |
| Example 28 | ⊚ | ○ | ⊚ | ⊚ | ○ |
| Example 29 | ⊚ | ○ | ⊚ | ⊚ | ○ |
| Example 30 | ⊚ | ○ | ⊚ | ⊚ | ○ |
| Example 31 | ⊚ | ○ | ⊚ | ⊚ | ○ |
| Example 32 | ⊚ | ○ | ⊚ | ⊚ | ○ |
| Example 33 | ⊚ | ○ | ⊚ | ⊚ | ○ |
| Example 34 | ⊚ | ○ | ⊚ | ⊚ | ○ |
| Example 35 | ⊚ | ○ | ⊚ | ⊚ | ○ |
| Example 36 | ⊚ | ○ | ⊚ | ⊚ | ○ |
| Example 37 | ⊚ | ○ | ⊚ | ⊚ | ○ |
| Example 38 | ⊚ | ○ | ⊚ | ⊚ | ○ |
| Example 39 | ⊚ | ○ | ⊚ | ⊚ | ○ |
| Example 40 | ⊚ | ○ | ⊚ | ⊚ | ○ |
| Example 41 | ⊚ | ○ | ⊚ | ⊚ | ○ |
| Example 42 | ⊚ | ○ | ⊚ | ⊚ | ○ |
| Example 43 | ⊚ | ○ | ⊚ | ⊚ | ○ |
| Example 44 | ⊚ | ○ | ⊚ | ⊚ | ○ |
| Example 45 | ⊚ | ○ | ⊚ | ⊚ | ○ |
| Example 46 | ⊚ | ○ | ⊚ | ⊚ | ○ |
| Example 47 | ⊚ | ○ | ⊚ | ⊚ | ○ |
| Example 48 | ⊚ | ○ | ⊚ | ⊚ | ○ |
| Example 49 | ⊚ | ○ | ⊚ | ⊚ | ○ |
| Example 50 | ⊚ | ○ | ⊚ | ⊚ | ○ |
| Example 51 | ⊚ | ○ | ⊚ | ⊚ | ○ |
| Example 52 | ⊚ | ○ | ⊚ | ⊚ | ○ |
| Example 53 | ⊚ | ○ | ⊚ | ⊚ | ○ |
| Example 54 | ⊚ | ○ | ⊚ | ⊚ | ○ |
| Example 55 | ⊚ | ○ | ⊚ | ⊚ | ○ |
| Example 56 | ⊚ | ○ | ⊚ | ⊚ | ○ |
| Example 57 | ⊚ | ○ | ⊚ | ⊚ | ○ |
| Example 58 | ○ | ○ | ○ | ○ | ○ |
| Example 59 | ○ | ○ | ○ | ○ | ○ |
| Example 60 | ○ | ○ | ○ | ○ | ○ |
| Example 61 | ○ | ○ | ○ | ○ | ○ |
| Example 62 | ○ | ○ | ○ | ○ | ○ |
| Example 63 | ○ | ○ | ○ | ○ | ○ |
| Example 64 | ○ | ○ | ○ | ○ | ○ |
| Example 65 | ○ | ○ | ○ | ○ | ○ |
| Example 66 | ○ | ○ | ○ | ○ | ○ |
| Example 67 | ○ | ○ | ○ | ○ | ○ |
| Example 68 | ⊚ | ○ | ⊚ | ⊚ | ○ |
| Example 69 | ⊚ | ○ | ⊚ | ⊚ | ○ |
| Example 70 | ⊚ | ○ | ⊚ | ⊚ | ○ |
| Example 71 | ⊚ | ○ | ⊚ | ⊚ | ○ |
| Example 72 | ⊚ | ○ | ⊚ | ⊚ | ○ |
| Example 73 | ⊚ | ○ | ⊚ | ⊚ | ○ |
| Example 74 | ⊚ | ○ | ⊚ | ⊚ | ○ |
| Example 75 | ⊚ | ○ | ⊚ | ⊚ | ○ |
| Example 76 | ○ | ○ | ○ | ○ | ○ |
| Example 77 | ○ | ○ | ○ | ○ | ○ |
| Example 78 | ⊚ | ○ | ⊚ | ⊚ | ○ |
| Example 79 | ○ | ○ | ○ | ○ | ○ |
| Example 80 | ○ | ○ | ○ | ○ | ○ |
| Example 81 | ○ | ○ | ○ | ○ | ○ |
| Example 82 | ⊚ | ○ | ⊚ | ⊚ | ○ |
| Example 83 | ⊚ | ○ | ⊚ | ⊚ | ○ |
| Example 84 | ○ | ○ | ○ | ○ | ○ |
| Example 85 | ⊚ | ○ | ⊚ | ⊚ | ○ |
| Example 86 | ⊚ | ○ | ⊚ | ⊚ | ○ |
| Example 87 | ⊚ | ○ | ⊚ | ⊚ | ○ |
| Example 88 | ○ | ○ | ○ | ○ | ○ |
| Example 89 | ⊚ | ○ | ⊚ | ⊚ | ○ |
| Example 90 | ⊚ | ○ | ⊚ | ⊚ | ○ |
| Example 91 | ○ | ○ | ○ | ○ | ○ |
| Example 92 | ○ | ○ | ○ | ○ | ○ |
| Example 93 | ○ | ○ | ○ | ○ | ○ |
| Example 94 | ○ | ○ | ○ | ○ | ○ |
| Example 95 | ○ | ○ | ○ | ○ | ○ |
| Example 96 | ⊚ | ○ | ⊚ | ⊚ | ○ |
| Example 97 | ⊚ | ○ | ⊚ | ⊚ | ○ |
| Example 98 | ○ | ○ | ○ | ○ | ○ |
| Example 99 | ○ | ○ | ○ | ○ | ○ |
| Example 100 | ○ | ○ | ○ | ○ | ○ |
| Example 101 | ○ | ○ | ○ | ○ | ○ |
| Example 102 | ○ | ○ | ○ | ○ | ○ |
| Example 103 | ○ | ○ | ○ | ○ | ○ |
| Example 104 | ○ | ○ | ○ | ○ | ○ |
| Example 105 | ○ | ○ | ○ | ○ | ○ |
| Example 106 | ○ | ○ | ○ | ○ | ○ |
| Example 107 | ○ | ○ | ○ | ○ | ○ |
| Example 108 | ○ | ○ | ○ | ○ | ○ |
| Example 109 | ○ | ○ | ○ | ○ | ○ |
| Example 110 | ○ | ○ | ○ | ○ | ○ |
| Example 111 | ○ | ○ | ○ | ○ | ○ |
| Example 112 | ○ | ○ | ○ | ○ | ○ |
| Example 113 | ○ | ○ | ○ | ○ | ○ |
| Example 114 | ○ | ○ | ○ | ○ | ○ |
| Example 115 | ○ | ○ | ○ | ○ | ○ |
| Example 116 | ○ | ○ | ○ | ○ | ○ |
| Example 117 | ○ | ○ | ○ | ○ | ○ |
| Example 118 | ○ | ○ | ○ | ○ | ○ |
| Example 119 | ○ | ○ | ○ | ○ | ○ |
| Example 120 | ○ | ○ | ○ | ○ | ○ |
| Example 121 | ○ | ○ | ○ | ○ | ○ |
| Example 122 | ○ | ○ | ○ | ○ | ○ |
| Example 123 | ○ | ○ | ○ | ○ | ○ |
| Example 124 | ○ | ○ | ○ | ○ | ○ |

**[Table 32]**

| | Fluorine content (ppm) | Sensitivity | Film retention rate | Adhesion | Chemical resistance |
|---|---|---|---|---|---|
| Comparative Example 1 | 12,616 | ○ | ○ | ○ | X |
| Comparative Example 2 | 11,469 | ○ | ○ | ○ | X |
| Comparative Example 3 | 10,896 | ○ | ○ | ○ | X |
| Comparative Example 4 | 8,976 | ○ | ○ | ○ | X |
| Comparative Example 5 | 10,839 | ○ | ○ | ○ | X |
| Comparative Example 6 | 10,839 | ○ | ○ | ○ | X |
| Comparative Example 7 | 13,419 | ○ | ○ | ○ | X |
| Comparative Example 8 | 9,853 | ○ | ○ | ○ | X |
| Comparative Example 9 | 11,043 | ○ | ○ | ○ | X |
| Comparative Example 10 | 11,355 | ○ | ○ | ○ | X |
| Comparative Example 11 | 7,226 | ○ | ○ | ○ | X |
| Comparative Example 12 | 10,323 | ○ | ○ | ○ | X |
| Comparative Example 13 | 9,874 | ○ | ○ | ○ | X |
| Comparative Example 14 | 10,968 | ○ | ○ | ○ | X |
| Comparative Example 15 | 11,183 | ○ | ○ | ○ | X |
| Comparative Example 16 | 11,183 | ○ | ○ | ○ | X |
| Comparative Example 17 | 11,911 | ○ | ○ | ○ | X |
| Comparative Example 18 | 13,763 | ○ | ○ | ○ | X |
| Comparative Example 19 | 10,323 | ○ | ○ | ○ | X |
| Comparative Example 20 | 17,548 | ○ | ○ | ○ | X |
| Comparative Example 21 | 18,351 | ○ | ○ | ○ | X |
| Comparative Example 22 | 15,484 | ○ | ○ | ○ | X |
| Comparative Example 23 | 18,581 | ○ | ○ | ○ | X |
| Comparative Example 24 | 15,015 | ○ | ○ | ○ | X |
| Comparative Example 25 | 12,199 | ○ | ○ | ○ | X |
| Comparative Example 26 | 10,678 | ○ | ○ | ○ | X |

**[Table 33]**

| | Heat resistance | Solar resistance | Hygroscopicity | Operation reliability | Bending characteristics |
|---|---|---|---|---|---|
| Comparative Example 1 | X | X | X | X | ○ |
| Comparative Example 2 | X | X | X | X | ○ |
| Comparative Example 3 | X | X | X | X | ○ |
| Comparative Example 4 | X | X | X | X | ○ |
| Comparative Example 5 | X | X | X | X | ○ |
| Comparative Example 6 | X | X | X | X | ○ |
| Comparative Example 7 | X | X | X | X | ○ |
| Comparative Example 8 | X | X | X | X | ○ |
| Comparative Example 9 | X | X | X | X | ○ |
| Comparative Example 10 | X | X | X | X | ○ |
| Comparative Example 11 | X | X | X | X | ○ |
| Comparative Example 12 | X | X | X | X | ○ |
| Comparative Example 13 | X | X | X | X | ○ |
| Comparative Example 14 | X | X | X | X | ○ |
| Comparative Example 15 | X | X | X | X | ○ |
| Comparative Example 16 | X | X | X | X | ○ |
| Comparative Example 17 | X | X | X | X | ○ |
| Comparative Example 18 | X | X | X | X | ○ |
| Comparative Example 19 | X | X | X | X | ○ |
| Comparative Example 20 | X | X | X | X | ○ |
| Comparative Example 21 | X | X | X | X | ○ |
| Comparative Example 22 | X | X | X | X | ○ |
| Comparative Example 23 | X | X | X | X | ○ |
| Comparative Example 24 | X | X | X | X | ○ |
| Comparative Example 25 | X | X | X | X | ○ |
| Comparative Example 26 | X | X | X | X | ○ |

Referring to Tables 30 to 33 above, it was confirmed that the positive photosensitive resin compositions prepared in Examples 1 to 124 exhibited excellent sensitivity, film retention rate, adhesion, chemical resistance, heat resistance, solar resistance, hygroscopicity, operation reliability, and bending characteristics.

On the other hand, it was confirmed that the physical properties of Comparative Examples 1 to 26 were inferior compared to those of Examples 1 to 124. Specifically, it was confirmed that the positive photosensitive resin compositions of Comparative Examples 1 to 26 had very inferior chemical resistance, heat resistance, solar resistance, hygroscopicity, operation reliability, and bending characteristics.

Accordingly, it can be seen that the positive photosensitive resin composition according to one embodiment of the present disclosure may easily realize an organic film having excellent sensitivity, film retention rate, adhesion, chemical resistance, heat resistance, solar resistance, hygroscopicity, operation reliability, and bending characteristics.

**[Description of Reference Numerals]**

| | | | |
|---|---|---|---|
| 10: | source/drain | 20: | organic film |
| 30: | anode | 40: | PDL |

## Claims

1. A positive photosensitive resin composition comprising:
an alkali-soluble polymer resin;
an esterified quinone diazide compound; and
a crosslinking agent containing a phenol group,
wherein the alkali-soluble polymer resin comprises a reaction product of a mixture comprising an amine-based compound, an acid anhydride compound, and a capping compound, and satisfies Equation 1 below: [Equation 1] $\left(A+B\right) / 2 < 6.0 eV$
in Equation 1 above, A is a CTC value (eV) of the amine-based compound, and B is a sum of the CTC value (eV) of the acid anhydride compound and the CTC value (eV) of the capping compound in a mixture of the acid anhydride compound and the capping compound,
wherein the CTC value represents a quantum calculation simulation value for an energy level difference between an electron donor and an electron acceptor in the compound, assuming that the compound forms a charge transfer complex.

2. The positive photosensitive resin composition of claim 1, wherein the positive photosensitive resin composition has a fluorine content of 10,000 ppm or less.

3. The positive photosensitive resin composition of claim 1, wherein the alkali-soluble polymer resin comprises a repeating unit represented by Formula A below and a repeating unit represented by Formula B below,
wherein the repeating unit represented by Formula A and the repeating unit represented by Formula B comprise a structure derived from an amine-based compound containing R_{b} and a structure derived from an acid anhydride compound containing Rₐ: 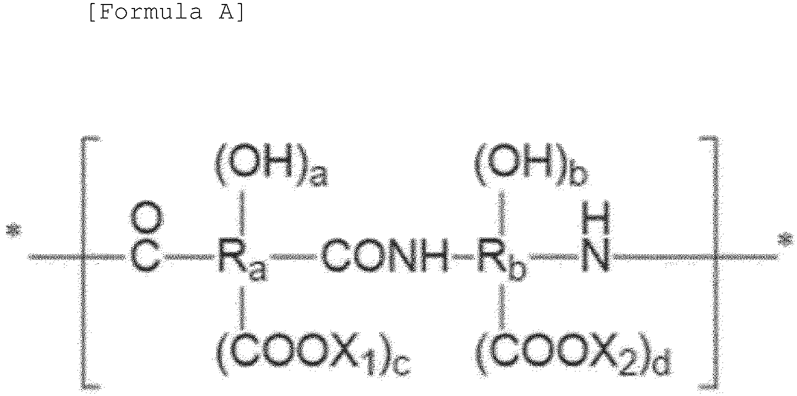 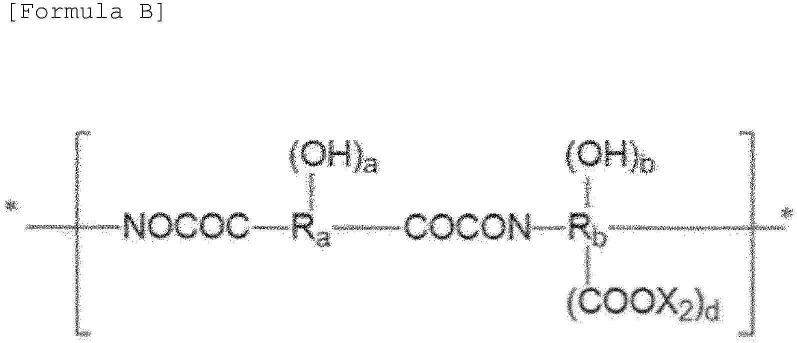
in Formulas A and B above,
Rₐ and R_{b} are each independently an organic group having 5 to 60 carbon atoms,
X₁ and X₂ are each independently hydrogen or an alkyl group having 1 to 10 carbon atoms,
a and b are each independently an integer ranging from 0 to 4,
c and d are each independently an integer ranging from 0 to 2, and
a+b is 1 or more.

4. The positive photosensitive resin composition of claim 3, wherein the alkali-soluble polymer resin comprises, based on a total of 100 mol% of the repeating unit represented by Formula A and the repeating unit represented by Formula B, at least 51 mol% of the repeating unit represented by Formula B.

5. The positive photosensitive resin composition of claim 3, wherein the amine-based compound comprises at least one of compounds represented by Formulas 1-1 to 1-19 below: 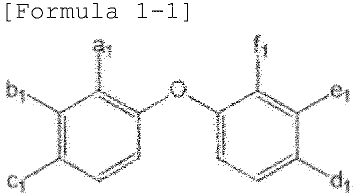 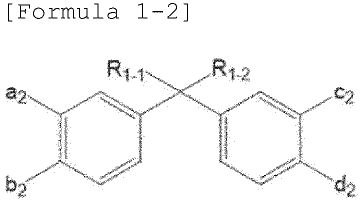 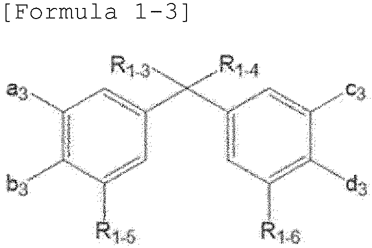 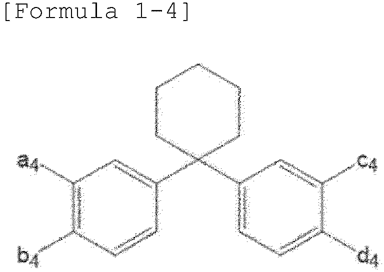 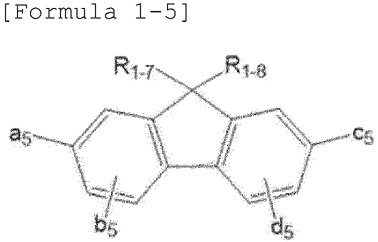 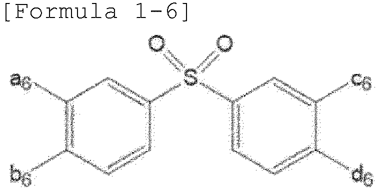 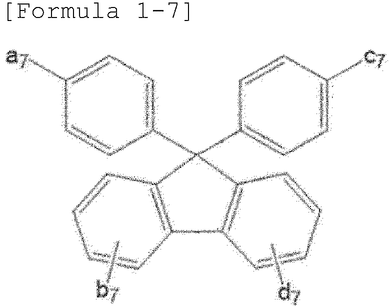 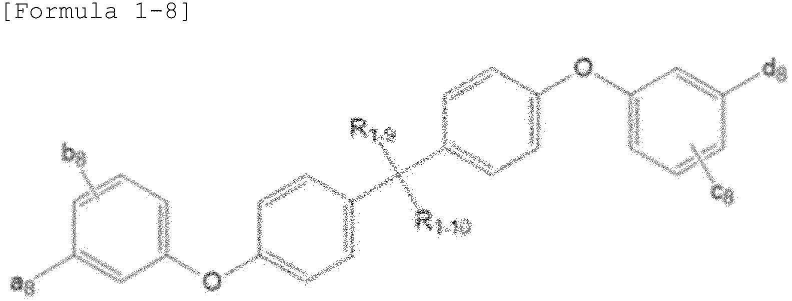 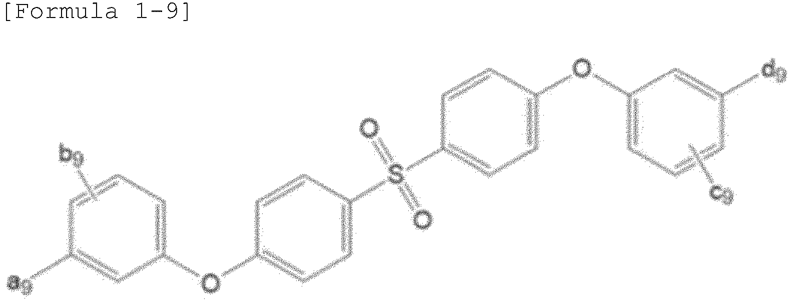 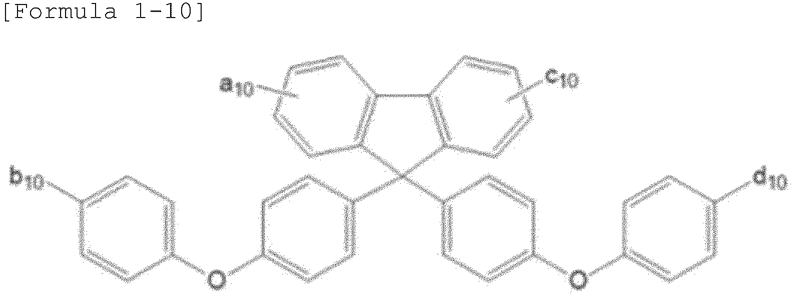 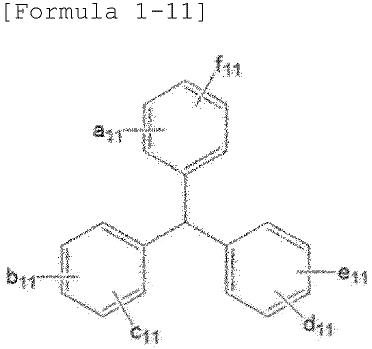 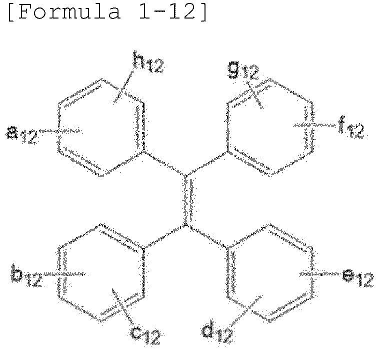 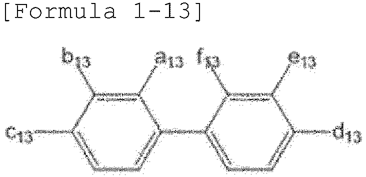 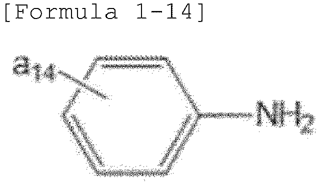 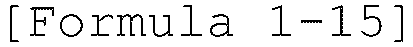 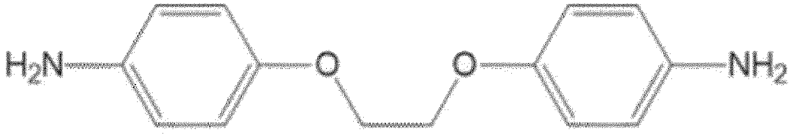 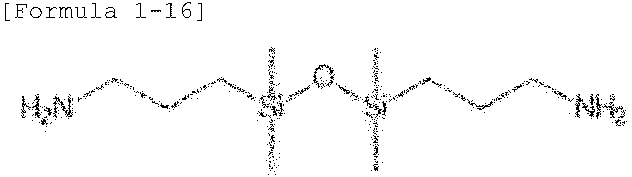 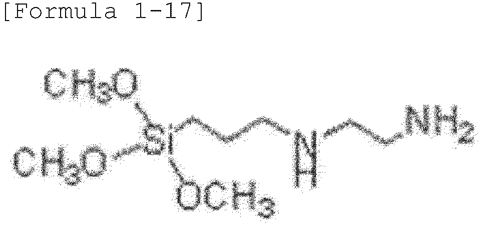 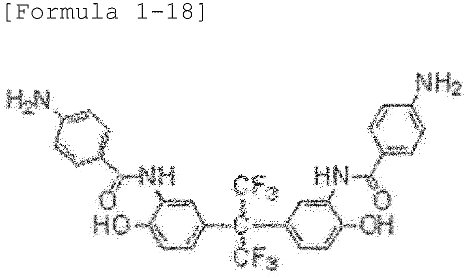 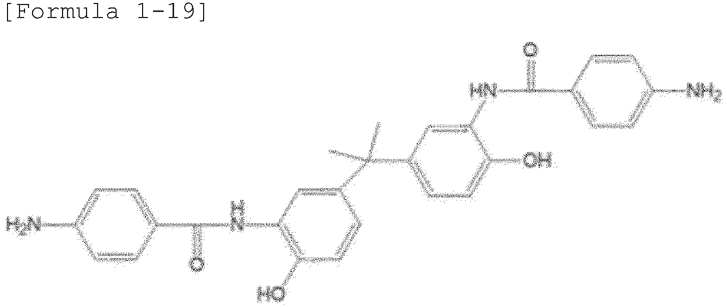
wherein at least two of a₁, b₁, c₁, d₁, e₁ and f₁ are amine groups, and the remainder are hydrogen, hydroxyl groups, halogen-substituted alkyl groups having 1 to 3 carbon atoms, or -COOX₂; at least two of a₂, b₂, c₂ and d₂ are amine groups, and the remainder are hydrogen, hydroxyl groups, or -COOX₂; R₁₋₁ and R₁₋₂ are each independently hydrogen, an alkyl group having 1 to 10 carbon atoms, a halogen-substituted alkyl group having 1 to 3 carbon atoms, or a cycloalkyl group having 5 to 10 carbon atoms;
at least two of a₃, b₃, c₃ and d₃ are amine groups, and the remainder are hydrogen, hydroxyl groups, or -COOX₂; R₁₋₃ and R₁₋₄ are each independently an alkyl group having 1 to 10 carbon atoms or a cycloalkyl group having 5 to 10 carbon atoms; R₁₋₅ and R₁₋₆ are each independently hydrogen or an alkyl group having 1 to 10 carbon atoms;
at least two of a₄, b₄, c₄ and d₄ are amine groups, and the remainder are hydrogen, hydroxyl groups, or -COOX₂;
at least two of a₅, b₅, c₅ and d₅ are amine groups, and the remainder are hydrogen, hydroxyl groups, or -COOX₂; R₁₋₇ and R₁₋₈ are each independently an alkyl group having 1 to 10 carbon atoms or a cycloalkyl group having 5 to 10 carbon atoms;
at least two of a₆, b₆, c₆ and d₆ are amine groups, and the remainder are hydrogen, hydroxyl groups, or -COOX₂;
at least two of a₇, b₇, c₇ and d₇ are amine groups, and the remainder are hydrogen, hydroxyl groups, or -COOX₂;
at least two of a₈, b₈, c₈ and d₈ are amine groups, and the remainder are hydrogen, hydroxyl groups, or -COOX₂; R₁₋₉ and R₁₋₁₀ are each independently an alkyl group having 1 to 10 carbon atoms or a cycloalkyl group having 5 to 10 carbon atoms;
at least two of a₉, b₉, c₉ and d₉ are amine groups, and the remainder are hydrogen, hydroxyl groups, or -COOX₂;
at least two of a₁₀, b₁₀, c₁₀ and d₁₀ are amine groups, and the remainder are hydrogen, hydroxyl groups, or -COOX₂;
at least two of a₁₁, b₁₁, c₁₁, d₁₁, e₁₁ and f₁₁ are amine groups, and the remainder are hydrogen, hydroxyl groups, or -COOX₂;
at least two of a₁₂, b₁₂, c₁₂, d₁₂, e₁₂, f₁₂ and g₁₂ are amine groups, and the remainder are hydrogen, hydroxyl groups, or -COOX₂;
at least two of a₁₃, b₁₃, c₁₃, d₁₃, e₁₃ and f₁₃ are amine groups, and the remainder are hydrogen, hydroxyl groups, unsubstituted or halogen-substituted alkyl groups having 1 to 3 carbon atoms, or -COOX₂;
a₁₄ is a thiol group, an amine group, or a hydroxyl group; and
X₂ is hydrogen or an alkyl group having 1 to 10 carbon atoms.

6. The positive photosensitive resin composition of claim 3, wherein the acid anhydride compound comprises at least one of compounds represented by Formulas 2-1 to 2-16 below: 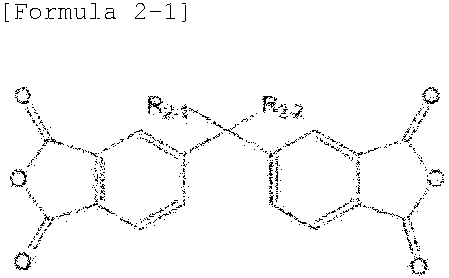 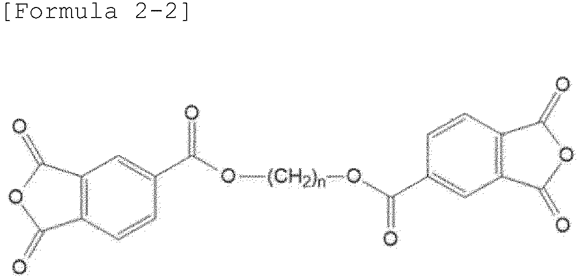 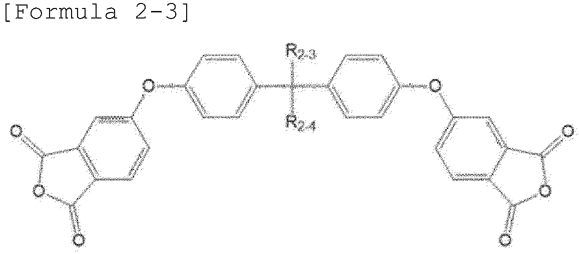 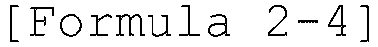 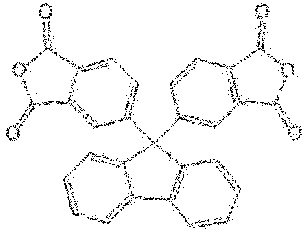 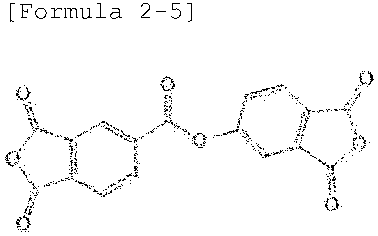 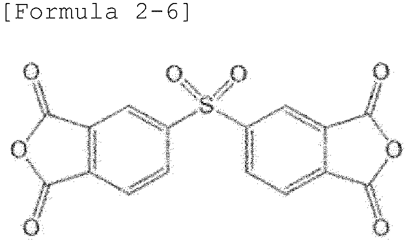 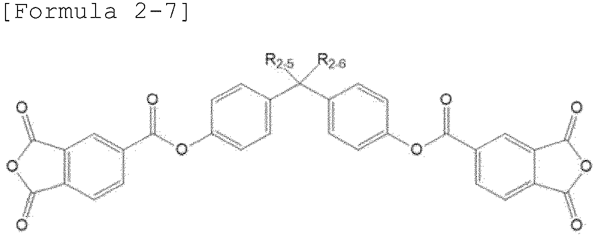 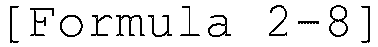 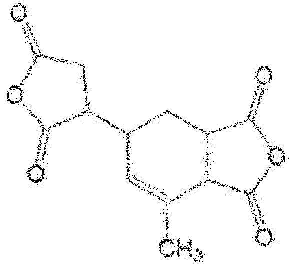 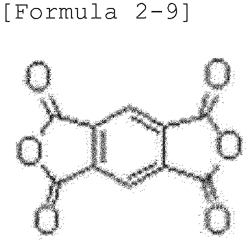 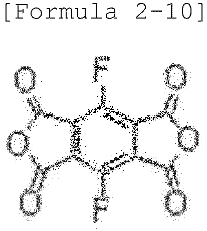 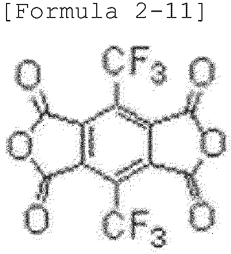 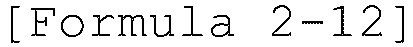 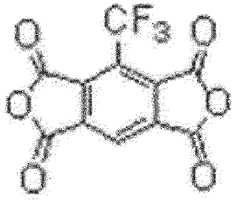 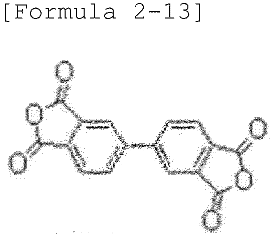 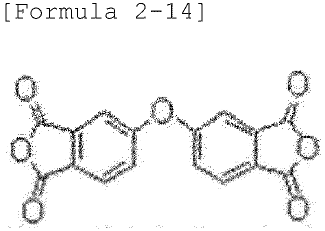 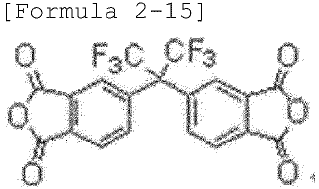 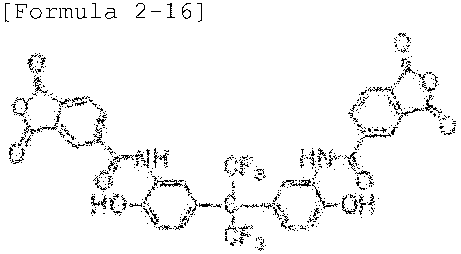
in the above Formulas, R₂₋₁ to R₂₋₆ are each independently an alkyl group having 1 to 10 carbon atoms or a cycloalkyl group having 5 to 10 carbon atoms, and
n is an integer ranging from 2 to 20.

7. The positive photosensitive resin composition of claim 1, wherein the capping compound comprises at least one of compounds C-1 to C-5 below:

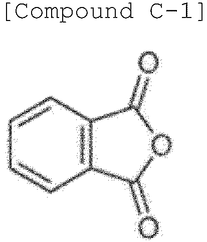

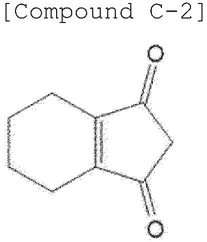

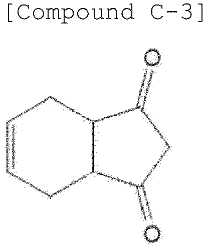

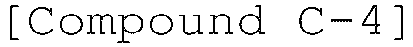

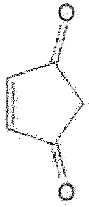

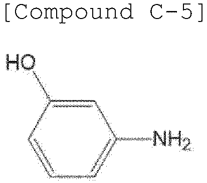

8. The positive photosensitive resin composition of claim 1, wherein the esterified quinone diazide compound comprises a reaction product of a quinone diazide compound and at least one of phenol compounds represented by Formulas 3-1 to 3-13 below: 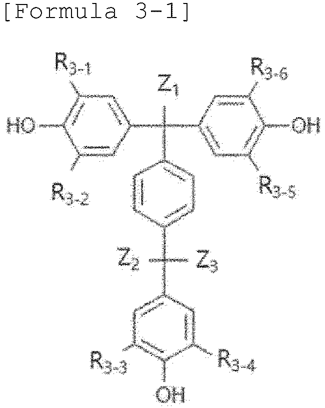 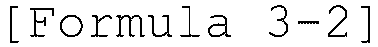 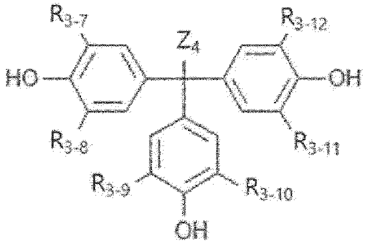 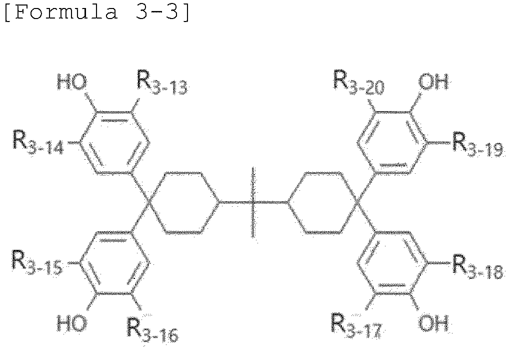 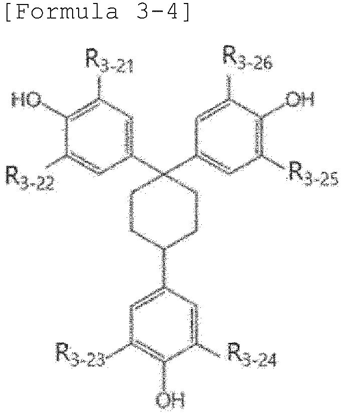 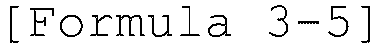 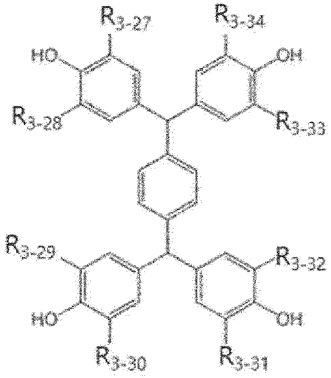 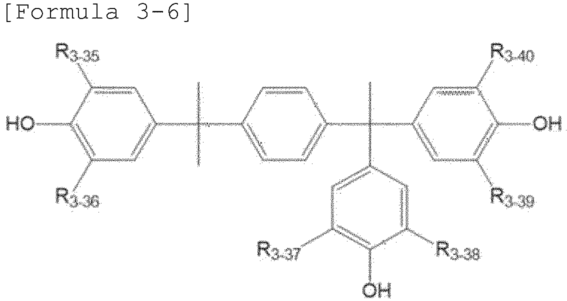 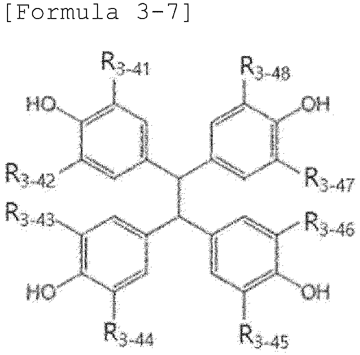 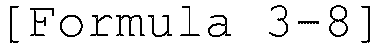 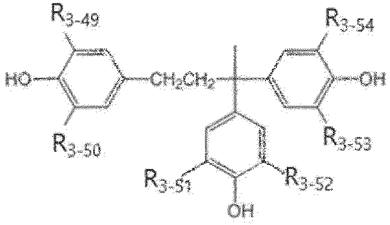 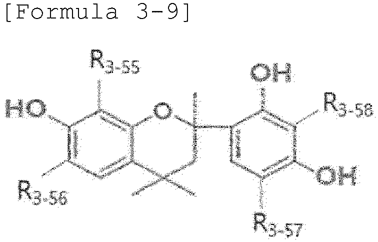 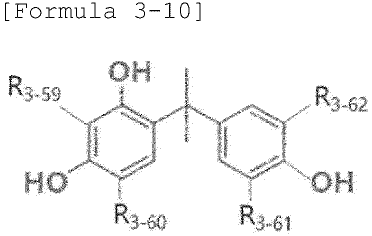 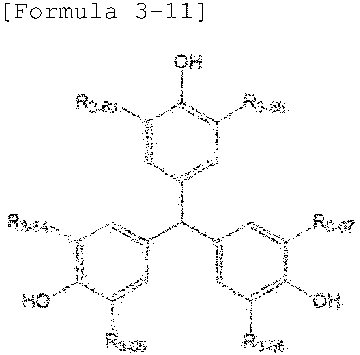 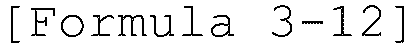 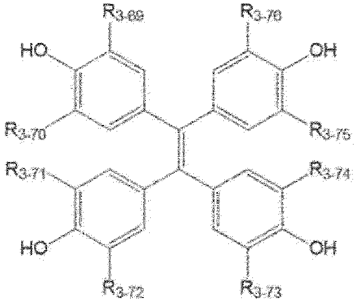 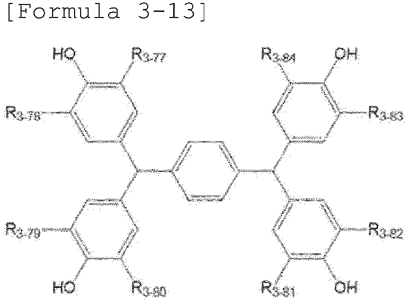 In the above Formulas,
R₃₋₁ to R₃₋₈₄ are each independently hydrogen, an alkyl group having 1 to 4 carbon atoms, or an alkenyl group having 2 to 4 carbon atoms, and
Z₁ to Z₄ are each independently hydrogen or an alkyl group having 1 to 4 carbon atoms.

9. The positive photosensitive resin composition of claim 1, wherein a content of the esterified quinone diazide compound is 10 parts by weight or more and 40 parts by weight or less based on 100 parts by weight of the alkali-soluble polymer resin.

10. The positive photosensitive resin composition of claim 1, wherein the crosslinking agent comprises at least one of compounds represented by Formulas 4-1 to 4-21 below: 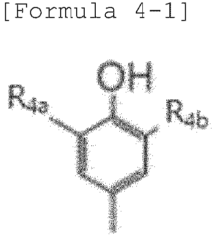 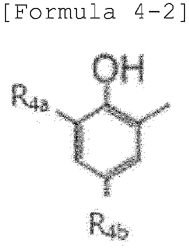 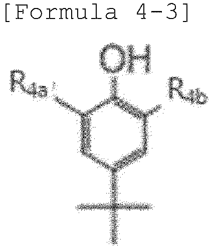 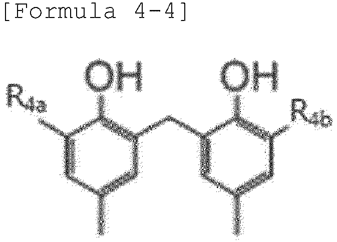 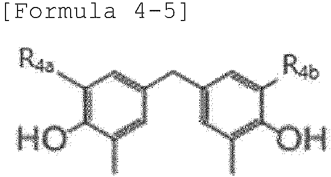 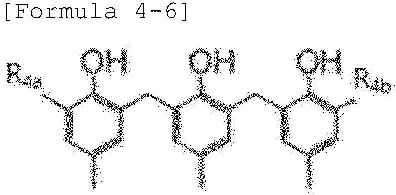 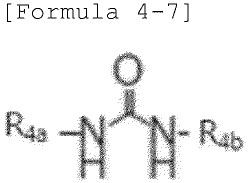 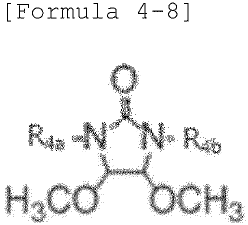 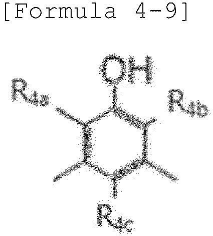 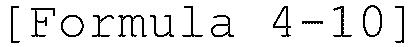 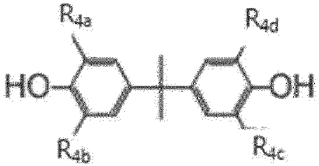 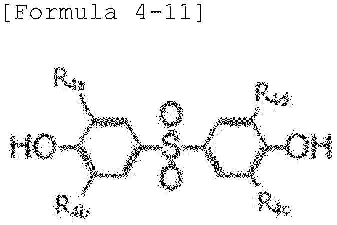 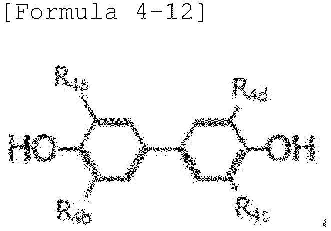 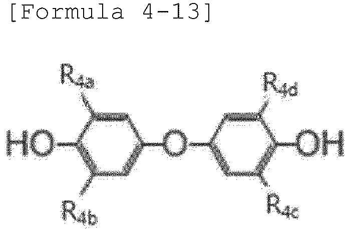 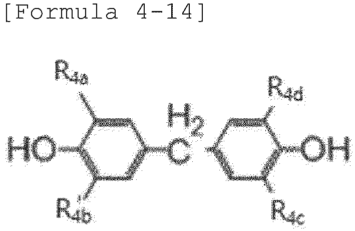 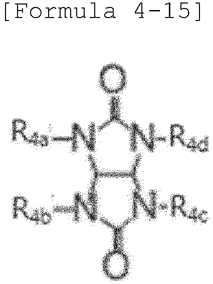 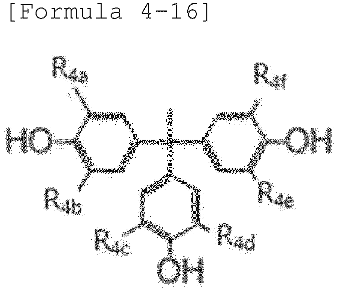 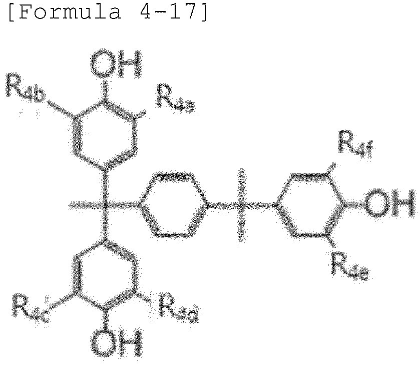 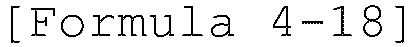 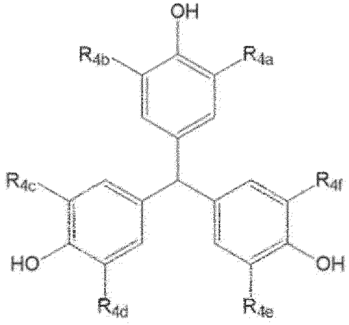 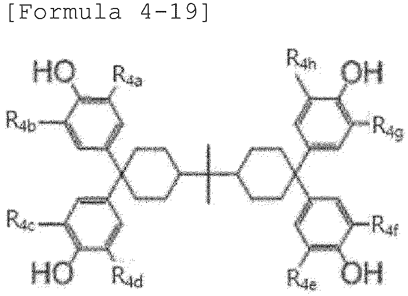 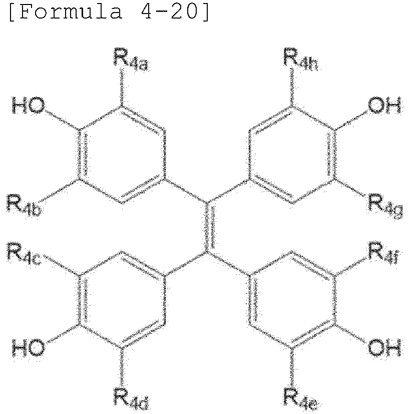 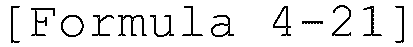 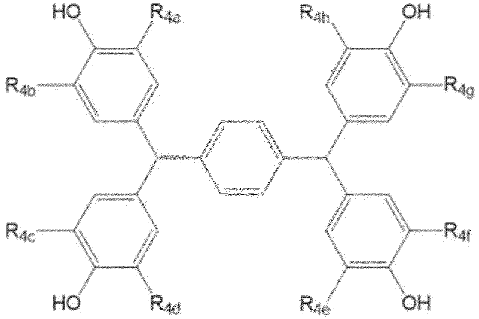 in the above Formulas,
R₄ₐ to R₄ₕ are each independently hydrogen, an alkyl group having 1 to 3 carbon atoms, or *-(CH₂)ₘ₋O-R₄₋₁,
at least one of R₄ₐ and R_{4b} in Formulas 4-1 to 4-8 above is -(CH₂)ₘ-O-R₄₋₁,
at least one of R₄ₐ to R_{4c} in Formula 4-9 above is *-(CH₂)ₘ-O-R₄₋₁,
at least one of R₄ₐ to R_{4d} in Formulas 4-10 to 4-15 above is *-(CH₂)ₘ-O-R₄₋₁,
at least one of R₄ₐ to R_{4f} in Formulas 4-16 to 4-18 above is *-(CH₂)ₘ-O-R₄₋₁,
at least one of R₄ₐ to R₄ₕ in Formulas 4-19 to 4-21 above is *-(CH₂)ₘ-O-R₄₋₁,
m is an integer ranging from 1 to 6, and
R₄₋₁ is an alkyl group having 1 to 3 carbon atoms.

11. The positive photosensitive resin composition of claim 1, wherein a content of the crosslinking agent is 5 parts by weight or more and 30 parts by weight or less based on 100 parts by weight of the alkali-soluble polymer resin.

12. The positive photosensitive resin composition of claim 1, further comprising at least one of an organic solvent, a surfactant, and an additive.

13. An electronic component comprising an insulating film comprising a cured product of the positive photosensitive resin composition according to claim 1.

14. A display device comprising an insulating film comprising a cured product of the positive photosensitive resin composition according to claim 1.
